(19) Europäisches Patentamt
European Patent Office
Office européen des brevets

(11) **EP 2 520 692 A2**

(12) **EUROPEAN PATENT APPLICATION**

(43) Date of publication:
**07.11.2012 Bulletin 2012/45**

(51) Int Cl.:
**C23C 18/12** $^{(2006.01)}$

(21) Application number: **12166477.5**

(22) Date of filing: **02.05.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **06.05.2011 JP 2011103450**
**06.05.2011 JP 2011103451**
**17.05.2011 JP 2011110102**
**02.06.2011 JP 2011124202**
**02.06.2011 JP 2011124465**

(71) Applicant: **Seiko Epson Corporation**
**Shinjuku-ku**
**Tokyo (JP)**

(72) Inventors:
• **Ogawa, Reina**
**Suwa-shi, Nagano 392-8502 (JP)**
• **Noguchi, Motohisa**
**Suwa-shi, Nagano 392-8502 (JP)**
• **Takubo, Miwa**
**Suwa-shi, Nagano 392-8502 (JP)**
• **Asaoka, Ichiro**
**Suwa-shi, Nagano 392-8502 (JP)**
• **Onodera, Toshiya**
**Suwa-shi, Nagano 392-8502 (JP)**

(74) Representative: **Miller Sturt Kenyon**
**9 John Street**
**London WC1N 2ES (GB)**

(54) **Precursor Solution for Piezoelectric Films, Method for Manufacturing the same, and Method for Manufacturing Piezoelectric Film**

(57) Some kinds of carboxylic acids have a stabilizing effect on metal alkoxides and, in a precursor solution, are unlikely to cause a reduced storage stability and an increased viscosity of the precursor solution even when their content is increased; they can be used in the solvent component of the precursor solution. The carboxylic acid content is preferably in a range of 20% by mass to 60% by mass, both inclusive, of the total amount of the raw materials used to prepare the precursor solution. The carboxylic acid component prevents the hydrolysis due to the moisture in the air when the carboxylic acid content is equal to or more than 20% by mass. When the carboxylic acid content is equal to or less than 60% by mass, furthermore, the resulting precursor film will have a sufficiently large thickness.

FIG. 1

EP 2 520 692 A2

## Description

The present invention relates to a precursor solution for piezoelectric films, a method for manufacturing a precursor solution for piezoelectric films, and a method for manufacturing a piezoelectric film.

Piezoelectric films containing crystals represented by lead zirconate titanate (PZT) films and films based on other similar compounds have such properties as spontaneous polarization, high dielectric constants, an electrooptic effect, a piezoelectric effect, and a pyroelectric effect and thus are applied to piezoelectric elements and other various devices. The manufacturing methods of piezoelectric films are roughly divided into two categories: gas-phase methods and liquid-phase methods. Examples of known gas-phase methods are CVD (chemical vapor deposition), sputtering, and so forth. Examples of known liquid-phase methods are, as described in JP-A-2008-001038, MOD (metal organic deposition), the sol-gel process, and so forth. Importantly, the liquid-phase methods are advantageous over the gas-phase ones for the following reasons: they can be carried out without expensive vacuum equipment, allow one to easily control the elemental composition and the amounts of additives, and thus can provide an easy, simple, and low-cost way to produce piezoelectric films.

The precursor solution used in the sol-gel process is prepared by hydrolyzing a metal alkoxide or some other organic metal compound, polymerizing the hydrolysate to form a colloidal suspension, and then dispersing it in an organic solvent. The precursor solution used in the MOD process is prepared by dissolving a non-hydrolysable organic acid salt of a metal in an organic solvent. Besides these, there are many kinds of known precursor solutions not classified into those for the sol-gel process or those for the MOD process (*e.g.*, solutions containing a metal organic acid salt, a metal alkoxide, and a metal complex).

Film formation by the sol-gel process employs a mixed solution containing metal alkoxides as the sources of the intended metal oxide. For example, JP-A-11-79747 discloses a precursor solution for the formation of a metal oxide. This precursor solution is prepared by dissolving lead acetate trihydrate in 3-methoxybutanol, synthesizing a lead alkoxide by azeotropic dehydration, and then adding and dissolving titanium and zirconium alkoxides.

On the other hand, film formation by the MOD process employs a mixed solution containing metal organic acid salts as the sources of the intended metal oxide. For example, JP-A-5-58636 discloses a precursor solution for the formation of a metal oxide, and this precursor solution is a mixed solution containing organic acid salts of lead, titanium, and zirconium. JP-A-8-111411 and JP-A-2007-145657 each provide an example of the piezoelectric film precursor solution containing a metal organic acid salt, a metal alkoxide, and a metal complex. The former discloses a precursor solution for the formation of a metal oxide, and this precursor solution is a mixed solution containing organic acid salts of strontium and bismuth. The latter discloses a composition for the formation of a piezoelectric film, and this composition takes the form of a precursor solution for the formation of a metal oxide and contains acetic acid to improve the dispersion stability of the acetylacetonate complex contained.

In general, the subsequent stages of the manufacturing of a piezoelectric film by a liquid-phase method are common regardless of how the precursor solution is prepared (the sol-gel process, MOD, or any other process): the precursor solution containing at least a solvent (an alcohol, a hydrocarbon, or the like), a stabilizing agent, and the organic metal compounds is applied to a base such as a silicon substrate, and the obtained coating is heated and thereby crystallized. In this way, a crystallized piezoelectric film is obtained.

However, the manufacturing of piezoelectric films by any known method suffers from the following problems.

It is difficult to form a sufficiently thick piezoelectric film in a single cycle and the same cycle should be repeated to achieve the required film thickness, and this limits the potential for productivity improvement. In order for the thickness of the piezoelectric film achieved in a single cycle to be a sufficiently large, it is needed to prepare the precursor solution to contain the organic metal compounds at sufficiently high concentrations. In the case of a precursor solution containing a solvent, a stabilizing agent, and organic metal compounds, a possible way to increase the concentrations of the organic metal compounds contained in the precursor solution is to reduce the solvent content or the stabilizing agent content.

However, a reduced content of the stabilizing agent can cause the hydrolysis due to the moisture in the air or from other sources to be accelerated and thereby lead to a reduced storage stability of the precursor solution. On the other hand, a reduced content of the solvent (usually an alcohol) can cause precipitation and thereby make it difficult to form uniform films and, worse yet, lead to an increased viscosity of the precursor solution that may cause unevenness of the coating.

The precursor solution that needs no stabilizing agent has another problem when the organic metal compounds contained are organic acid salts: increasing the chain length of the ligand to make the compounds more soluble in the solvent results in reduced concentrations of the metals. Because of these problems, there is the demand for a piezoelectric film precursor solution that can produce a sufficiently thick piezoelectric film in a single film-formation cycle and is highly stable during storage.

Furthermore, the manufacturing process of a piezoelectric film using a precursor solution involves heat treatment operations, during which a coating of the precursor solution spread over the substrate undergoes thermal decomposition reactions such as solvent evaporation and ligand decomposition. These thermal decomposition reactions can occur not at a particular limited temperature but over some temperature range; this means that the actual reaction temperature in the substrate plane varies between the individual coatings. The resulting piezoelectric films have varying piezoelectric properties, and their in-plane uniformity in piezoelectric properties is low. When the precursor solution contains multiple organic compounds as solutes that provide ligands, such reactions can occur in a broader temperature range. This has a great influence on the consistency in piezoelectric properties of the finished products and, importantly, the larger the substrate size is, the more significant the influence is. Because of these problems, there is the demand for a piezoelectric film precursor solution that can produce films with improved in-plane uniformity in piezoelectric properties.

During the formation of a piezoelectric film by a liquid-phase method, moreover, esterification reaction occurs between the acid and the alcohol contained in the precursor solution. Esters are less viscous than alcohols, and thus the precursor solution becomes less viscous as its ester content increases over time. A reduced viscosity of the precursor solution causes the resulting piezoelectric film to be thin and thus uneven. However, an increased viscosity of the precursor solution causes the resulting piezoelectric film to be less compatible with the substrate on which it is formed (the lower electrode) and to be too thick and more likely to crack. These problems have created the demand for a method for manufacturing a precursor solution that has a reduced potential for esterification reaction and thus is highly stable.

Another problem with the manufacturing of a piezoelectric film by a liquid-phase method is that when the film thickness reduction at the sintering stage, at which the coating of the precursor solution spread over the base is crystallized, is too large, the resulting piezoelectric film may be likely to crack at any later manufacturing stage or some time after the completion of the whole manufacturing process. This problem has created the demand for a manufacturing method that yields a piezoelectric film less likely to crack.

The following embodiments or applications represent some aspects of the invention.

Application 1

Application 1 is a precursor solution for piezoelectric films that is obtained by mixing raw materials including the following: a carboxylic acid component consisting of acetic acid and/or propionic acid; lead acetate; a zirconium alkoxide represented by $Zr(OR^1)_4$ ($OR^1$ is a linear or branched alkoxy group having 3 to 8 carbon atoms); a titanium alkoxide represented by $Ti(OR^2)_4$ ($OR^2$ is a linear or branched alkoxy group having 3 to 8 carbon atoms); and a polymeric component. The carboxylic acid component is contained in an amount of 20% by mass to 60% by mass, both inclusive, of the total amount of the raw materials, and at least one of the ligand $OR^1$ of the zirconium alkoxide and the ligand $OR^2$ of the titanium alkoxide is a branched alkoxy group.

The carboxylic acids selected for this application have a stabilizing effect on metal alkoxides and are unlikely to cause a reduced storage stability and an increased viscosity of the precursor solution even when their content is increased; they can be suitably used in the solvent component.

The precursor solution according to the formulation of this application contains the carboxylic acid or acids in an amount of at least 20% by mass of the total amount of the raw materials for the preparation thereof and thus is unlikely to undergo the hydrolysis caused by the moisture in the air. At the same time, the carboxylic acid content is not higher than 60% by mass, and thus this precursor solution can produce a piezoelectric film with a sufficiently large thickness in a single application operation. The amount of the carboxylic acid or acids added can thus be adjusted within this range to satisfy the performance requirements for piezoelectric film precursor solutions (e.g., viscosity, the metal oxide content, waterproofness, and storage stability).

Furthermore, the formulation of this application contains a metal alkoxide having a branched alkoxy group and this leads to a reduced amount of carboxylate formation. As a result, the piezoelectric film precursor solution shows little change over time, and the piezoelectric films formed therewith are highly consistent in thickness. When a carboxylic acid contained in a precursor solution for piezoelectric films turns into a carboxylate, the volatility of the solvent component changes, and this often results in increased thicknesses of the resulting piezoelectric films.

Moreover, the precursor solution according to the formulation of this application contains a polymeric component, which works during the film-formation cycle to relax the stress generated as the piezoelectric film shrinks and thereby to prevent the film from cracking.

Application 2

Application 2 is a preferred embodiment of the above-described precursor solution for piezoelectric films. In this application, both of the ligand $OR^1$ of the zirconium alkoxide and the ligand $OR^2$ of the titanium alkoxide are branched alkoxy groups.

The formulation of this application serves to further reduce the amount of carboxylate formation.

Application 3

Application 3 is a preferred embodiment of the above-described precursor solution for piezoelectric films. In this application, the precursor solution further contains one or more solvents selected from water, secondary or tertiary alcohols, ethers, esters, and ketones.

The formulation of this application serves to prevent the carboxylate formation reactions from occurring.

Application 4

Application 4 is a preferred embodiment of the above-described precursor solution for piezoelectric films. In this application, the polymeric component consists of one or more polymers selected from polyethylene glycols, polyethylene glycol derivatives, polypropylene glycols, and polypropylene glycol derivatives, and the weight-average molecular weight of the polymeric component is in a range of 300 to 800.

The piezoelectric film precursor solution according to the formulation of this application contains a polymeric component consisting of one or more polymers selected from polyethylene glycols, polyethylene glycol derivatives, polypropylene glycols, and polypropylene glycol derivatives. These polymers all have carbon-oxygen bonds. Compared with carbon-carbon bonds, carbon-oxygen bonds are weak in bonding force and thus are likely to be broken by heat. The use of a polymer or polymers having carbon-oxygen bonds thus reduces the possibility that the resulting piezoelectric film still contains the polymeric component after crystallization. The stress generated when the piezoelectric film shrinks can thus be relaxed with a reduced adverse effect on the piezoelectric properties.

Furthermore, the polymeric component used in the formulation of this application has its weight-average molecular weight controlled to fall within a range of 300 to 800 and thus has a sufficient stress relaxation effect and a satisfactory thermal decomposability. The resulting piezoelectric film is thus unlikely to crack with a reduced loss of quality.

Application 5

Application 5 is a preferred embodiment of the above-described precursor solution for piezoelectric films. In this application, the oxide-equivalent content of the metal elements contained in the precursor solution is in a range of 15% by mass to 27% by mass, both inclusive.

As already known, the thickness of a film obtained by spin coating (a kind of liquid-phase technique) is determined by the spinning speed and the oxide-equivalent content of the metal elements involved. In the formulation of this application, the oxide-equivalent content of the metal elements is controlled to fall within a range of 15% by mass to 27% by mass, both inclusive, and this allows the resulting piezoelectric film to have an sufficiently large thickness when that kind of film-formation technique is used.

Application 6

Application 6 is a possible embodiment of the above-described precursor solution for piezoelectric films. In this application, the precursor solution further contains at least one organic metal compound.

Application 7

Application 7 is a precursor solution for piezoelectric films that is obtained by mixing raw materials including the following: a solvent component containing a carboxylic acid component consisting of acetic acid and/or propionic acid; lead acetate; zirconium acetate and/or zirconium oxyacetate; a titanium alkoxide represented by $Ti(OR^1)_4$ ($OR^1$ is a branched alkoxy group having 3 to 8 carbon atoms); and a polymeric component. The carboxylic acid is contained in an amount of 20% by mass to 50% by mass, both inclusive, of the total amount of the raw materials, and the raw materials are substantially free of primary alcohols.

The precursor solution according to the formulation of this application contains the carboxylic acid or acids in an amount of at least 20% by mass of the total amount of the raw materials for the preparation thereof and thus is unlikely to undergo the hydrolysis caused by the moisture in the air. At the same time, the carboxylic acid content is not higher than 50% by mass, and thus this precursor solution can produce a piezoelectric film with a sufficiently large thickness in a single application operation.

Furthermore, the raw materials of the piezoelectric film precursor solution according to the formulation of this application includes zirconium acetate and/or zirconium oxyacetate and also includes a titanium alkoxide having a branched alkoxy group with 3 to 8 carbon atoms, and all raw materials of the precursor solution are substantially free of primary alcohols. This serves to reduce the amount of carboxylate formation in the piezoelectric film precursor solution and thereby leads to reduced variations in thickness in resulting piezoelectric films. The expression *substantially free*

*of primary alcohols* as used herein means that no primary alcohol is contained in any of the raw materials or primary alcohols account for less than 5.0% by mass of the raw materials.

Moreover, the precursor solution according to the formulation of this application contains a polymeric component, which works during the film-formation cycle to relax the stress generated as the piezoelectric film shrinks and thereby to prevent the film from cracking.

Application 8

Application 8 is a preferred embodiment of the above-described precursor solution for piezoelectric films. In this application, the solvent component of the precursor solution further contains one or more solvents selected from water, secondary or tertiary alcohols, ethers, esters, and ketones.

The formulation of this application serves to prevent the carboxylate formation reactions from occurring.

Application 9

Application 9 is a preferred embodiment of the above-described precursor solution for piezoelectric films. In this application, the polymeric component consists of one or more polymers selected from polyethylene glycols, polyethylene glycol derivatives, polypropylene glycols, and polypropylene glycol derivatives, and the weight-average molecular weight of the polymeric component is in a range of 300 to 800.

The piezoelectric film precursor solution according to the formulation of this application contains a polymeric component consisting of one or more polymers selected from polyethylene glycols, polyethylene glycol derivatives, polypropylene glycols, and polypropylene glycol derivatives. As already mentioned, these polymers all have carbon-oxygen bonds. Compared with carbon-carbon bonds, carbon-oxygen bonds are weak in bonding force and thus are likely to be broken by heat. The use of a polymer or polymers having carbon-oxygen bonds thus reduces the possibility that the resulting piezoelectric film still contains the polymeric component after crystallization. The stress generated when the piezoelectric film shrinks can thus be relaxed with a reduced adverse effect on the piezoelectric properties.

Furthermore, the polymeric component used in the formulation of this application has its weight-average molecular weight controlled to fall within a range of 300 to 800 and thus has a sufficient stress relaxation effect and a satisfactory thermal decomposability. The resulting piezoelectric film is thus unlikely to crack with a reduced loss of quality.

Application 10

Application 10 is a preferred embodiment of the above-described precursor solution for piezoelectric films. In this application, the oxide-equivalent content of the metal elements contained in the precursor solution is in a range of 15% by mass to 25% by mass, both inclusive.

In the formulation of this application, the oxide-equivalent content of the metal elements is controlled to fall within a range of 15% by mass to 25% by mass, both inclusive, and this allows the resulting piezoelectric film to have a sufficiently large thickness when spin coating or any other similar film-formation process is used. Application 11

Application 11 is a possible embodiment of the above-described precursor solution for piezoelectric films. In this application, the precursor solution further contains at least one organic metal compound.

Application 12

Application 12 is a precursor solution for piezoelectric films. In this application, 90% or more of the molecules coordinating to the metal or metals contained in the precursor solution are of the same kind.

The manufacturing process of piezoelectric films involves heat treatment operations. During these heat treatment operations, the formulation of this application serves to narrow and limit the temperature range in which the thermal decomposition reactions relevant to the precursor solution can occur. In other words, a broader temperature margin is allowed during the heat treatment operations involved in the manufacturing process. The piezoelectric film formed with this precursor solution by a liquid-phase method thus has an improved in-plane uniformity in piezoelectric properties.

Application 13

Application 13 is a possible embodiment of the above-described precursor solution for piezoelectric films. In this application, 90% or more of the molecules coordinating to the metal or metals are acetic acid anions, butoxyethoxy groups, 2-ethylhexyl groups, diethanolamino groups, methoxyethoxy groups, or acetylacetonate anions.

Application 14

Application 14 is a preferred embodiment of the above-described precursor solution for piezoelectric films. In this application, the precursor solution further contains water to make 10% by mass or more of the preexisting solvent component thereof.

The formulation of this application makes the solutes more soluble in the precursor solution and thereby makes the precursor solution less likely to form a precipitate.

Application 15

Application 15 is a preferred embodiment of the above-described precursor solution for piezoelectric films. In this application, the precursor solution further contains a polyethylene glycol.

The formulation of this application serves for improved quality of the piezoelectric film obtained after sintering.

Application 16

Application 16 is a method for manufacturing a precursor solution for piezoelectric films. The precursor solution contains an acid, an alcohol, and a metal compound. This method includes adding water to make 20% by mass or more of the preexisting solvent component of the precursor solution.

The method according to this application serves to reduce the potential of the precursor solution for esterification reaction (detailed later). The reduced potential for esterification reaction makes the precursor solution less likely to undergo ester formation after preparation and thus less likely to change its viscosity after preparation. The resulting precursor solution is thus highly stable.

Application 17

Application 17 is a preferred embodiment of the above-described method for manufacturing a precursor solution for piezoelectric films. In this application, the method further includes adding an ester to the solvent component.

The method according to this application makes it more certain that the prepared precursor solution will be unlikely to change its viscosity.

Application 18

Application 18 is a preferred embodiment of the above-described method for manufacturing a precursor solution for piezoelectric films. In this application, the method includes adding the ester of the kind that the acid and the alcohol form by reacting with each other.

The method according to this application yields a highly stable precursor solution. Application 19

Application 19 is a preferred embodiment of the above-described method for manufacturing a precursor solution for piezoelectric films. In this application, the method further includes adding a titanium compound, adding a zirconium compound, and adding a lead compound. Water is added after the titanium compound and the zirconium compound are added, but before the lead compound is added.

The method according to this application makes the precursor solution less likely to form a precipitate.

Application 20

Application 20 is a method for manufacturing a piezoelectric film. This method includes applying a piezoelectric film precursor solution containing a metal compound and thereby forming a precursor piezoelectric coating (an application stage), and heating and crystallizing the precursor piezoelectric coating until a film thickness reduction of 27% to 45%, both inclusive, is reached and thereby forming the piezoelectric film (a sintering stage).

The method according to this application yields a piezoelectric film of good quality and with a reduced potential for cracking.

Application 21

Application 21 is a preferred embodiment of the above-described method for manufacturing a piezoelectric film. The piezoelectric film produced in this application is one made of a piezoelectric material containing at least Pb, Zr, and Ti.

The method according to this application yields a piezoelectric film with excellent piezoelectric properties.

Application 22

Application 22 is a preferred embodiment of the above-described method for manufacturing a piezoelectric film. In this application, the precursor solution contains a polyethylene glycol.

With the method according to this application it is easier to control the film thickness reduction at the sintering stage to fall within a range of 27% to 45%, both inclusive.

Application 23

Application 23 is a preferred embodiment of the above-described method for manufacturing piezoelectric films. In this application, the weight-average molecular weight of the polyethylene glycol is at least 200 but less than 1000.

With the method according to this application it is easier to control the film thickness reduction at the sintering stage to fall within a range of 27% to 45%, both inclusive.

Embodiments of the invention will now be described by way of example only with reference to the accompanying drawings, wherein like numbers reference like elements.

Fig. 1 is a schematic exploded perspective view of an ink jet recording head.

Figs. 2A and 2B are a plan view and a cross-sectional view of the ink jet recording head.

Fig. 3 is an enlarged cross-sectional view of the essential portion of the ink jet recording head.

Figs. 4A to 4C, 5A and 5B, 6A and 6B, and 7A and 7B are cross-sectional diagrams illustrating a method for manufacturing piezoelectric elements and an ink jet recording head.

Fig. 8 is a schematic perspective view of an ink jet recording apparatus.

Fig. 9 lists the raw materials used to prepare the piezoelectric film precursor solutions according to Embodiment 1.

Fig. 10 summarizes the weight measurements of the solvents, the metal sources, and the polymer used in Examples 1-1 to 1-5 and Comparative Examples 1-1 to 1-4.

Fig. 11 summarizes the metal oxide content and the carboxylic acid content of the precursor solutions prepared in Examples 1-1 to 1-5 and Comparative Examples 1-1 to 1-4 along with the thickness, the waterproofness, and the storage stability of the resulting PZT films.

Fig. 12 summarizes the weight measurements of the solvents, the metal sources, and the polymer used in Examples 1-6 to 1-22 and Comparative Examples 1-5 to 1-7.

Fig. 13 summarizes the metal oxide content and the carboxylic acid content of the precursor solutions prepared in Examples 1-6 to 1-22 and Comparative Examples 1-5 to 1-7 along with the consistency in thickness (thickness variations), the waterproofness, and the storage stability of the resulting films.

Fig. 14 summarizes the weight measurements of the solvents, the metal sources, and the polymer used in Examples 1-23 to 1-32.

Fig. 15 summarizes the metal oxide content and the carboxylic acid content of the precursor solutions prepared in Examples 1-23 to 1-32 along with the consistency in thickness (thickness variations), the waterproofness, and the storage stability of the resulting films.

Fig. 16 summarizes the weight measurements of the solvents, the metal sources, and the polymers used in Examples 1-33 to 1-43.

Fig. 17 summarizes the metal oxide content and the carboxylic acid content of the precursor solutions prepared in Examples 1-33 to 1-43 along with the thickness, the resistance to cracking, the waterproofness, and the storage stability of the resulting films.

Fig. 18 summarizes the weight measurements of the solvents, the metal sources, and the polymers used in Examples 1-44 to 1-48.

Fig. 19 summarizes the metal oxide content and the carboxylic acid content of the precursor solutions prepared in Examples 1-44 to 1-48 and Comparative Example 1-8 along with the spinning speed used and the thickness, the waterproofness, and the storage stability of the resulting films.

Fig. 20 summarizes the weight measurements of the solvents, the metal sources, and the polymer used in Examples 1-49 and 1-50.

Fig. 21 summarizes the metal oxide content and the carboxylic acid content of the precursor solutions prepared in Examples 1-49 and 1-50 along with the consistency in thickness (thickness variations), the waterproofness, and the storage stability of the resulting films.

Fig. 22 lists the raw materials used to prepare the piezoelectric film precursor solutions according to Embodiment 2.

Fig. 23 summarizes the weight measurements of the solvents, the metal sources, and the polymer used in Examples 2-1 to 2-5 and Comparative Examples 2-1 to 2-4.

Figs. 24 to 26 show the molecular weight distribution of zirconium acetate measured in Examples 2-1 to 2-3, respectively.

Fig. 27 summarizes the metal oxide content and the carboxylic acid content of the precursor solutions prepared in Examples 2-1 to 2-5 and Comparative Examples 2-1 to 2-4 along with the thickness, the waterproofness, and the storage stability of the resulting PZT films.

Fig. 28 summarizes the weight measurements of the solvents, the metal sources, and the polymer used in Examples 2-6 to 2-8 and Comparative Examples 2-5 to 2-7.

Fig. 29 summarizes the metal oxide content and the carboxylic acid content of the precursor solutions prepared in Examples 2-6 to 2-8 and Comparative Examples 2-5 to 2-7 along with the consistency in thickness (thickness variations), the waterproofness, and the storage stability of the resulting films.

Fig. 30 summarizes the weight measurements of the solvents, the metal sources, and the polymers used in Examples 2-9 to 2-12.

Fig. 31 summarizes the metal oxide content and the carboxylic acid content of the precursor solutions prepared in Examples 2-9 to 2-12 and Comparative Example 2-8 along with the spinning speed used and the thickness, the waterproofness, and the storage stability of the resulting films.

Fig. 32 summarizes the weight measurements of the solvents, the metal sources, and the polymers used in Examples 2-13 to 2-23.

Fig. 33 summarizes the metal oxide content and the carboxylic acid content of the precursor solutions prepared in Examples 2-13 to 2-23 along with the thickness, the resistance to cracking, the waterproofness, and the storage stability of the resulting films.

Figs. 34 to 38 and Fig. 39 are $^1$H-NMR spectra obtained for Examples 3-1 to 3-5 and Comparative Example 3-1, respectively.

Fig. 40 shows the full width at half maximum of the (100) XRD peak plotted against defatting temperature for Example 3-1 and Comparative Example 3-1.

Fig. 41 is a flow chart illustrating the method for manufacturing a precursor solution for piezoelectric films according to Embodiment 4.

Fig. 42 shows the amounts of ester formation measured for Examples 4-1 and 4-2 and Comparative Example 4-1 on a graph.

Figs. 43 and 44 are $^1$H-NMR spectra taken for Example 4-1 on Days 0 and 30 of storage, respectively.

Figs. 45 and 46 are $^1$H-NMR spectra taken for Comparative Example 4-1 obtained on Days 0 and 30 of storage, respectively.

Fig. 47 shows the relationship between the weight-average molecular weight of PEG and the film thickness reduction at the sintering stage.

Fig. 48 shows the relationship between defatting time and the film thickness reduction at the sintering stage.

Fig. 49 shows the relationship between defatting temperature and the film thickness reduction at the sintering stage.

Fig. 50 shows the relationship between drying temperature and the film thickness reduction at the sintering stage.

Fig. 51 shows the relationship between the amount of PEG added and the film thickness reduction at the sintering stage.

Figs. 52 and 53 are metallographic microscope surface images of the piezoelectric layers of Example 5-1 and Comparative Example 5-2, respectively.

Figs. 54 and 55 are cross-sectional SEM images of the piezoelectric layers of Example 5-1 and Comparative Example 5-1, respectively.

The following describes some embodiments of the invention with reference to the accompanying drawings. Prior to that, however, an overview of an ink jet recording head is provided. This ink jet recording head is an example of the liquid ejecting head that incorporates piezoelectric elements produced using the piezoelectric film precursor solution, the method for manufacturing it, and the method for manufacturing a piezoelectric film according to the corresponding embodiments of the invention.

Liquid Ejecting Head

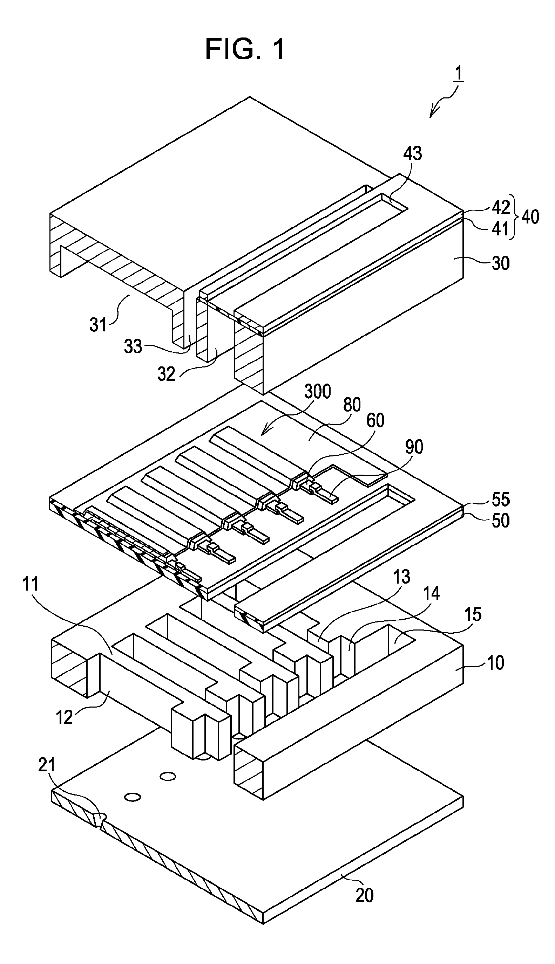

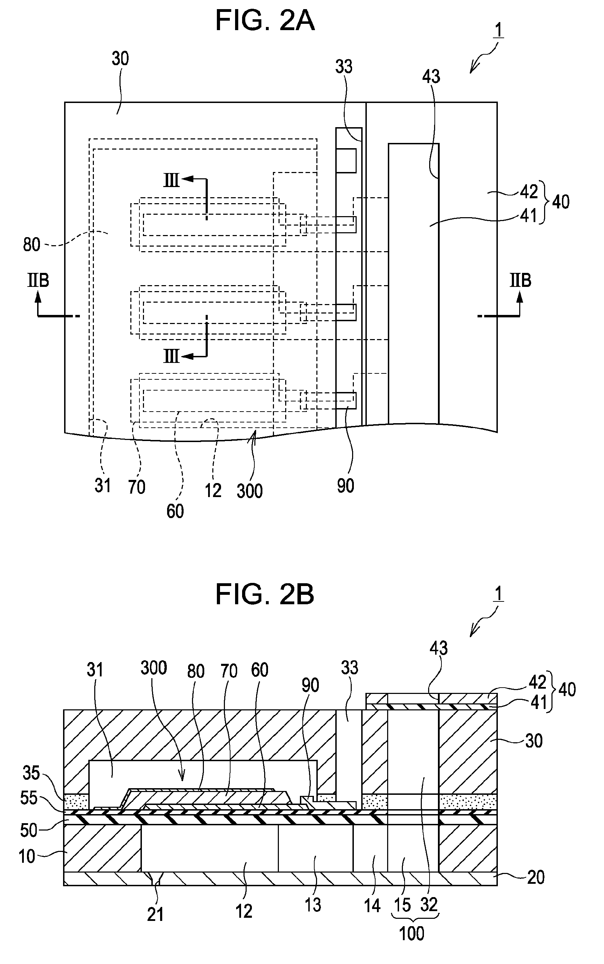

Fig. 1 is a schematic exploded perspective view of an ink jet recording head 1. Fig. 2A is a plan view of the same ink jet recording head, and Fig. 2B is a cross-sectional diagram taken along line IIB-IIB in Fig. 2A. As illustrated in Figs. 1, 2A, and 2B, the ink jet recording head 1 has a flow channel substrate 10, a nozzle plate 20, and a protective substrate 30.

In a possible constitution, the flow channel substrate 10 is a silicon single crystal substrate having a crystal plane orientation of (110). The flow channel substrate 10 has an elastic film 50 (*e.g.*, a silicon dioxide [$SiO_2$] film having a thickness of 0.5 $\mu$m to 2.0 $\mu$m formed by thermal oxidation) formed in advance on one side thereof. The flow channel substrate 10 further has multiple pressure chambers 12, which are spaces existing between the elastic film 50 and the nozzle plate 20 and divided by partitions 11. The pressure chambers 12 are arranged in the width direction thereof. Hereinafter, this direction is referred to as the first direction, and the direction perpendicular to the first direction is referred to as the longitudinal direction of the pressure chambers 12 or the second direction. The first and second directions are therefore orthogonal to the thickness direction of the flow channel substrate 10. In Fig. 2A, line IIB-IIB is in parallel with the second direction, and line III-III is in parallel with the first direction.

The flow channel substrate 10 also has ink supply paths 13 and communicating paths 14 divided by the partitions 11 and each communicating with each pressure chamber 12 from the same longitudinal end. Furthermore, the flow channel substrate 10 has a communicating space 15, which communicates with the communicating paths 14 from outside with respect to the second direction. This communicating space 15 also communicates with a reservoir portion 32 formed in the protective substrate 30 (described later) to serve as a component of a reservoir 100, a common ink tank (liquid tank) for the pressure chambers 12.

The ink supply paths 13 have a smaller cross section than that of the pressure chambers 12 and thereby serve to maintain the resistance to which the ink is exposed when it flows from the communicating space 15 into the pressure chambers 12. The ink supply paths 13 can be formed by, for example, making the channel between the reservoir 100 and each pressure chamber 12 have a reduced width over some length from the pressure chamber 12. Although in the illustrated ink jet recording head the ink supply paths 13 are formed by making a projection on one lateral side in each channel, the flow channels may have projections on both lateral sides. The ink supply paths 13 may also be formed by narrowing each channel in the thickness direction of the flow channel substrate 10 rather than in the width direction. The communicating paths 14 are formed by extending the partitions 11, which exist along both lateral sides of the pressure chambers 12, toward the communicating space 15 so as to divide the space between the ink supply paths 13 and the communicating space 15.

Although the flow channel substrate 10 of the illustrated ink jet recording head is a silicon single crystal substrate, its material is not limited to silicon single crystals; glass, ceramic materials, stainless steel, and other suitable materials can be used.

To the opposite side of the flow channel substrate 10 to the elastic film 50, the nozzle plate 20 is bonded with an adhesive agent, hot-melt film, or some other adhesive material. The nozzle plate 20 has nozzle openings 21 drilled therethrough, and each nozzle opening 21 communicates with each pressure chamber 12 near the opposite end to the ink supply path 13. The nozzle openings 21 are therefore arranged in the first direction. The nozzle plate 20 is made of a glass ceramic material, silicon single crystals, stainless steel, or some other suitable material.

The elastic film 50, which is formed on one side of the flow channel substrate 10, is covered with an insulating film 55 having a thickness of 0.05 $\mu$m to 0.8 $\mu$m. The insulating film 55 is made of, for example, zirconium oxide ($ZrO_2$). On this insulating film 55, a lower electrode 60, a piezoelectric layer 70, and an upper electrode 80 are formed and stacked in this order by the procedure described later, and in a possible constitution their thicknesses are 0.2 $\mu$m, 1.3 $\mu$m, and 0.05 $\mu$m, respectively. The lower electrode 60, the piezoelectric layer 70, and the upper electrode 80, and any other necessary components collectively provide multiple piezoelectric elements 300. Usually, one of the constituent electrodes of the piezoelectric elements 300 is used as a common electrode, and the other is patterned together with the piezoelectric layer 70 to provide separate electrodes that fit the pressure chambers 12. The illustrated ink jet recording head takes the *common upper electrode* structure, in which the lower electrode 60 is patterned to provide the separate electrodes and the upper electrode 80 serves as the common electrode.

Here, each piezoelectric element 300 and the portion of the diaphragm displaced by the movement of the piezoelectric element 300 are collectively referred to as a piezoelectric actuator. In the illustrated ink jet recording head, the elastic film 50, the insulating film 55, and the lower electrode 60 collectively serve as the diaphragm.

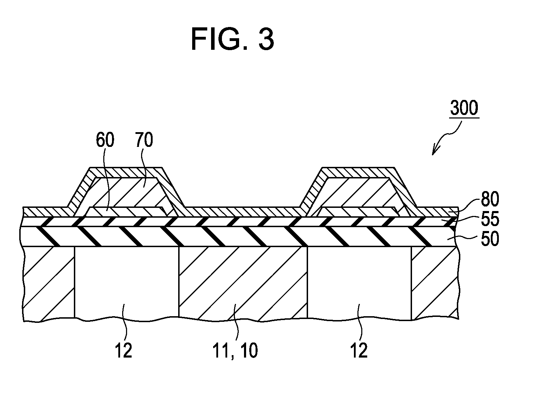

The piezoelectric film precursor solution, the method for manufacturing it, and the method for manufacturing a piezoelectric film according to their respective embodiments of the invention can be used to produce these piezoelectric elements 300. The following further details the structure of each piezoelectric element 300 with reference to Fig. 3. Fig. 3 illustrates the essential portion of the ink jet recording head on a cross-sectional diagram taken along line III-III in Fig. 2A.

As illustrated in Fig. 3, the lower electrode 60, the separate electrode for the piezoelectric element 300 in this drawing, is located to fit the pressure chamber 12 and is narrower than the pressure chamber 12.

As can be seen from Figs. 1, 2A, and 2B, the lower electrode 60 extends from near one longitudinal end of the pressure chamber 12 toward the ink supply path 13 and is connected to a lead electrode 90 outside the pressure chamber 12 (on the ink supply path 13 side). The lead electrode 90 is made by gold (Au) or some other suitable material and used to activate the piezoelectric element 300. The opposite end of the lower electrode 60 to the lead electrode 90 is located within the area overlapping with the pressure chamber 12 in plan view, or in the view looking down in the thickness direction of the flow channel substrate 10 (see Fig. 2A).

The piezoelectric layer 70 is wider than the lower electrode 60 but narrower than the pressure chamber 12. And the ends of the piezoelectric layer 70 with respect to the second direction both extend beyond the corresponding ends of the pressure chamber 12. The piezoelectric layer 70 therefore covers the top and the sides of the lower electrode 60 within the area overlapping with the pressure chamber 12. The end of the piezoelectric layer 70 on the lead electrode 90 side is located near the corresponding end of the pressure chamber 12. On the lead electrode 90 side, the lower electrode 60 extends to a greater length than the piezoelectric layer 70.

The upper electrode 80 seamlessly extends to span the areas overlapping with the pressure chambers 12 in the second direction. In the first direction, the upper electrode 80 extends beyond the opposite ends of the pressure chambers 12 to the lead electrodes 90. As a result, the upper electrode 80 covers almost entire top and side surfaces of the piezoelectric layer 70 within the areas overlapping with the pressure chambers 12.

Placing the upper electrode 80 in this way, i.e., to cover almost entire top and side surfaces of the piezoelectric layer 70 within the areas overlapping with the pressure chambers 12, serves to prevent the moisture in the air (damp) from penetrating into the piezoelectric layer 70. Each piezoelectric element 300 (the piezoelectric layer 70) is thus protected from the destruction caused by moisture (damp). As a result, the piezoelectric element 300 is remarkably durable.

The end of the upper electrode 80 on the lead electrode 90 side is located within the whole area defined by the pressure chambers 12. The substantial driving portion of each piezoelectric element 300 is thus positioned within the area overlapping with the corresponding pressure chamber 12. This means that the lower electrode 60, the piezoelectric layer 70, and the upper electrode 80 work as the substantial driving portions of the piezoelectric elements 300 within the areas overlapping with the pressure chambers 12. While the piezoelectric elements 300 are in operation, therefore, the diaphragm (the elastic film 50 and the insulating film 55) is deformed only to a limited extent near the longitudinal ends of each pressure chamber 12 and thus is unlikely to crack around there. Although in the illustrated constitution the surface of the piezoelectric layer 70 is partially exposed even within the areas overlapping with the pressure chambers 12, the exposed areas are very small, and the edge of the upper electrode 80 is sufficiently distant from the lower electrode 60 as detailed later; in this way, this constitution can adequately prevent the destruction of the piezoelectric layer 70 caused by moisture.

To the surface of the flow channel substrate 10 on which the elastic film 50, the insulating film 55, and the piezoelectric elements 300 have been formed, the protective substrate 30 is bonded using an adhesive agent 35. The protective substrate 30 has a piezoelectric element housing 31, which is a space formed over the whole area defined by the piezoelectric elements 300 and large enough to allow the piezoelectric elements 300 to move. Placing the piezoelectric elements 300 inside this piezoelectric element housing 31 provides a nearly perfect protection against the external environment. Furthermore, the protective substrate 30 has a reservoir portion 32 over the area corresponding to the communicating space 15 of the flow channel substrate 10. In the illustrated ink jet recording head, the reservoir portion 32 is formed through the entire thickness of the protective substrate 30 and extends along the direction of arrangement of the pressure chambers 12 (the first direction). The reservoir portion 32 communicates with the communicating space 15 of the flow channel substrate 10 to form a reservoir 100, a common ink tank for the pressure chambers 12 (see Fig. 2B).

Furthermore, the protective substrate 30 has a through-hole 33 in the area between the piezoelectric element housing 31 and the reservoir portion 32, and this through-hole 33 is formed through the entire thickness of the protective substrate 30. Although not illustrated in the drawings, the lower electrode 60 and the lead electrodes 90 are connected to a driving IC or some other circuit for activating the piezoelectric elements 300 via wiring installed inside this through-hole 33.

Examples of materials for the protective substrate 30 include glass, ceramic materials, metals, and resins. Preferably, however, the protective substrate 30 is made of a material having a coefficient of thermal expansion equal or nearly equal to that of the flow channel substrate 10. In the illustrated ink jet recording head, the protective substrate 30 and the flow channel substrate 10 are made of the same material; both are silicon single crystal substrates.

To the protective substrate 30, furthermore, a compliance substrate 40 is bonded. The compliance substrate 40 is composed of a sealing film 41 and a stationary plate 42. The sealing film 41 is made of a low-rigidity flexible material, and the reservoir portion 32 is sealed with this sealing film 41 at one end (the opposite end to the flow channel substrate 10). On the other hand, the stationary plate 42 is made of a harder material such as metal. The stationary plate 42 has an opening 43 formed through its entire thickness over the area overlapping with the reservoir 100. One end of the reservoir 100 (the opposite end to the flow channel substrate 10) is therefore sealed with the flexible sealing film 41 only.

The illustrated ink jet recording head 1 receives ink from an external ink source (not illustrated), and the ink fills the entire space from the reservoir 100 to the nozzle openings 21. After the internal space is completely filled with the ink, the driving IC (not illustrated) transmits recording signals and in response to them voltage is distributed to the piezoelectric elements 300 corresponding to appropriate ones of the pressure chambers 12. The energized piezoelectric elements 300 are deformed to pressurize the corresponding pressure chambers 12, and the ink is ejected in droplets through the corresponding nozzle openings 21.

Method for Manufacturing Piezoelectric Elements and an Ink Jet Recording Head

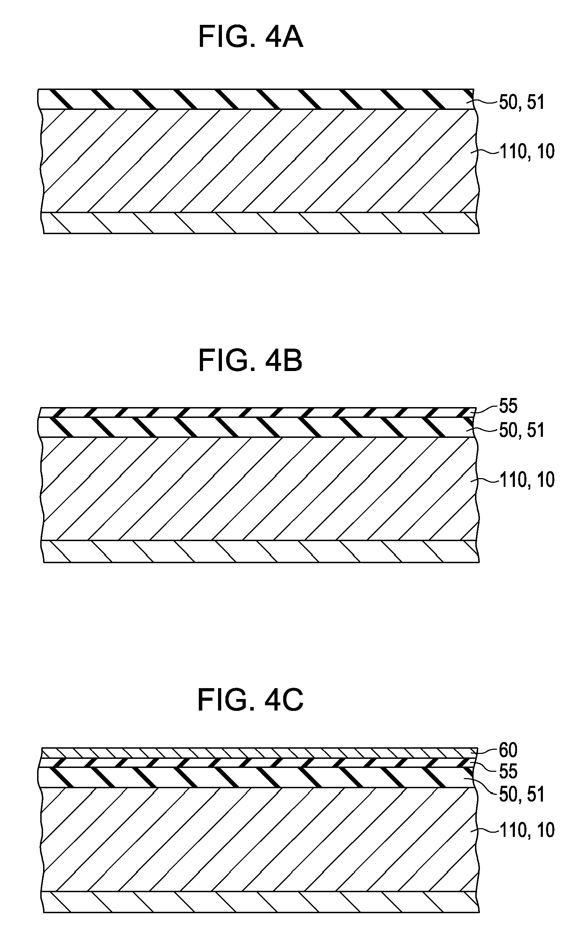

The following describes a method for manufacturing the piezoelectric elements 300 and the ink jet recording head 1 described above, with reference to Figs. 4A to 4C, 5A and 5B, 6A and 6B, and 7A and 7B. Figs. 4A to 4C, 5A and 5B, 6A and 6B, and 7A and 7B are cross-sectional diagrams illustrating the individual stages of this manufacturing process for piezoelectric elements and an ink jet recording head. The cross sections shown in Figs. 4A to 4C, 5A and 5B, 6A and 6B, and 7A and 7B all extend in the direction of line III-III in Fig. 2A.

First, as illustrated in Fig. 4A, the surface of a flow channel substrate wafer 110 is coated with an oxide film 51. The flow channel substrate wafer 110 is a silicon wafer and serves as a common base to form multiple flow channel substrates 10. The oxide film 51 serves as the elastic film 50.

Then, as illustrated in Fig. 4B, an insulating film 55 is formed on the elastic film 50 (the oxide film 51) from zirconium oxide ($ZrO_2$) or some other suitable material.

Then, as illustrated in Fig. 4C, a lower electrode 60 is formed on the insulating film 55. The material of the lower electrode 60 is not particularly limited; however, if the piezoelectric layer 70 that covers the lower electrode 60 is made of a PZT-based composite oxide, it is desirable to choose a material that can maintain its conductivity with little change when the lead oxide diffuses thereinto. If the piezoelectric layer 70 is formed by a liquid-phase process, it is desirable that the lower electrode 60 is unlikely to be oxidized by heat treatment. The lower electrode 60 is therefore preferably a single unit made of platinum, iridium, or some other suitable simple metal or a laminate of layers made of these metals.

The method for forming the lower electrode 60 is not particularly limited and examples include sputtering, chemical vapor deposition (CVD), and physical vapor deposition (PVD). Although not illustrated in the drawings, it is allowed to form a contact film by sputtering or vacuum deposition prior to the formation of the lower electrode 60. If such a contact film is formed, its material is titanium, zirconium, or chromium, and its thickness is typically in a range of 0.005 μm to 0.05 μm.

After the formation of the lower electrode 60, the lower electrode 60 may immediately be covered with a titanium layer, although not illustrated in the drawings. This will provide some degree of crystal orientation to the piezoelectric layer 70. Such a titanium layer can be formed by sputtering or any other suitable technique, and its thickness is typically in a range of 0.003 μm to 0.02 μm. Although such a titanium layer is usually a uniform coating formed on the lower electrode 60, it may also take a form like islands.

Then, the lower electrode 60 is coated with a piezoelectric layer 70 made of lead zirconate titanate (PZT) or some other PZT-based composite oxide. The illustrated manufacturing method employs a liquid-phase method to form the piezoelectric layer 70. More specifically, the illustrated method uses a kind of sol-gel process in which organic metal compounds are dissolved or dispersed in a solvent component to form a sol (the precursor solution), the sol is applied and dried to form a gel, and then the gel is sintered at a high temperature to produce a metal-oxide-based piezoelectric layer 70.

The following describes a method for producing the piezoelectric layer 70, including the procedure for forming the piezoelectric films contained therein. This method for producing the piezoelectric layer 70 includes at least five stages: solution preparation, application, drying, defatting, and sintering.

At the solution preparation stage, a solvent component, lead-, zirconium-, and titanium-based organic metal compounds, and a polymeric component are mixed, and the obtained mixture is stirred to yield a piezoelectric film precursor solution for liquid-phase methods. Further details of how to prepare this piezoelectric film precursor solution will be provided later.

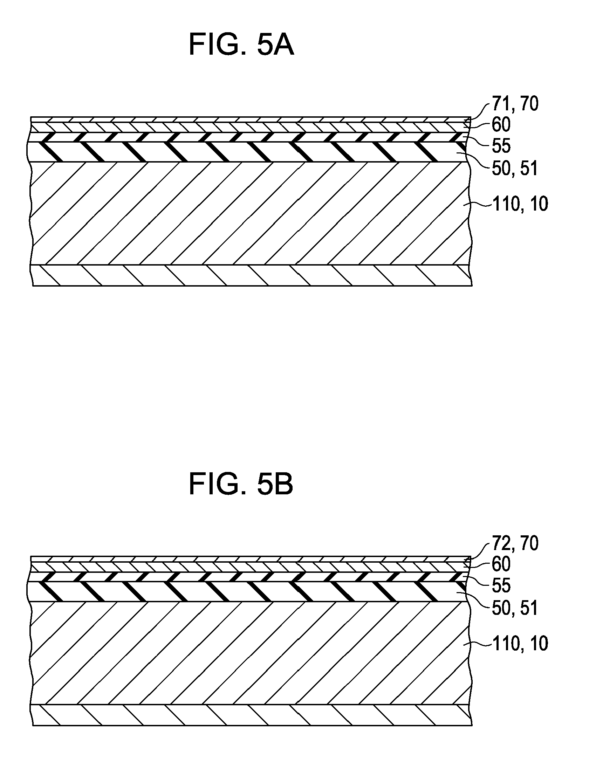

Then, at the application stage, the piezoelectric film precursor solution is applied to the flow channel substrate wafer 110 that has the lower electrode 60 formed thereon, as illustrated in Fig. 5A. As a result, the lower electrode 60 is covered with a precursor piezoelectric coating 71, a PZT-based precursor film.

The piezoelectric film precursor solution can be applied by spin coating, spray coating, dip coating, ink jet printing, or any other suitable application technique. A preferred technique is spin coating because it can form films over substrates on one side only and with good in-plane thickness uniformity and thereby allows for the use of various apparatuses for semiconductor processes. The conditions of spin coating (e.g., spinning speed and spinning time) can be appropriately selected depending on the characteristics of the piezoelectric film precursor solution used; however, the spinning speed is preferably on the order of 500 to 5000 rpm for such purposes as ensuring the in-plane thickness uniformity of the film and preventing the precursor solution from reaching the back surface of the base. In the course of the spin coating process, a rinse agent can be used to clean the edge of the substrate and the back surface of the base. These cleaning operations are referred to as edge rinsing and back rinsing, respectively.

Then, at the drying stage, the precursor piezoelectric coating 71 is heated at a certain temperature and thereby dried for a certain period of time. For example, the sol (precursor solution) applied to the flow channel substrate wafer 110 is maintained at a temperature of 140 to 180˚C for 5 to 30 minutes so it is dried. It is preferable that the drying temperature is high enough to make the solvent of the precursor solution evaporate; for example, it can be 140˚C when the solvent component consists of acetic acid.

Then, at the defatting stage, the dried precursor piezoelectric coating 71 is maintained at a certain temperature for a certain period of time so it is defatted. In the illustrated method, the dried precursor piezoelectric coating 71 is defatted by maintaining it at a temperature of 350 to 500˚C for 5 to 30 minutes.

The term *defatting* as used herein represents removing organic substances from the precursor piezoelectric coating 71 by changing them into $CO_2$, $H_2O$, alcohols, hydrocarbons, or other chemical species. The defatting temperature therefore depends on what and how much organic substances exist in the precursor piezoelectric coating 71. Results of thermal analyses (*e.g.*, TG/DTA and DSC) may serve as guides for choosing the defatting temperature. Some thermal analysis methods track the exothermic reaction that proceeds as the precursor solution is defatted, and some others measure the temperature at which a weight change occurs.

When PZT is used as the material of the piezoelectric film, the formation of the non-ferroelectric pyrochlore phase should be avoided, and the term *defatting* therefore means that the defatted precursor piezoelectric coating 71 is not crystalline, *i.e.,* it is amorphous. The defatting stage is for the purpose of removing organic substances from the precursor piezoelectric coating 71 by evaporation or thermal decomposition and thus can be performed in the air or in any other atmosphere containing oxygen.

Then, at the sintering stage, the precursor piezoelectric coating 71 is maintained at a certain temperature for a certain period of time so it is crystallized, and thereby a piezoelectric film 72 is formed as illustrated in Fig. 5B. Electric furnaces, RTA (rapid thermal annealing) apparatuses, and other suitable systems can be used at this sintering stage. When PZT is used as the material of the piezoelectric film 72, it is preferable that the defatted precursor piezoelectric coating 71 is heated and crystallized at a temperature of 650 to 800˚C so that the whole film should be composed only of the ferroelectric perovskite phase. It is also preferable that the defatted coating is sintered in an oxygen atmosphere or under a stream of oxygen so that the oxygen loss out of PZT should be prevented.

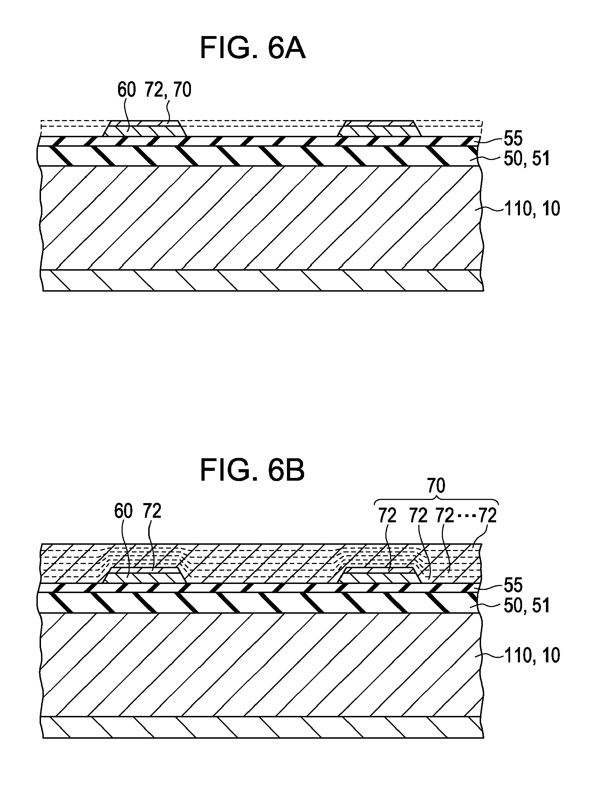

After the first piezoelectric film 72 is formed on the lower electrode 60 in this way, the lower electrode 60 and the first piezoelectric film 72 are patterned together to have sloping sides as illustrated in Fig. 6A.

However, for example, if the lower electrode 60 was patterned before the formation of the first piezoelectric film 72, the operations for patterning the lower electrode 60 would involve photolithography, etching, and ashing. These treatments could modify the surface characteristics of such portions as the lower electrode 60 and the titanium layer formed on the lower electrode 60 to provide some degree of crystal orientation to the resulting piezoelectric film (not illustrated). Forming the piezoelectric film 72 on the affected lower electrode 60 would result in the piezoelectric film 72 somewhat lacking crystallinity or crystal orientation. This means that the whole piezoelectric layer 70 would have inadequate crystallinity because the crystal growth in the second and subsequent piezoelectric films 72 is influenced by the crystallographic state of the first piezoelectric film 72.

On the other hand, the illustrated method, in which the first piezoelectric film 72 is formed in advance and then this piezoelectric film 72 is patterned together with the lower electrode 60, allows for good crystal growth in the second and subsequent piezoelectric films 72 because the piezoelectric film 72 itself can serve as a better crystallization seed layer than titanium or other similar kinds of seed crystals. Furthermore, the high performance of the piezoelectric film 72 as a seed layer ensures that the crystal growth in the second and subsequent piezoelectric films 72 is not seriously affected even if as a result of the patterning operation a very thin deteriorated layer is formed on the surface.

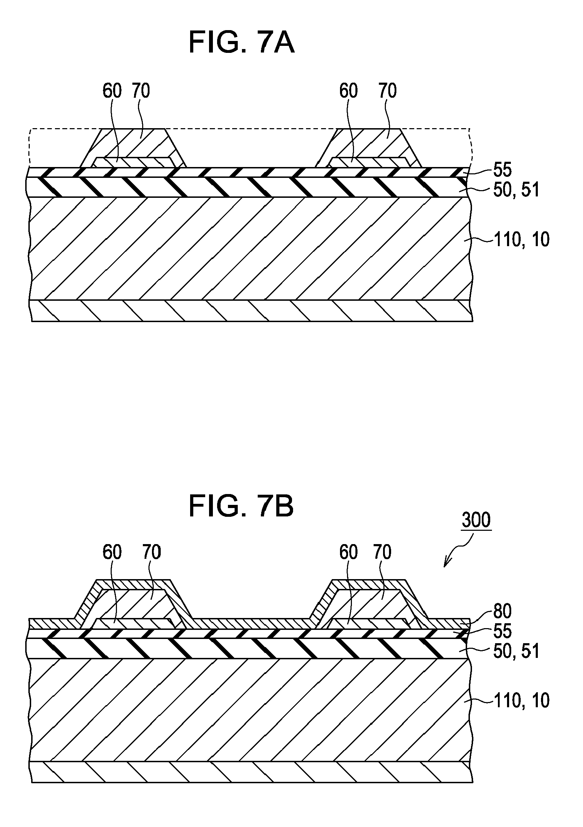

Then, this piezoelectric film formation cycle consisting of the precursor film formation phase (the application, drying, and defatting stages) and the sintering stage is repeated twice or more, and thereby the second to top piezoelectric films 72 are formed as illustrated in Fig. 6B. After that, the stack of piezoelectric films 72, including the second and all subsequent layers, is patterned to form the piezoelectric layer 70 as illustrated in Fig. 7A.

Then, as illustrated in 7B, an upper electrode 80 is formed over the entire surface of the flow channel substrate wafer 110 and then patterned into a certain shape. A specific example is the pattern illustrated in Fig. 2A, in which the upper electrode 80 seamlessly extends in the direction of arrangement of the pressure chambers 12 (the second direction) and, in the first direction, extends from near the ends of the pressure chambers 12 on the lead electrode 90 side to beyond the other ends. In this way, piezoelectric elements 300 are formed.

Then, although not illustrated in the drawings, the entire surface of the flow channel substrate wafer 110 is coated with gold (Au) or some other suitable metal and the coating is patterned to fit the piezoelectric elements 300, and thereby lead electrodes 90 are formed.

After that, a protective substrate wafer is bonded to the surface of the flow channel substrate wafer 110 on the piezoelectric element 300 side using an adhesive agent 35. The protective substrate wafer is a silicon wafer and will later be divided into several protective substrates 30. Each protective substrate 30 has a reservoir portion 32, a piezoelectric element housing 31, and other necessary features formed in advance. The protective substrate 30 is typically a silicon single crystal substrate, and its typical thickness is about 400 μm. Bonding of the protective substrates 30 significantly improves the rigidity of the flow channel substrates 10. Then, the flow channel substrate wafer 110 is processed to have a certain thickness.

Subsequently, a masking film is formed on the flow channel substrate wafer 110 and patterned into a certain shape. The flow channel substrate wafer 110 is then anisotropically etched through the masking film with KOH or some other alkali solution (wet etching), and thereby the pressure chambers 12 corresponding to the piezoelectric elements 300 are formed together with ink supply paths 13, communicating paths 14, a communicating space 15, and other necessary features.

After that, driving circuits (not illustrated) are mounted on the protective substrate wafer and connected to the lead electrodes 90 via wiring, the masking film is removed from the surface of the flow channel substrate wafer 110 on which the pressure chambers 12 have openings, and then the flow channel substrate wafer 110 and the protective substrate wafer are trimmed by dicing or some other suitable technique so that any unnecessary peripheral portions should be removed.

Then, a nozzle plate 20 is bonded to the opposite side of the flow channel substrate wafer 110 to the protective substrate wafer, and compliance substrates 40 are bonded to the protective substrate wafer. The entire structure including the flow channel substrate wafer 110 and all other components bonded thereto is divided into equal-sized chips each composed of one flow channel substrate 10 and other components like that illustrated in Fig. 1. In this way, ink jet recording heads 1 each having the above-described structure are produced.

Liquid Ejecting Apparatus

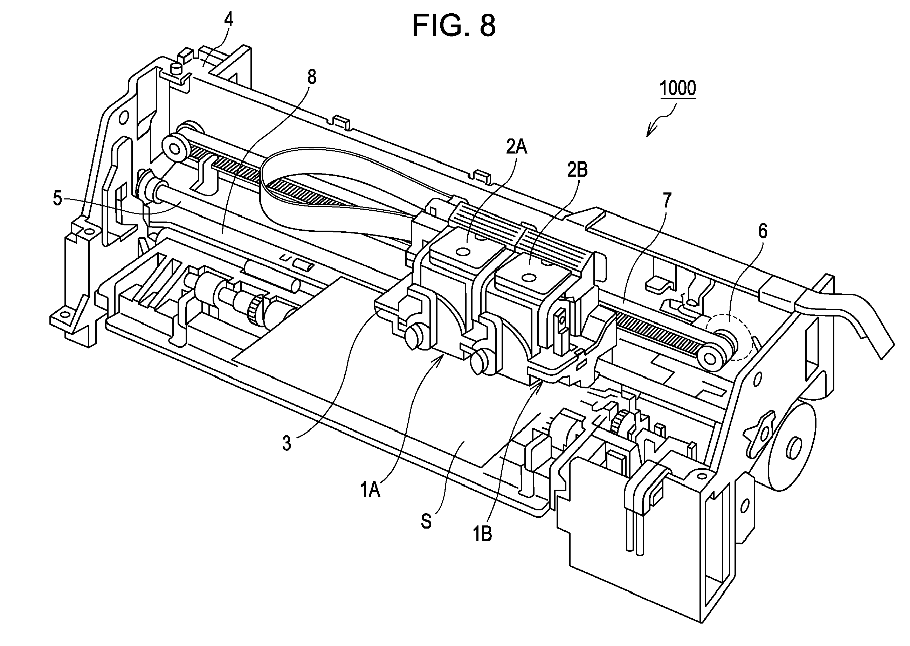

The following provides an overview of an ink jet recording apparatus. This ink jet recording apparatus is an example of the liquid ejecting apparatus that incorporates the ink jet recording head 1 described above. Fig. 8 is a schematic perspective view of this ink jet recording apparatus.

As illustrated in Fig. 8, the ink jet recording apparatus 1000 has ink jet recording head units 1A and 1 B. The ink jet recording head units 1A and 1B each incorporate the ink jet recording head 1 illustrated in Fig. 1 and carry detachable ink supply cartridges 2A and 2B, respectively.

The ink jet recording head units 1A and 1 B are supported by a carriage 3. The main body 4 has a carriage shaft 5, along which the carriage 3 can be freely moved. In a typical constitution, the ink jet recording head unit 1 A discharges a black ink composition, and the ink jet recording head unit 1 B discharges a color ink composition.

The driving force generated by a motor 6 is transmitted through gears (not illustrated) and a timing belt 7 to the carriage 3. Receiving the driving force from the motor 6, the carriage 3 and the ink jet recording head units 1A and 1 B carried thereon move along the carriage shaft 5. Incidentally, the main body 4 has a platen 8 extending along the carriage shaft 5. Although not illustrated in the drawing, rollers or some other feeding mechanism feeds a recording sheet S (paper or some other recording medium), which is then transported by this platen 8.

Although in the constitution illustrated in Fig. 8 the ink jet recording head units 1A and 1 B each have one ink jet recording head 1, this is not the only possible constitution. For example, one of the ink jet recording head units 1A and 1 B may have two or more ink jet recording heads 1. It is also allowed to directly mount the ink jet recording heads 1 on the ink jet recording apparatus 1000 instead of placing them on the ink jet recording head units 1A and 1 B.

Furthermore, although in the illustrated ink jet recording apparatus 1000 the ink jet recording head units 1A and 1 B having ink jet recording heads 1 move on the carriage 3 in the primary scanning direction, this is not the only possible way of printing that benefits from the invention. For example, the invention can be applied to recording apparatuses having a line ink jet head, in which ink jet recording heads 1 remain in fixed positions and a recording sheet S (paper or some other recording medium) moves in the secondary scanning direction.

Moreover, although the foregoing illustrates liquid ejecting heads by describing the ink jet recording head 1 as an example, the invention can also be applied to liquid ejecting heads not used with ink, such as recording heads for printers and other kinds of image recording apparatuses, colorant ejecting heads for manufacturing color filters for liquid crystal displays and other kinds of displays, electrode material ejecting heads for forming electrodes for organic EL displays, FEDs (field emission displays), and other kinds of displays, and bioorganic substance ejecting heads for manufacturing biochips.

In the following paragraphs, some embodiments of the invention are described with reference to the accompanied drawings.

Embodiment 1

Precursor Solution for Piezoelectric Films

The following describes the piezoelectric film precursor solution according to Embodiment 1. The piezoelectric film precursor solution according to Embodiment 1 is a precursor solution for the formation of a piezoelectric film (a piezoelectric element) by a liquid-phase method.

The piezoelectric film precursor solution according to Embodiment 1 is a solution obtained by mixing the organic metal compounds constituting the intended composite oxide and a solvent component. The precursor solution is prepared at the solution preparation stage mentioned above. Specifically, the precursor solution is obtained by mixing the following raw materials and stirring the mixture: a selected carboxylic acid or acids, *e.g.*, acetic acid and/or propionic acid (the solvent component); lead-, zirconium-, and titanium-based organic metal compounds; and a polymeric component. The carboxylic acids that can be used in this embodiment are ones having a stabilizing effect on metal alkoxides and unlikely to cause a reduced storage stability and an increased viscosity in the precursor solution even when their content is increased; they can thus be suitably used to constitute the solvent component.

The raw materials may be mixed by the "one-pot" method or in separate vessels. In a possible "one-pot" procedure, a zirconium alkoxide and a titanium alkoxide are added to the carboxylic acid or acids, lead acetate is then added, and finally the polymeric component is added to yield the piezoelectric film precursor solution. When several vessels are used, the following three solutions are separately prepared and then mixed with the polymeric component: a solution containing the carboxylic acid or acids and lead acetate (a first solution), a solution containing the carboxylic acid or acids and a zirconium alkoxide (a second solution), and a solution containing the carboxylic acid and acids and a titanium alkoxide (a third solution).

The mixing operation may be performed at room temperature, or more specifically at around 25˚C, or under heat. For example, when lead (II) acetate trihydrate, a solid, is used as the lead acetate, the solvent may be heated while the solute is added and mixed so that it can be dissolved faster. The molar ratios between the lead, zirconium, and titanium sources have some influence on the piezoelectric properties of the resulting piezoelectric layer 70 and thus, for example, it is preferred to adjust their amounts to meet the following relation: Pb:Zr:Ti = 1.05 to 1.25:0.46 to 0.56: 0.44 to 0.54 (molar ratios).

The lead-based organic metal compound is lead (II) acetate or lead (IV) acetate, both usually in the form of trihydrate, and is preferably lead (II) acetate because it is easier to handle.

The zirconium-based organic metal compound is preferably a zirconium alkoxide. Any zirconium alkoxide can be used as long as the ligand is an alkoxy group having 3 to 8 carbon atoms. Examples include zirconium tetra-n-propoxide, zirconium tetraisopropoxide, zirconium tetra-n-butoxide, zirconium tetraisobutoxide, zirconium tetra-sec-butoxide, zirconium tetra-tert-butoxide, zirconium tetra-n-pentoxide, zirconium tetra-sec-pentoxide, zirconium tetra-tert-pentoxide, zirconium tetra-n-hexoxide, zirconium tetra-sec-hexoxide, zirconium tetra-n-heptoxide, zirconium tetra-sec-heptoxide, zirconium tetra-n-octoxide, tetrakis(2-ethylhexyloxy) orthozirconate, and so forth, and these compounds may be used as a pure substance or as a mixture. A ligand having 3 or more carbon atoms serves to reduce the amount of carboxylate formation, and one having 8 or less carbon atoms serves for an increased metal oxide content of the piezoelectric film precursor solution.

The titanium-based organic metal compound is preferably a titanium alkoxide. Any titanium alkoxide can be used as long as the ligand is an alkoxy group having 3 to 8 carbon atoms. Examples include titanium tetra-n-propoxide, titanium tetraisopropoxide, titanium tetra-n-butoxide, titanium tetraisobutoxide, titanium tetra-sec-butoxide, titanium tetra-tert-butoxide, titanium tetra-n-pentoxide, titanium tetra-sec-pentoxide, titanium tetra-tert-pentoxide, titanium tetra-n-hexoxide, titanium tetra-sec-hexoxide, titanium tetra-n-heptoxide, titanium tetra-sec-heptoxide, titanium tetra-n-octoxide, titanium tetrakis(2-ethylhexyloxide), and so forth, and these compounds may be used as a pure substance or as a mixture. A ligand having 3 or more carbon atoms serves to reduce the amount of carboxylate formation, and one having 8 or less carbon atoms serves for an increased metal oxide content of the piezoelectric film precursor solution.

In the piezoelectric film precursor solution according to Embodiment 1, if such zirconium and titanium alkoxides are used, the ligand of at least one of the alkoxides has a branched structure, and it is preferable that the ligands of the zirconium and titanium alkoxides both have branched structures. This reduces the amount of carboxylate formation in the piezoelectric film precursor solution and thereby leads to reduced variations in thickness among the resulting piezoelectric films.

When a metal alkoxide is dissolved in a solvent carboxylic acid, ligand exchange reaction occurs and the carboxylic acid and the released alcohol are left in the solution. The carboxylic acid (A-COOH) and the alcohol (B-OH) then undergo the carboxylate (A-COO-B) formation reaction of Formula (1).

$$A\text{-}COOH + B\text{-}OH \leftrightarrow A\text{-}COO\text{-}B + H_2O \qquad (1)$$

The carboxylate tends to be more volatile than the constituent carboxylic acid and alcohol. If a precursor solution for piezoelectric films contains a free alcohol and the carboxylate formation reaction is let to progress over time, therefore, the film thickness achieved after the film-formation cycle will seriously vary from cycle to cycle.

When a carboxylic acid and an alcohol react with each other to form a carboxylate, the more carbon atoms the alcohol has, the smaller the amount of the carboxylate formed is. When linear and branched alcohols of the same number of carbon atoms are compared, the latter leads to a smaller amount of carboxylate formation. It is therefore preferable that titanium and zirconium alkoxides the ligand of each of which is an alcohol of 3 to 8 carbon atoms are used and that the ligand of at least one of the titanium and zirconium alkoxides has a branched structure.

The piezoelectric film precursor solution according to Embodiment 1 contains the carboxylic acid or acids in an amount in a range of 20% by mass to 60% by mass, both inclusive, of the total amount of the raw materials used for the preparation thereof. As demonstrated by the test results for some examples provided later, the carboxylic acid or acids prevent the hydrolysis due to the moisture in the air when contained in an amount of at least 20% by mass of the total amount of the raw materials, and the resulting piezoelectric film will have a sufficiently large thickness when the amount of the carboxylic acid or acids relative to the total amount of the raw materials is equal to or lower than 60% by mass.

The amount of the carboxylic acid or acids added can be adjusted within this range to satisfy the performance requirements for piezoelectric film precursor solutions (e.g., viscosity, the metal oxide content, waterproofness, and storage stability). The *metal oxide content* as used herein represents the total mass of the metal elements relative to the mass of the piezoelectric film precursor solution calculated on the assumption that the metal elements all exist in their oxide forms. This means that in the case of a PZT precursor solution, the metal oxide content is the total mass of PbO, $ZrO_2$, and $TiO_2$ relative to the total mass of the PZT precursor solution.

The metal oxide content can be calculated from the chemical formulae of the organic metal compounds used, and it can also be measured in the prepared piezoelectric film precursor solution by such analytical methods as gravimetry and ICP. For example, when a thin film is formed by spin coating, the viscosity of the piezoelectric film precursor solution can be in a range of 5 to 15 mPa·s, and the oxide-equivalent content of the metal sources contained in the precursor solution can be in a range of 12 to 32%.

Preferably, the solvent component of the piezoelectric film precursor solution according to Embodiment 1 contains one or more solvents selected from water, secondary or tertiary alcohols, ethers, esters, and ketones in addition to the carboxylic acid or acids. Replacing some portion of the carboxylic acid component, the carboxylate source, with one or more selected from water, secondary or tertiary alcohols, ethers, esters, and ketones serve to suppress the carboxylate formation reaction.

The secondary or tertiary alcohols that can be used for this purpose include, but are not particularly limited to, isopropyl alcohol, isobutyl alcohol, sec-butyl alcohol, tert-butyl alcohol, and isopentyl alcohol. The ethers that can be used for this purpose include, but are not particularly limited to, diisopropyl ether, di-n-butyl ether, ethylene glycol dimethyl ether, ethylene glycol diethyl ether, and ethylene glycol di-n-butyl ether.

The esters that can be used for this purpose include, but are not particularly limited to, methyl acetate, ethyl acetate, isopropyl acetate, n-butyl acetate, ethyl propionate, n-ethyl butyrate, and ethylene glycol diacetate. The compounds classified into both ethers and esters, including ethylene glycol monomethyl ether acetate, ethylene glycol monoethyl ether acetate, ethylene glycol mono-n-butyl ether (butyl Cellosolve), and propylene glycol monomethyl ether acetate, can also be used.

The ketones that can be used for this purpose include, but are not particularly limited to, dimethyl ketone (acetone), diethyl ketone, di-n-propyl ketone, diisopropyl ketone, methyl ethyl ketone, methyl n-propyl ketone, methyl isopropyl ketone, methyl n-butyl ketone, methyl isobutyl ketone, methyl tert-butyl ketone, methyl isopentyl ketone, ethyl n-propyl ketone, ethyl isopropyl ketone, and ethyl n-butyl ketone.

Incidentally, adding a polymeric component to a piezoelectric film precursor solution will serve to relax the stress generated as the piezoelectric film shrinks during the film-formation cycle. However, if the polymeric component is not degraded to water, carbon dioxide and other substances by decomposition/elimination and remains in the film as carbon residues or in other forms, it causes the formation of voids, reduced insulation properties, and other problems that affect the piezoelectric properties of the piezoelectric film. Any polymers contained in a piezoelectric film precursor solution should be thermally decomposable enough for the crystallized piezoelectric film to be free of them.

In Embodiment 1, the polymer or polymers contained in the piezoelectric film precursor solution are selected from polyethylene glycols, polyethylene glycol derivatives, polypropylene glycols, and polypropylene glycol derivatives, for these polymers have carbon-oxygen bonds. Carbon-oxygen bonds are weaker and thus are more likely to be broken by heat than carbon-carbon bonds. The use of a polymer or polymers having carbon-oxygen bonds therefore will lead to relaxation of the stress on the film generated as its shrinks, with a reduced adverse effect on the piezoelectric properties.

The polymeric component should have not only be sufficiently thermally decomposable but also have the effect of preventing the film from cracking, and thus it is desirable to specify an allowable range for its weight-average molecular weight. Too small a weight-average molecular weight of the polymeric component causes the polymer or polymers to behave like a low-molecular-weight compound or compounds and thus will lead to an insufficient stress relaxation effect in the formation cycle of the piezoelectric film. With too large a weight-average molecular weight, however, the polymer component is thermally decomposed only to an insufficient extent by the heat treatment operation in the film-formation cycle. As a result, some portion of the polymeric component remains in the film as carbon residues or in other forms and damages the insulation properties and other characteristics of the piezoelectric film.

In Embodiment 1, the weight-average molecular weight of the polymeric component is controlled to fall within a range of 300 to 800, and this ensures a sufficient stress relaxation effect and a satisfactory thermal decomposability of the polymeric component as demonstrated by the test results for some examples provided later. As a result, the produced piezoelectric film is unlikely to crack with a reduced loss of quality. The weight-average molecular weight used here is the value calculated from the molecular weight distribution determined by gel permeation chromatography (GPC) performed with polyethylene glycols as the calibration standards.

Additionally, it is preferable in Embodiment 1 that the oxide-equivalent content of the metal elements existing in the piezoelectric film precursor solution is in a range of 15% by mass to 27% by mass, both inclusive. As already known, the thickness of a film obtained by spin coating (a kind of liquid-phase technique) is determined by the spinning speed and the oxide-equivalent content of the metal elements involved. Controlling the oxide-equivalent content of the metal elements to fall within a range of 15% by mass to 27% by mass, both inclusive, ensures that the resulting piezoelectric film has a sufficiently large thickness when that kind of film-formation technique is used, as demonstrated by the test results for some examples provided later.

The following examples illustrate the piezoelectric film precursor solution according to Embodiment 1 in more detail. Examples 1-1 to 1-48 illustrate PZT films and PZT precursor solutions as examples of the piezoelectric films 72 and the precursor solution, respectively.

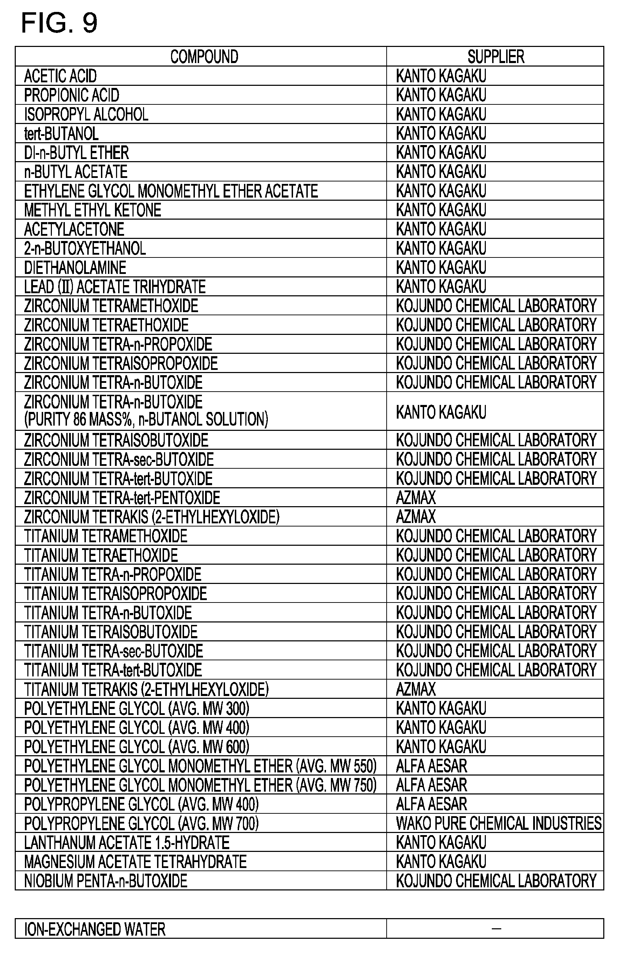

In the following examples and comparative examples, different piezoelectric film precursor solutions were used, but the application, drying, defatting, and sintering stages were carried out under the same conditions. The following paragraphs first describe the procedure for preparing the piezoelectric film precursor solution for each individual example or comparative example, and then the procedures common to the examples and comparative examples. Fig. 9 lists the raw materials used to prepare the piezoelectric film precursor solutions according to Embodiment 1. Note that these examples should not be construed as limiting the scope of the invention. Solution Preparation Stage

Example 1-1

In a 200-mL glass flask 43.0 g of acetic acid (the solvent component) was weighed. To this, 14.0 g of the n-butanol solution of zirconium tetra-n-butoxide (the zirconium source; concentration: 86.0% by mass) and 8.4 g of titanium tetraisopropoxide (the titanium source) were added. The obtained mixture was stirred with a magnetic stirrer at room temperature, or more specifically 25°C, for 30 minutes to yield a mixed solution. To this mixed solution 27.3 g of lead (II) acetate trihydrate (the lead source) and 6.8 g of polyethylene glycol (the polymeric component; weight-average molecular weight: 600) were added. The obtained mixture was heated and stirred in an oil bath at 80°C for 1 hour to complete the PZT precursor solution.

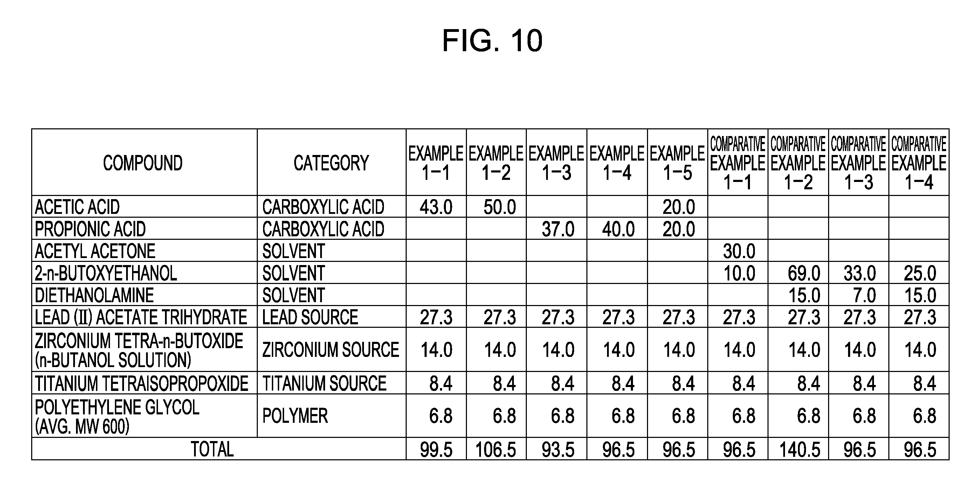

Fig. 10 presents the weight measurements of the solvent, the metal sources, and the polymer used in this example. The metal oxide content of the PZT precursor solution of this example (the content of the metal elements calculated on the assumption that the metal elements all existed in their oxide forms, i.e., lead oxide PbO, zirconium oxide $ZrO_2$, and titanium oxide $TiO_2$) was measured to be 22.4% by mass, and the raw-material-derived carboxylic acid content in the total amount of the raw materials was 43.2% by mass.

Example 1-2

The PZT precursor solution was obtained in the same way as in Example 1-1 except that the solvent component consisted of 50.0 g of acetic acid. The weight measurements of the solvent, the metal sources, and the polymer used in this example are also presented in Fig. 10. The metal oxide content and the raw-material-derived carboxylic acid content in the total amount of the raw materials calculated for this example in the same way as in Example 1-1 were 20.9% by mass and 46.9% by mass, respectively.

Example 1-3

The PZT precursor solution was obtained in the same way as in Example 1-1 except that the solvent component consisted of 37.0 g of propionic acid. The weight measurements of the solvent, the metal sources, and the polymer used in this example are also presented in Fig. 10. The metal oxide content and the raw-material-derived carboxylic acid content in the total amount of the raw materials calculated for this example in the same way as in Example 1-1 were 23.8% by mass and 39.6% by mass, respectively.

Example 1-4

The PZT precursor solution was obtained in the same way as in Example 1-1 except that the solvent component consisted of 40.0 g of propionic acid. The weight measurements of the solvent, the metal sources, and the polymer used in this example are also presented in Fig. 10. The metal oxide content and the raw-material-derived carboxylic acid content in the total amount of the raw materials calculated for this example in the same way as in Example 1-1 were 23.1 % by mass and 41.4% by mass, respectively.

Example 1-5

The PZT precursor solution was obtained in the same way as in Example 1-1 except that the solvent component consisted of 20.0 g of acetic acid and 20.0 g of propionic acid. The weight measurements of the solvents, the metal sources, and the polymer used in this example are also presented in Fig. 10. The metal oxide content and the raw-material-derived carboxylic acid content in the total amount of the raw materials calculated for this example in the same way as in Example 1-1 were 23.1% by mass and 41.4% by mass, respectively.

Comparative Example 1-1

The PZT precursor solution was obtained in the same way as in Example 1-1 except that the solvent component consisted of 30.0 g of acetyl acetone and 10.0 g of 2-n-butoxyethanol. The weight measurements of the solvents, the metal sources, and the polymer used in this comparative example are also presented in Fig. 10. The metal oxide content calculated for this comparative example in the same way as in Example 1-1 was 23.1% by mass.

Comparative Example 1-2

The PZT precursor solution was obtained in the same way as in Example 1-1 except that the solvent component consisted of 69.0 g of 2-n-butoxyethanol and 15.0 g of diethanolamine. The weight measurements of the solvents, the metal sources, and the polymer used in this comparative example are also presented in Fig. 10. The metal oxide content calculated for this comparative example in the same way as in Example 1-1 was 15.9% by mass.

Comparative Example 1-3

The PZT precursor solution was obtained in the same way as in Example 1-1 except that the solvent component consisted of 33.0 g of 2-n-butoxyethanol and 7.0 g of diethanolamine. The weight measurements of the solvents, the metal sources, and the polymer used in this comparative example are also presented in Fig. 10. The metal oxide content calculated for this comparative example in the same way as in Example 1-1 was 23.1% by mass.

Comparative Example 1-4

The PZT precursor solution was obtained in the same way as in Example 1-1 except that the solvent component consisted of 25.0 g of 2-n-butoxyethanol and 15.0 g of diethanolamine. The weight measurements of the solvents, the metal sources, and the polymer used in this comparative example are also presented in Fig. 10. The metal oxide content calculated for this comparative example in the same way as in Example 1-1 was 23.1% by mass.

Application Stage

The obtained PZT precursor solutions were applied to flow channel substrate wafers 110 like that illustrated in Fig. 4C. The following provides a more detailed description about the procedure at this stage. First, a silicon single crystal substrate measuring 150 mm in diameter and 700 $\mu$m in thickness was subjected to thermal oxidation until the thickness of the $SiO_2$ layer as the elastic film 50 reached 1.1 $\mu$m. Then, a $ZrO_2$ film was formed as the insulating film 55 by sputtering until a thickness of 0.4 $\mu$m was reached. After that, a laminate consisting of a Pt layer of 130 nm thick and an Ir layer of 20 nm thick was formed by sputtering as the lower electrode 60.

Prior to the formation of the lower electrode 60, a titanium layer having a thickness of 10 nm was formed as a contact layer. Furthermore, a titanium layer having a thickness of 5 nm was formed after the formation of the lower electrode 60. Then, the PZT precursor solutions of Examples 1-1 to 1-5 and Comparative Examples 1-1 to 1-4 were applied by spin coating at 25˚C and 40% RH. The conditions of spin coating were as follows: the volume of PZT precursor solution dropped, 4 mL; spinning speed, 2000 rpm; spinning time, 60 seconds. Note that each PZT solution was applied on the next day of preparation.

Drying Stage

After the application stage, each substrate wafer was heated on a hot plate at 140˚C for 5 minutes (the drying stage).

Defatting Stage

After the drying stage, the substrate wafer was heated on a hot plate at 400˚C for 5 minutes (the defatting stage).

Sintering Stage

After the defatting stage, the substrate wafer was put into an RTA apparatus and heated at 700˚C for 5 minutes under a stream of oxygen (the sintering stage).

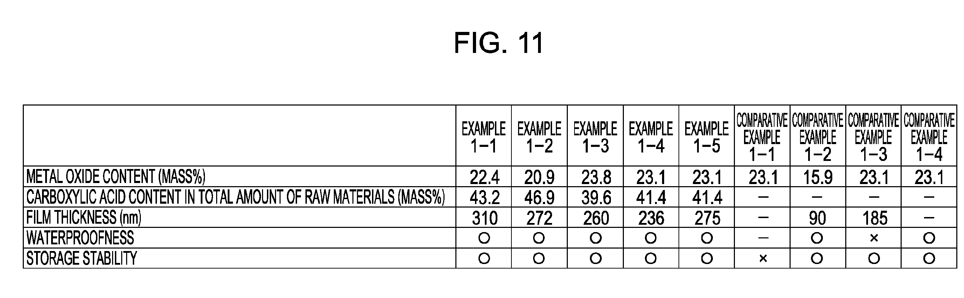

The obtained PZT films were analyzed in a scanning electron microscope (Hitachi S-4700) and the cross-sectional images were used to determine their thicknesses. For each example or comparative example, the thickness of the PZT film formed with the PZT precursor solution is presented in Fig. 11 along with the metal oxide content and the raw-material-derived carboxylic acid content in the total amount of the raw materials of the PZT precursor solution.

Waterproofness Test

The PZT precursor solutions of Examples 1-1 to 1-5 and Comparative Examples 1-1 to 1-4 were subjected to a waterproofness test. In the waterproofness test, ion-exchanged water was added to each PZT precursor solution, and the obtained mixture was rocked and observed for the formation of any precipitate. More specifically, 1.0 g of the PZT precursor solution was put into a glass bottle of 2.0 mL capacity with a cap, 0.5 g of ion-exchanged water was added, and then the bottle was rocked, and the waterproofness of the PZT precursor solution was evaluated in accordance with the following criteria: Pass (O)—No precipitate formed; Fail (×)—A precipitate formed. The obtained test results are summarized in Fig. 11.

Storage Stability Test

The PZT precursor solutions of Examples 1-1 to 1-5 and Comparative Examples 1-1 to 1-4 were then subjected to a storage stability test. In the storage stability test, each PZT precursor solution was stored at room temperature while being observed for the formation of any precipitate. More specifically, 70 g of the PZT precursor solution was put into a glass bottle of 100 mL capacity with a cap and tightly sealed, and the bottle was stored in a dark chemical cabinet for a month. The inside of the cabinet was at room temperature, or around 25˚C. The storage stability of the solution was then evaluated in accordance with the following criteria: Pass (O)—No precipitate formed; Fail (×)—A precipitate formed. The obtained test results are summarized in Fig. 11.

As is clear from the results presented in Fig. 11, the PZT precursor solutions of Examples 1-1 to 1-5 produced PZT films that had thicknesses over 200 nm after crystallization, and these PZT precursor solutions showed good waterproofness and storage stability.

In contrast, the PZT precursor solution of Comparative Example 1-1 formed a precipitate as early as on the next day of preparation and could not be applied. This is because acetyl acetone was present in too large an amount and affected the stability of the solution.

The PZT precursor solution of Comparative Example 1-2 was good in waterproofness and storage stability, but the thickness of the PZT film formed therewith was 90 nm.

The PZT precursor solution of Comparative Example 1-3 produced a relatively thick PZT film, but failed (x) the waterproofness test (a precipitate was formed). This is because the amount of diethanolamine was too small to produce a sufficient stabilizing effect.

The PZT precursor solution of Comparative Example 1-4 was good in waterproofness and storage stability, but the PZT film formed therewith was seriously uneven and could not be tested. Diethanolamine is a very viscous solvent, and the amount of 2-n-butoxyethanol added was small. As a result, the viscosity of the PZT precursor solution was so high that the coating could not be spread over the entire surface of the substrate.

Solution Preparation Stage

Example 1-6

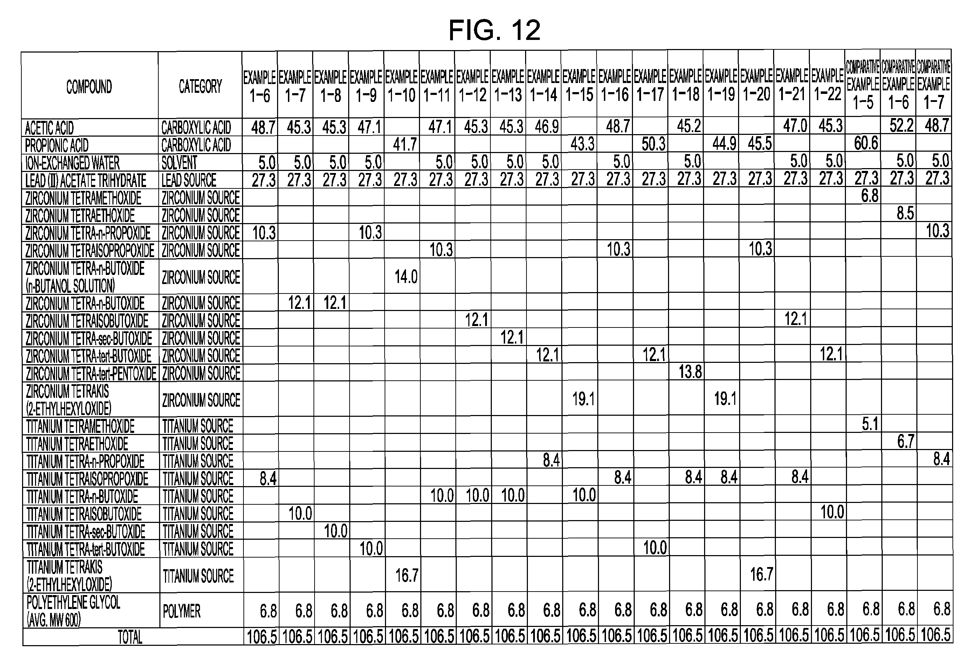

In a 200-mL glass flask 48.7 g of acetic acid (the solvent component) was weighed. To this, 10.3 g of zirconium tetra-n-propoxide (the zirconium source) and 8.4 g of titanium tetraisopropoxide (the titanium source) were added. The obtained mixture was stirred with a magnetic stirrer at room temperature, or more specifically 25˚C, for 30 minutes to yield a mixed solution. To this mixed solution 27.3 g of lead (II) acetate trihydrate (the lead source), 6.8 g of a polyethylene glycol with a weight-average molecular weight of 600 (the polymeric component), and 5.0 g of ion-exchanged water as an additional solvent were added. The obtained mixture was stirred at room temperature, 25˚C, for 1 hour to complete the PZT precursor solution. Fig. 12 presents the weight measurements of the solvents, the metal sources, and the polymer used in this example. The metal oxide content and the raw-material-derived carboxylic acid content in the total amount of the raw materials calculated for this example in the same way as in Example 1-1 were 20.9% by mass and 45.8% by mass, respectively.

Example 1-7

The PZT precursor solution was obtained in the same way as in Example 1-6 except that the solvent component consisted of 45.3 g of acetic acid, the zirconium source was 12.1 g of zirconium tetra-n-butoxide, and the titanium source was 10.0 g of titanium tetraisobutoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 42.5% by mass, respectively.

Example 1-8

The PZT precursor solution was obtained in the same way as in Example 1-6 except that the solvent component consisted of 45.3 g of acetic acid, the zirconium source was 12.1 g of zirconium tetra-n-butoxide, and the titanium source was 10.0 g of titanium tetra-sec-butoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 42.5% by mass, respectively.

Example 1-9

The PZT precursor solution was obtained in the same way as in Example 1-6 except that the solvent component consisted of 47.1 g of acetic acid and the titanium source was 10.0 g of titanium tetra-tert-butoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 44.2% by mass, respectively.

Example 1-10

The PZT precursor solution was obtained in the same way as in Example 1-1 except that the solvent component consisted of 41.7 g of propionic acid and the titanium source was 16.7 g of titanium tetrakis(2-ethylhexyloxide). The weight measurements of the solvent, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 39.2% by mass, respectively.

Example 1-11

The PZT precursor solution was obtained in the same way as in Example 1-6 except that the solvent component consisted of 47.1 g of acetic acid, the zirconium source was 10.3 g of zirconium tetraisopropoxide, and the titanium source was 10.0 g of titanium tetra-n-butoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 44.2% by mass, respectively.

Example 1-12

The PZT precursor solution was obtained in the same way as in Example 1-6 except that the solvent component consisted of 45.3 g of acetic acid, the zirconium source was 12.1 g of zirconium tetraisobutoxide, and the titanium source was 10.0 g of titanium tetra-n-butoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 42.5% by mass, respectively.

Example 1-13

The PZT precursor solution was obtained in the same way as in Example 1-6 except that the solvent component consisted of 45.3 g of acetic acid, the zirconium source was 12.1 g of zirconium tetra-sec-butoxide, and the titanium source was 10.0 g of titanium tetra-n-butoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 42.5% by mass, respectively.

Example 1-14

The PZT precursor solution was obtained in the same way as in Example 1-6 except that the solvent component consisted of 46.9 g of acetic acid, the zirconium source was 12.1 g of zirconium tetra-tert-butoxide, and the titanium source was 8.4 g of titanium tetra-n-propoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 49.2% by mass, respectively.

Example 1-15

The PZT precursor solution was obtained in the same way as in Example 1-1 except that the solvent component consisted of 43.3 g of propionic acid, the zirconium source was 19.1 g of zirconium tetrakis(2-ethylhexyloxide), and the titanium source was 10.0 g of titanium tetra-n-butoxide. The weight measurements of the solvent, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 40.6% by mass, respectively.

Example 1-16

The PZT precursor solution was obtained in the same way as in Example 1-6 except that the solvent component consisted of 48.7 g of acetic acid and the zirconium source was 10.3 g of zirconium tetraisopropoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 45.8% by mass, respectively.

Example 1-17

The PZT precursor solution was obtained in the same way as in Example 1-1 except that the solvent component consisted of 50.3 g of propionic acid, the zirconium source was 12.1 g of zirconium tetra-tert-butoxide, and the titanium source was 10.0 g of titanium tetra-tert-butoxide. The weight measurements of the solvent, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 47.2% by mass, respectively.

Example 1-18

The PZT precursor solution was obtained in the same way as in Example 1-6 except that the solvent component consisted of 45.2 g of acetic acid and the zirconium source was 13.8 g of zirconium tetra-tert-pentoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 42.4% by mass, respectively.

Example 1-19

The PZT precursor solution was obtained in the same way as in Example 1-1 except that the solvent component consisted of 44.9 g of propionic acid and the zirconium source was 19.1 g of zirconium tetrakis(2-ethylhexyloxide). The weight measurements of the solvent, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 42.2% by mass, respectively.

Example 1-20

The PZT precursor solution was obtained in the same way as in Example 1-1 except that the solvent component consisted of 45.5 g of propionic acid, the zirconium source was 10.3 g of zirconium tetraisopropoxide, and the titanium source was 16.7 g of titanium tetrakis(2-ethylhexyloxide). The weight measurements of the solvent, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 42.7% by mass, respectively.

Example 1-21

The PZT precursor solution was obtained in the same way as in Example 1-6 except that the solvent component consisted of 47.0 g of acetic acid and the zirconium source was 12.1 g of zirconium tetraisobutoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 44.1% by mass, respectively.

Example 1-22

The PZT precursor solution was obtained in the same way as in Example 1-6 except that the solvent component consisted of 45.3 g of acetic acid, the zirconium source was 12.1 g of zirconium tetra-tert-butoxide, and the titanium source was 10.0 g of titanium tetraisopropoxide. The weight measurements of the solvents, the metal sources, and the polymer used in this example are also presented in Fig. 12. The metal oxide content and the raw-material-derived carboxylic acid content in the total amount of the raw materials calculated for this example in the same way as in Example 1-1 were 20.9% by mass and 42.5% by mass, respectively.

Comparative Example 1-5

The PZT precursor solution was obtained in the same way as in Example 1-1 except that the solvent component consisted of 60.6 g of propionic acid, the zirconium source was 6.8 g of zirconium tetramethoxide, and the titanium source was 5.1 g of titanium tetramethoxide. The weight measurements of the solvent, the metal sources, and the polymer used in this comparative example are also presented in Fig. 12. The metal oxide content and the raw-material-derived carboxylic acid content in the total amount of the raw materials calculated for this comparative example in the same way as in Example 1-1 were 20.9% by mass and 56.9% by mass, respectively. Comparative Example 1-6

The PZT precursor solution was obtained in the same way as in Example 1-6 except that the solvent component consisted of 52.2 g of acetic acid, the zirconium source was 8.5 g of zirconium tetraethoxide, and the titanium source was 6.7 g of titanium tetraethoxide. The weight measurements of the solvents, the metal sources, and the polymer used in this comparative example are also presented in Fig. 12. The metal oxide content and the raw-material-derived carboxylic acid content in the total amount of the raw materials calculated for this comparative example in the same way as in Example 1-1 were 20.9% by mass and 49.0% by mass, respectively. Comparative Example 1-7

The PZT precursor solution was obtained in the same way as in Example 1-6 except that the solvent component consisted of 48.7 g of acetic acid and the titanium source was 8.4 g of titanium tetra-n-propoxide. The weight measurements of the solvents, the metal sources, and the polymer used in this comparative example are also presented in Fig. 12. The metal oxide content and the raw-material-derived carboxylic acid content in the total amount of the raw materials calculated for this comparative example in the same way as in Example 1-1 were 20.9% by mass and 45.8% by mass, respectively.

Film-Formation Cycle

The PZT precursor solutions of Examples 1-6 to 1-22 and Comparative Examples 1-5 to 1-7 were used to form PZT films. More specifically, each PZT precursor solution was used on the next day and 30 days after preparation to form a PZT film by the same film-formation cycle (the application, drying, defatting, and sintering stages) as that used for Example 1-1; two PZT films were formed for each example or comparative example. Before each time of use, the PZT precursor solution was put into a glass bottle with a cap and stored in a dark place at room temperature, or at around 25˚C.

Consistency Test

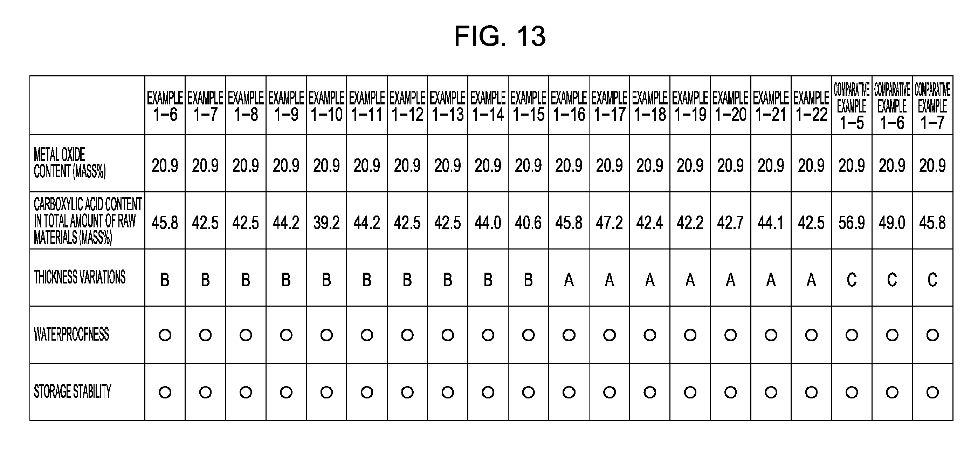

The PZT film parings obtained using the PZT precursor solutions of Examples 1-6 to 1-22 and Comparative Examples 1-5 to 1-7 were analyzed in a scanning electron microscope (Hitachi S-4700) and the cross-sectional images were used to determine their thicknesses. The thickness of the PZT film formed with the PZT precursor solution stored for 30 days was normalized against that of the PZT film formed on the next day after the PZT precursor solution was prepared, with the latter as 100, and the film thickness consistency of the PZT precursor solution was evaluated in accordance with the criteria presented below. The test results for Examples 1-6 to 1-22 and Comparative Examples 1-5 to 1-7 are summarized in Fig. 13.

A: The thickness of the PZT film obtained using the PZT precursor solution stored for 30 days was in a range of ≥100 to <110;
B: The thickness of the PZT film obtained using the PZT precursor solution stored for 30 days was in a range of ≥110 to <120;
C: The thickness of the PZT film obtained using the PZT precursor solution stored for 30 days was ≥120.

Waterproofness Test

The PZT precursor solutions of Examples 1-6 to 1-22 and Comparative Examples 1-5 to 1-7 were tested for waterproofness in the same way and in accordance with the same criteria as those used for Example 1-1. The obtained test results are summarized in Fig. 13.

Storage Stability Test

The PZT precursor solutions of Examples 1-6 to 1-22 and Comparative Examples 1-5 to 1-7 were then tested for storage stability in the same way and in accordance with the same criteria as those used for Example 1-1. The obtained test results are summarized in Fig. 13.
As is clear from the results presented in Fig. 13, the precursor solutions in which the ligand of the zirconium alkoxide and that of the titanium alkoxide were both linear chains of 1 to 3 carbon atoms all received a grade C in film thickness consistency (Comparative Examples 1-5 to 1-7).
Compared with Comparative Examples 1-5 to 1-7, Examples 1-6 to 1-15 all got a grade B in film thickness consistency. This is because either the ligand of the zirconium alkoxide or that of the titanium alkoxide was a branched chain and this led to a reduced amount of carboxylate formation. Furthermore, Examples 1-16 to 1-22 achieved a grade A in film thickness consistency. In these examples the ligands of the zirconium and titanium alkoxides were both branched chains, and thus the effect of reducing the amount of carboxylate formation was more potent than in Examples 1-6 to 1-15.
Additionally, the alcohol content and the carboxylate content of each PZT precursor solution were briefly determined by $^1$H- and $^{13}$C-NMR. The obtained results showed that for all of the PZT precursor solutions prepared in Examples 1-6 to 1-22 and Comparative Examples 1-5 to 1-7, the carboxylate increased over time during the period from Days 1 to 30 after preparation, and the film thickness consistency correlated with the percent ester formation.
For example, in the PZT precursor solution of Comparative Example 1-5, the percent ester formation determined from the peak intensities of methyl acetate and methanol was 36 mol% on Day 1 and 81 mol% on Day 30. The percent ester formation as used herein was calculated as the following formula: 100 x [Carboxylate] /([Carboxylate] + [Alcohol]).
As for the examples, the percent ester formation in the precursor solution of Example 1-16 was 6 mol% on Day 1 and 10 mol% on Day 30, and that in the solution of Example 1-6 was 27 mol% on Day 1 and 48 mol% on Day 30.

Solution Preparation Stage

Example 1-23

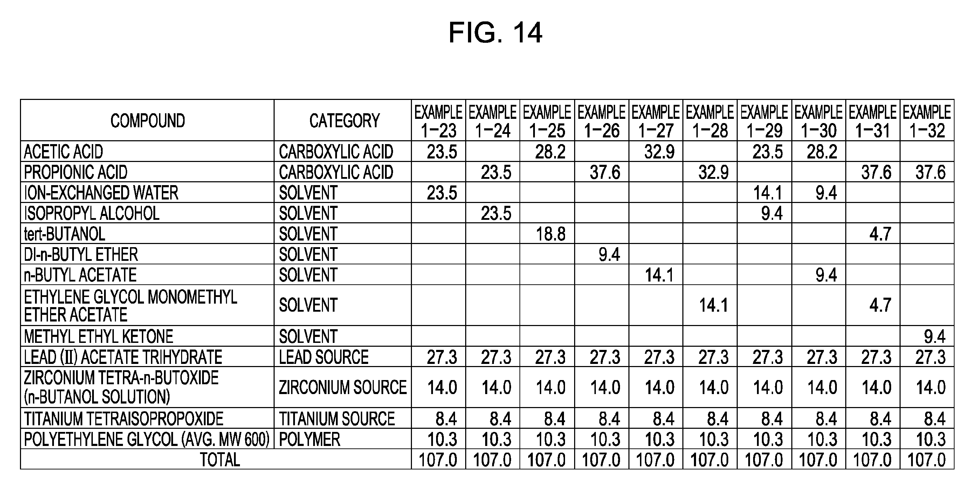

The PZT precursor solution was obtained in the same way as in Example 1-6 except that the solvent component consisted of 23.5 g of acetic acid, the zirconium source was 14.0 g of the n-butanol solution of zirconium tetra-n-butoxide, the polymeric component consisted of 10.3 g of a polyethylene glycol with a weight-average molecular weight of 600, and the additional solvent was 23.5 g of ion-exchanged water. The weight measurements of the solvents, the metal sources, and the polymer used in this example are presented in Fig. 14. The metal oxide content and the raw-material-derived carboxylic acid content in the total amount of the raw materials calculated for this example in the same way as in Example 1-1 were 20.8% by mass and 22.0% by mass, respectively.

Example 1-24

The PZT precursor solution was obtained in the same way as in Example 1-1 except that the solvent component consisted of 23.5 g of propionic acid and 23.5 g of isopropyl alcohol and the polymeric component consisted of 10.3 g of a polyethylene glycol with a weight-average molecular weight of 600. The weight measurements of the solvents, the metal sources, and the polymer used in this example are also presented in Fig. 14. The metal oxide content and the raw-material-derived carboxylic acid content in the total amount of the raw materials calculated for this example in the same way as in Example 1-1 were 20.8% by mass and 22.0% by mass, respectively.

Example 1-25

The PZT precursor solution was obtained in the same way as in Example 1-1 except that the solvent component consisted of 28.2 g of acetic acid and 18.8 g of tert-butanol and the polymeric component consisted of 10.3 g of a polyethylene glycol with a weight-average molecular weight of 600. The weight measurements of the solvents, the metal sources, and the polymer used in this example are also presented in Fig. 14. The metal oxide content and the raw-material-derived carboxylic acid content in the total amount of the raw materials calculated for this example in the same way as in Example 1-1 were 20.8% by mass and 26.4% by mass, respectively.

Example 1-26

The PZT precursor solution was obtained in the same way as in Example 1-1 except that the solvent component consisted of 37.6 g of propionic acid and 9.4 g of di-n-butyl ether and the polymeric component consisted of 10.3 g of a polyethylene glycol with a weight-average molecular weight of 600. The weight measurements of the solvents, the metal sources, and the polymer used in this example are also presented in Fig. 14. The metal oxide content and the raw-material-derived carboxylic acid content in the total amount of the raw materials calculated for this example in the same way as in Example 1-1 were 20.8% by mass and 35.2% by mass, respectively.

Example 1-27

The PZT precursor solution was obtained in the same way as in Example 1-1 except that the solvent component consisted of 32.9 g of acetic acid and 14.1 g of n-butyl acetate and the polymeric component consisted of 10.3 g of a polyethylene glycol with a weight-average molecular weight of 600. The weight measurements of the solvents, the metal sources, and the polymer used in this example are also presented in Fig. 14. The metal oxide content and the raw-material-derived carboxylic acid content in the total amount of the raw materials calculated for this example in the same way as in Example 1-1 were 20.8% by mass and 30.8% by mass, respectively.

Example 1-28

The PZT precursor solution was obtained in the same way as in Example 1-1 except that the solvent component consisted of 32.9 g of propionic acid and 14.1 g of ethylene glycol monomethyl ether acetate and the polymeric component consisted of 10.3 g of a polyethylene glycol with a weight-average molecular weight of 600. The weight measurements of the solvents, the metal sources, and the polymer used in this example are also presented in Fig. 14. The metal oxide content and the raw-material-derived carboxylic acid content in the total amount of the raw materials calculated for this example in the same way as in Example 1-1 were 20.8% by mass and 30.8% by mass, respectively.

Example 1-29

The PZT precursor solution was obtained in the same way as in Example 1-6 except that the solvent component consisted of 23.5 g of propionic acid and 9.4 g of isopropyl alcohol, the zirconium source was 14.0 g of the n-butanol solution of zirconium tetra-n-butoxide, the polymeric component consisted of 10.3 g of a polyethylene glycol with a weight-average molecular weight of 600, and 14.1 g of ion-exchanged water was used as an additional solvent. The weight measurements of the solvents, the metal sources, and the polymer used in this example are also presented in Fig. 14. The metal oxide content and the raw-material-derived carboxylic acid content in the total amount of the raw materials calculated for this example in the same way as in Example 1-1 were 20.8% by mass and 22.0% by mass, respectively.

Example 1-30

The PZT precursor solution was obtained in the same way as in Example 1-6 except that the solvent component consisted of 28.2 g of acetic acid and 9.4 g of n-butyl acetate, the zirconium source was 14.0 g of the n-butanol solution of zirconium tetra-n-butoxide, the polymeric component consisted of 10.3 g of a polyethylene glycol with a weight-average molecular weight of 600, and 9.4 g of ion-exchanged water was used as an additional solvent. The weight measurements of the solvents, the metal sources, and the polymer used in this example are also presented in Fig. 14. The metal oxide content and the raw-material-derived carboxylic acid content in the total amount of the raw materials calculated for this example in the same way as in Example 1-1 were 20.8% by mass and 26.4% by mass, respectively.

Example 1-31

The PZT precursor solution was obtained in the same way as in Example 1-1 except that the solvent component consisted of 37.6 g of propionic acid, 4.7 g of tert-butanol, and 4.7 g of ethylene glycol monomethyl ether acetate and the polymeric component consisted of 10.3 g of a polyethylene glycol with a weight-average molecular weight of 600. The weight measurements of the solvents, the metal sources, and the polymer used in this example are also presented in Fig. 14. The metal oxide content and the raw-material-derived carboxylic acid content in the total amount of the raw materials calculated for this example in the same way as in Example 1-1 were 20.8% by mass and 35.2% by mass, respectively.

Example 1-32

The PZT precursor solution was obtained in the same way as in Example 1-1 except that the solvent component consisted of 37.6 g of propionic acid and 9.4 g of methyl ethyl ketone and the polymeric component consisted of 10.3 g of a polyethylene glycol with a weight-average molecular weight of 600. The weight measurements of the solvents, the metal sources, and the polymer used in this example are also presented in Fig. 14. The metal oxide content and the raw-material-derived carboxylic acid content in the total amount of the raw materials calculated for this example in the same way as in Example 1-1 were 20.8% by mass and 35.2% by mass, respectively.

Film-Formation Cycle

The PZT precursor solutions of Examples 1-23 to 1-32 were used to form PZT films. More specifically, each PZT precursor solution was used on the next day and 30 days after preparation to form a PZT film by the same film-formation cycle (the application, drying, defatting, and sintering stages) as that used for Example 1-1; two PZT films were formed for each example. Before each time of use, the PZT solution was put into a glass bottle with a cap and stored in a dark place at room temperature, or at around 25˚C.

Consistency Test

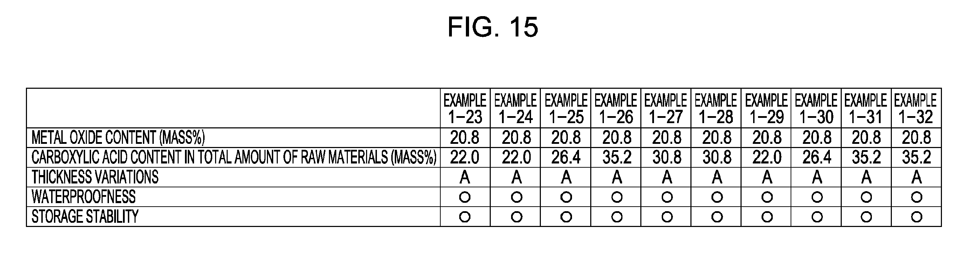

The PZT film parings obtained using the PZT precursor solutions of Examples 1-23 to 1-32 were analyzed in a scanning electron microscope (Hitachi S-4700) and the cross-sectional images were used to determine their thicknesses. The thickness of the PZT film formed with the precursor solution stored for 30 days was normalized against that of the PZT film formed on the next day after the PZT precursor solution was prepared, with the latter as 100, and the film thickness consistency of the PZT precursor solution was evaluated in accordance with the criteria presented below. The test results for Examples 1-23 to 1-32 are summarized in Fig. 15.

A: The thickness of the PZT film obtained using the PZT precursor solution stored for 30 days was in a range of ≥100 to <110;
B: The thickness of the PZT film obtained using the PZT precursor solution stored for 30 days was in a range of ≥110 to <120;
C: The thickness of the PZT film obtained using the PZT precursor solution stored for 30 days was ≥120.

Waterproofness Test

The PZT precursor solutions of Examples 1-23 to 1-32 were tested for waterproofness in the same way and in accordance with the same criteria as those used for Example 1-1. The obtained test results are summarized in Fig. 15.

Storage Stability Test

The PZT precursor solutions of Examples 1-23 to 1-32 were then tested for storage stability in the same way and in accordance with the same criteria as those used for Example 1-1. The obtained test results are summarized in Fig. 15.

As can be seen from the results presented in Fig. 15, the PZT precursor solutions of Examples 1-23 to 1-32 all received a grade A in film thickness consistency. This is because these precursor solutions contained water, a secondary or tertiary alcohol, an ether, an ester, or a ketone to replace some portion of the carboxylic acid component thereof, the carboxylate source, and thus the carboxylate formation reaction was suppressed.

Solution Preparation Stage

Example 1-33

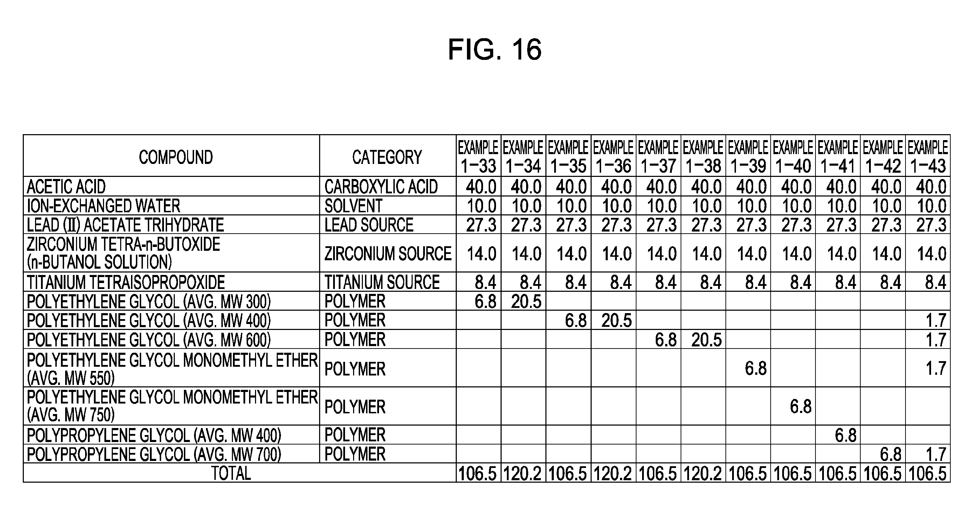

In a 200-mL glass flask 40.0 g of acetic acid (the solvent component) was weighed. To this, 14.0 g of the n-butanol solution of zirconium tetra-n-butoxide (the zirconium source) and 8.4 g of titanium tetraisopropoxide (the titanium source) were added. The obtained mixture was stirred with a magnetic stirrer at room temperature, or more specifically 25˚C, for 30 minutes to yield a mixed solution. To this mixed solution 27.3 g of lead (II) acetate trihydrate (the lead source), 6.8 g of polyethylene glycol (the polymeric component; weight-average molecular weight: 300), and 10.0 g of ion-exchanged water as an additional solvent were added. The obtained mixture was heated and stirred in an oil bath at 80˚C for 1 hour to complete the PZT precursor solution. Fig. 16 presents the weight measurements of the solvents, the metal sources, and the polymer used in this example. The metal oxide content and the raw-material-derived carboxylic acid content in the total amount of the raw materials calculated for this example in the same way as in Example 1-1 were 20.9% by mass and 37.5% by mass, respectively.

Example 1-34

The PZT precursor solution was obtained in the same way as in Example 1-33 except that the polymeric component consisted of 20.5 g of a polyethylene glycol with a weight-average molecular weight of 300. The weight measurements of the solvents, the metal sources, and the polymer used in this example are also presented in Fig. 16. The metal oxide content and the raw-material-derived carboxylic acid content in the total amount of the raw materials calculated for this example in the same way as in Example 1-1 were 18.5% by mass and 33.3% by mass, respectively.

Example 1-35

The PZT precursor solution was obtained in the same way as in Example 1-33 except that the polymeric component consisted of 6.8 g of a polyethylene glycol with a weight-average molecular weight of 400. The weight measurements of the solvents, the metal sources, and the polymer used in this example are also presented in Fig. 16. The metal oxide content and the raw-material-derived carboxylic acid content in the total amount of the raw materials calculated for this example in the same way as in Example 1-1 were 20.9% by mass and 37.5% by mass, respectively.

Example 1-36

The PZT precursor solution was obtained in the same way as in Example 1-33 except that the polymeric component consisted of 20.5 g of a polyethylene glycol with a weight-average molecular weight of 400. The weight measurements of the solvents, the metal sources, and the polymer used in this example are also presented in Fig. 16. The metal oxide content and the raw-material-derived carboxylic acid content in the total amount of the raw materials calculated for this example in the same way as in Example 1-1 were 18.5% by mass and 33.3% by mass, respectively.

Example 1-37

The PZT precursor solution was obtained in the same way as in Example 1-33 except that the polymeric component consisted of 6.8 g of a polyethylene glycol with a weight-average molecular weight of 600. The weight measurements of the solvents, the metal sources, and the polymer used in this example are also presented in Fig. 16. The metal oxide content and the raw-material-derived carboxylic acid content in the total amount of the raw materials calculated for this example in the same way as in Example 1-1 were 20.9% by mass and 37.5% by mass, respectively.

Example 1-38

The PZT precursor solution was obtained in the same way as in Example 1-33 except that the polymeric component consisted of 20.5 g of a polyethylene glycol with a weight-average molecular weight of 600. The weight measurements of the solvents, the metal sources, and the polymer used in this example are also presented in Fig. 16. The metal oxide content and the raw-material-derived carboxylic acid content in the total amount of the raw materials calculated for this example in the same way as in Example 1-1 were 18.5% by mass and 33.3% by mass, respectively.

Example 1-39

The PZT precursor solution was obtained in the same way as in Example 1-33 except that the polymeric component consisted of 6.8 g of a polyethylene glycol monomethyl ether with a weight-average molecular weight of 550. The weight measurements of the solvents, the metal sources, and the polymer used in this example are also presented in Fig. 16. The metal oxide content and the raw-material-derived carboxylic acid content in the total amount of the raw materials calculated for this example in the same way as in Example 1-1 were 20.9% by mass and 37.5% by mass, respectively.

Example 1-40

The PZT precursor solution was obtained in the same way as in Example 1-33 except that the polymeric component consisted of 6.8 g of a polyethylene glycol monomethyl ether with a weight-average molecular weight of 750. The weight measurements of the solvents, the metal sources, and the polymer used in this example are also presented in Fig. 16. The metal oxide content and the raw-material-derived carboxylic acid content in the total amount of the raw materials calculated for this example in the same way as in Example 1-1 were 20.9% by mass and 37.5% by mass, respectively.

Example 1-41

The PZT precursor solution was obtained in the same way as in Example 1-33 except that the polymeric component consisted of 6.8 g of a polypropylene glycol with a weight-average molecular weight of 400. The weight measurements of the solvents, the metal sources, and the polymer used in this example are also presented in Fig. 16. The metal oxide content and the raw-material-derived carboxylic acid content in the total amount of the raw materials calculated for this example in the same way as in Example 1-1 were 20.9% by mass and 37.5% by mass, respectively.

Example 1-42

The PZT precursor solution was obtained in the same way as in Example 1-33 except that the polymeric component consisted of 6.8 g of a polypropylene glycol with a weight-average molecular weight of 700. The weight measurements of the solvents, the metal sources, and the polymer used in this example are also presented in Fig. 16. The metal oxide content and the raw-material-derived carboxylic acid content in the total amount of the raw materials calculated for this example in the same way as in Example 1-1 were 20.9% by mass and 37.5% by mass, respectively.

Example 1-43

The PZT precursor solution was obtained in the same way as in Example 1-33 except that the polymeric component consisted of 1.7 g of a polyethylene glycol with a weight-average molecular weight of 400, 1.7 g of a polyethylene glycol with a weight-average molecular weight of 600, 1.7 g of a polyethylene glycol monomethyl ether with a weight-average molecular weight of 550, and 1.7 g of a polypropylene glycol with a weight-average molecular weight of 700. The weight measurements of the solvents, the metal sources, and the polymers used in this example are also presented in Fig. 16. The metal oxide content and the raw-material-derived carboxylic acid content in the total amount of the raw materials calculated for this example in the same way as in Example 1-1 were 20.9% by mass and 37.5% by mass, respectively. Film-Formation Cycle

The PZT precursor solutions of Examples 1-33 to 1-43 were used to form PZT films. More specifically, each PZT precursor solution was used on the next day of preparation to form a laminate consisting of six PZT films. To do this, the same film-formation cycle (the application, drying, defatting, and sintering stages) as that used for Example 1-1 was repeated six times with the PZT precursor solution. Before the time of use, the PZT precursor solution was put into a glass bottle with a cap and stored in a dark place at room temperature, or at around 25°C.

Crack Resistance Test

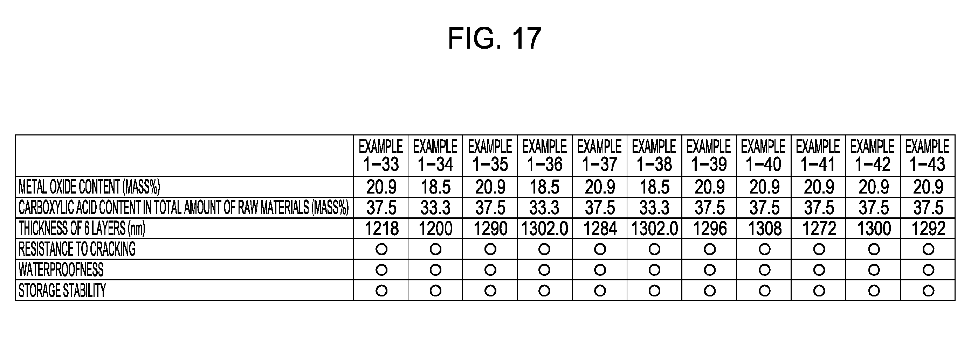

The laminates of PZT films formed with the PZT precursor solutions of Examples 1-33 to 1-43 were observed under a metallographic microscope for any cracks, and the resistance of each laminate to cracking was evaluated in accordance with the following criteria: Pass (O)—No cracks found; Fail (×)—Any cracks found. The laminates were then analyzed in a scanning electron microscope (Hitachi S-4700) and the cross-sectional images were used to determine their thicknesses. The obtained results are summarized in Fig. 17.

Waterproofness Test

The PZT precursor solutions of Examples 1-33 to 1-43 were tested for waterproofness in the same way and in accordance with the same criteria as those used for Example 1-1. The obtained test results are summarized in Fig. 17.

Storage Stability Test

The PZT precursor solutions of Examples 1-33 to 1-43 were then tested for storage stability in the same way and in accordance with the same criteria as those used for Example 1-1. The obtained test results are summarized in Fig. 17.

As demonstrated by the results presented in Fig. 17, the PZT precursor solutions of Examples 1-33 to 1-43 were all capable of producing a laminate of PZT films with a total thickness of over 1 μm with no cracks found in it. Furthermore, all of these PZT precursor solutions passed both the waterproofness test and the storage stability test.

Solution Preparation Stage

Example 1-44

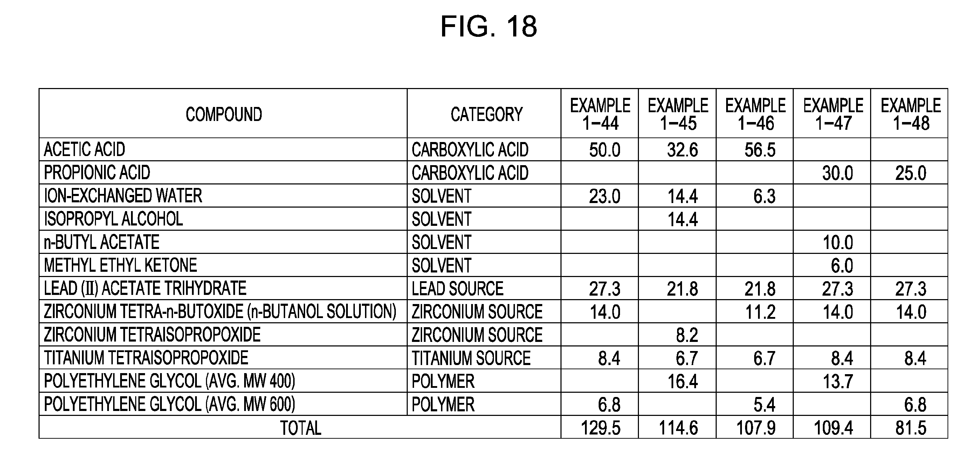

The PZT precursor solution was obtained in the same way as in Example 1-33 except that the solvent component consisted of 50.0 g of acetic acid, the additional solvent was 23.0 g of ion-exchanged water, and the polymeric component consisted of 6.8 g of a polyethylene glycol with a weight-average molecular weight of 600. The weight measurements of the solvents, the metal sources, and the polymer used in this example are presented in Fig. 18. The metal oxide content and the raw-material-derived carboxylic acid content in the total amount of the raw materials calculated for this example in the same way as in Example 1-1 were 17.2% by mass and 38.6% by mass, respectively.

Example 1-45

The PZT precursor solution was obtained in the same way as in Example 1-33 except that the solvent component consisted of 32.6 g of acetic acid and 14.4 g of isopropyl alcohol, the lead source was 21.8 g of lead (II) acetate trihydrate, the zirconium source was 8.2 g of zirconium tetraisopropoxide, the titanium source was 6.7 g of titanium tetraisopropoxide, the polymeric component consisted of 16.4 g of a polyethylene glycol with a weight-average molecular weight of 400, and the additional solvent was 14.4 g of ion-exchanged water. The weight measurements of the solvents, the metal sources, and the polymer used in this example are also presented in Fig. 18. The metal oxide content and the raw-material-derived carboxylic acid content in the total amount of the raw materials calculated for this example in the same way as in Example 1-1 were 15.6% by mass and 28.4% by mass, respectively.

Example 1-46

The PZT precursor solution was obtained in the same way as in Example 1-33 except that the solvent component consisted of 56.5 g of acetic acid, the lead source was 21.8 g of lead (II) acetate trihydrate, the zirconium source was 11.2 g of the n-butanol solution of zirconium tetra-n-butoxide, the titanium source was 6.7 g of titanium tetraisopropoxide, the polymeric component consisted of 5.4 g of a polyethylene glycol with a weight-average molecular weight of 600, and the additional solvent was 6.3 g of ion-exchanged water. The weight measurements of the solvents, the metal sources, and the polymer used in this example are also presented in Fig. 18. The metal oxide content and the raw-material-derived carboxylic acid content in the total amount of the raw materials calculated for this example in the same way as in Example 1-1 were 16.5% by mass and 52.4% by mass, respectively.

Example 1-47

The PZT precursor solution was obtained in the same way as in Example 1-1 except that the solvent component consisted of 30.0 g of propionic acid, 10.0 g of n-butyl acetate, and 6.0 g of methyl ethyl ketone and the polymeric component consisted of 13.7 g of a polyethylene glycol with a weight-average molecular weight of 400. The weight measurements of the solvents, the metal sources, and the polymer used in this example are also presented in Fig. 18. The metal oxide content and the raw-material-derived carboxylic acid content in the total amount of the raw materials calculated for this example in the same way as in Example 1-1 were 20.4% by mass and 27.4% by mass, respectively.

Example 1-48

The PZT precursor solution was obtained in the same way as in Example 1-1 except that the solvent component consisted of 25.0 g of propionic acid. The weight measurements of the solvent, the metal sources, and the polymer used in this example are also presented in Fig. 18. The metal oxide content and the raw-material-derived carboxylic acid content in the total amount of the raw materials calculated for this example in the same way as in Example 1-1 were 26.1% by mass and 30.7% by mass, respectively.

Film-Formation Cycle

The PZT precursor solutions of Examples 1-44 to 1-48 and Comparative Example 1-2 were used to form PZT films. More specifically, each PZT precursor solution was used on the next day of preparation to form PZT films by the same film-formation cycle (the application, drying, defatting, and sintering stages) as that used for Example 1-1 except that different spinning speeds were used. Before the time of use, the PZT precursor solution was put into a glass bottle with a cap and stored in a dark place at room temperature, or at around 25°C.

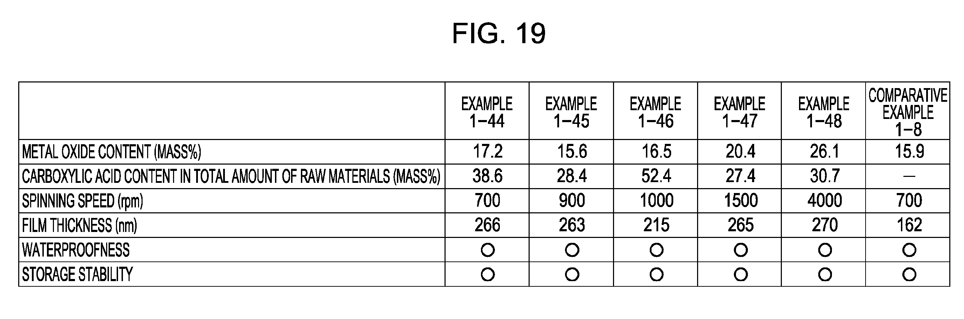

The obtained PZT films were analyzed in a scanning electron microscope (Hitachi S-4700) and the cross-sectional images were used to determine their thicknesses. The thicknesses of the PZT films formed with the PZT precursor solutions of these examples and comparative example are summarized in Fig. 19. Waterproofness Test

The PZT precursor solutions of Examples 1-44 to 1-48 were tested for waterproofness in the same way and in accordance with the same criteria as those used for Example 1-1. The obtained test results are summarized in Fig. 19.

Storage Stability Test

The PZT precursor solutions of Examples 1-44 to 1-48 were then tested for storage stability in the same way and in accordance with the same criteria as those used for Example 1-1. The obtained test results are summarized in Fig. 19.

As is obvious from Fig. 19, the precursor solutions of Examples 1-44 to 1-48 each produced a PZT film with a thickness of over 200 $\mu$m when applied at an appropriate spinning speed. On the other hand, the PZT film of Comparative Example 1-8, which was formed with the PZT precursor solution of Comparative Example 1-2, had a thickness of 162 nm even when the spinning speed was 700 rpm.

Solution Preparation Stage

Example 1-49

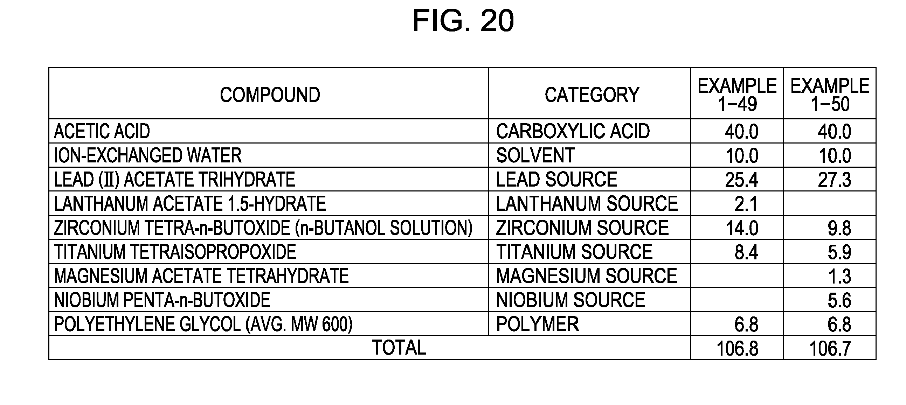

In a 200-mL glass flask 40.0 g of acetic acid (the solvent component) was weighed. To this, 14.0 g of the n-butanol solution of zirconium tetra-n-butoxide (the zirconium source; concentration: 86.0% by mass) and 8.4 g of titanium tetraisopropoxide (the titanium source) were added. The obtained mixture was stirred with a magnetic stirrer at room temperature, or more specifically 25°C, for 30 minutes to yield a mixed solution. To this mixed solution 25.4 g of lead (II) acetate trihydrate (the lead source), 2.1 g of lanthanum acetate 1.5-hydrate as a lanthanum source, 6.8 g of a polyethylene glycol with a weight-average molecular weight of 600 (the polymeric component), and 10.0 g of ion-exchanged water as an additional solvent were added. The obtained mixture was heated and stirred in an oil bath at 80°C for 1 hour to complete a precursor solution for lead-based piezoelectric films. Fig. 20 presents the weight measurements of the solvents, the metal sources, and the polymer used in this example. The metal oxide content of the obtained precursor solution (the content of the metal elements calculated on the assumption that the metal elements all existed in their oxide forms, i.e., lead oxide PbO, lanthanum oxide $La_2O_3$, zirconium oxide $ZrO_2$, and titanium oxide $TiO_2$) was measured to be 20.9% by mass, and the raw-material-derived carboxylic acid content in the total amount of the raw materials was 37.5% by mass.

Example 1-50

In a 200-mL glass flask 40.0 g of acetic acid (the solvent component) was weighed. To this, 9.8 g of the n-butanol solution of zirconium tetra-n-butoxide (the zirconium source; concentration: 86.0% by mass), 5.9 g of titanium tetraisopropoxide (the titanium source), and 5.6 g of niobium penta-n-butoxide as a niobium source were added. The obtained mixture was stirred with a magnetic stirrer at room temperature, or more specifically 25˚C, for 30 minutes to yield a mixed solution. To this mixed solution 27.3 g of lead (II) acetate trihydrate (the lead source), 1.3 g of magnesium acetate tetrahydrate as a magnesium source, 6.8 g of a polyethylene glycol with a weight-average molecular weight of 600 (the polymeric component), and 10.0 g of ion-exchanged water as an additional solvent were added. The obtained mixture was heated and stirred in an oil bath at 80˚C for 1 hour to complete a precursor solution for lead-based piezoelectric films. The weight measurements of the solvents, the metal sources, and the polymer used in this example are also presented in Fig. 20. The metal oxide content of the obtained precursor solution (the content of the metal elements calculated on the assumption that the metal elements all existed in their oxide forms, *i.e.,* lead oxide PbO, zirconium oxide $ZrO_2$, titanium oxide $TiO_2$, magnesium oxide MgO, and niobium oxide $Nb_2O_5$) was measured to be 20.8% by mass, and the raw-material-derived carboxylic acid content in the total amount of the raw materials was 37.5% by mass.

Film-Formation Cycle

The precursor solutions for lead-based piezoelectric films of Examples 1-49 and 1-50 were used to form lead-based piezoelectric films. More specifically, each precursor solution was used on the next day and 30 days after preparation to form a lead-based piezoelectric film by the same film-formation cycle (the application, drying, defatting, and sintering stages) as that used for Example 1-1; two lead-based piezoelectric films were formed for each example. Before each time of use, the precursor solution was put into a glass bottle with a cap and stored in a dark place at room temperature, or at around 25˚C.

Consistency Test

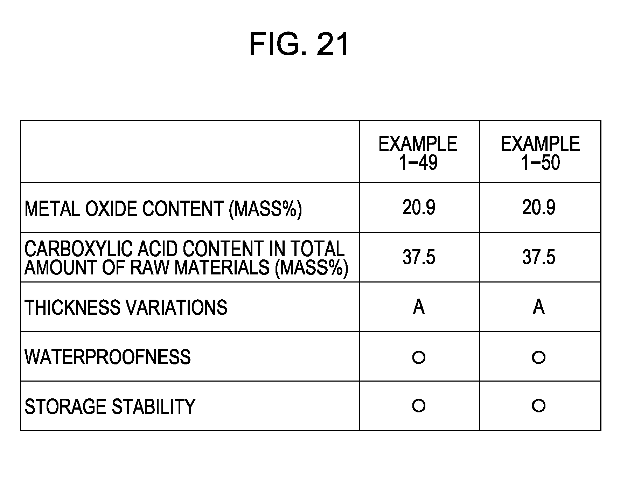

The lead-based piezoelectric film parings obtained using the precursor solutions of Examples 1-49 and 1-50 were analyzed in a scanning electron microscope (Hitachi S-4700) and the cross-sectional images were used to determine their thicknesses. The thickness of the lead-based piezoelectric film formed with the precursor solution stored for 30 days was normalized against that of the lead-based piezoelectric film formed on the next day after the precursor solution was prepared, with the latter as 100, and the film thickness consistency of the precursor solution was evaluated in accordance with the criteria presented below. The obtained test results are summarized in Fig. 21.

A: The thickness of the lead-based piezoelectric film obtained using the precursor solution for lead-based piezoelectric films stored for 30 days was in a range of ≥100 to <110;
B: The thickness of the lead-based piezoelectric film obtained using the precursor solution for lead-based piezoelectric films stored for 30 days was in a range of ≥110 to <120;
C: The thickness of the lead-based piezoelectric film obtained using the precursor solution for lead-based piezoelectric films stored for 30 days was ≥120.

Waterproofness Test

The precursor solutions for lead-based piezoelectric films prepared in Examples 1-49 and 1-50 were tested for waterproofness in the same way and in accordance with the same criteria as those used for Example 1-1. The obtained test results are summarized in Fig. 21.

Storage Stability Test

The precursor solutions for lead-based piezoelectric films prepared in Examples 1-49 and 1-50 were then tested for storage stability in the same way and in accordance with the same criteria as those used for Example 1-1. The obtained test results are summarized in Fig. 21.

Manufacturing of Ink Jet Recording Heads

The PZT precursor solutions of Examples 1-1 to 1-48 and Comparative Example 1-2 were used to manufacture ink jet recording heads in accordance with the above-described manufacturing process of an ink jet recording head.

For Examples 1-1 to 1-48, the PZT precursor solution was used on the next day of preparation to form a piezoelectric layer 70 having a thickness of 1.2 $\mu$m. To do this, the above-described film-formation cycle (the application, drying, defatting, and sintering stages) was repeated six times with the PZT precursor solution. (Each PZT precursor solution was applied with the spinning speed adjusted so that the thickness of every film should be 200 nm.)

As for Comparative Example 1-2, although the PZT precursor solution was also used on the next day of preparation to form a piezoelectric layer 70 having a thickness of 1.2 $\mu$m, it was required to repeat the same film-formation cycle 12 times to achieve this thickness (the spinning speed was 1500 rpm). This means that to produce a piezoelectric layer 70 having a certain thickness, the PZT precursor solution according to this embodiment requires only half the number of film-formation cycles needed with that of Comparative Example 1-2.

The obtained piezoelectric layers 70 were subjected to the determination of crystallinity (measurement of $\theta/2\theta$ in an X-ray diffractometer), the evaluation of hysteresis properties by the virtual ground method, the assessment of piezoelectric properties with a laser Doppler vibrometer (measurement of the amount of displacement), a pulse durability test (the percent reduction of displacements after 20 billion pulses from the baseline), and some other tests. The results for the piezoelectric layers 70 formed using the precursor solutions of Examples 1-1 to 1-48 were equivalent to those with the piezoelectric layer 70 formed with the precursor solution of Comparative Example 1-2.

The word *equivalent* as used herein means that the numerical results normalized with those for the piezoelectric body formed with the precursor solution of Comparative Example 1-2 as 100 all fell within a range of 95 to 105. The numerical results considered were as follows: the peak intensity corresponding to the (100) plane and the percentage of orientation along the (100) plane in the crystallinity determination; maximum polarization, remnant polarization, and coercivity in the hysteresis evaluation; the amount of displacement in piezoelectric properties; and the percent reduction of displacements in the pulse durability test.

Embodiment 2

Precursor Solution for Piezoelectric Films

The following describes the piezoelectric film precursor solution according to Embodiment 2 by explaining the differences from Embodiment 1; the explanations about the elements already described in Embodiment 1 will not be repeated. The drawings used to illustrate Embodiment 1 will be mentioned as necessary, and the elements already explained in Embodiment 1 are given the same numerals as in these drawings.

The piezoelectric film precursor solution according to Embodiment 2 is, as with that according to Embodiment 1, a solution obtained by mixing the following raw materials: a selected carboxylic acid or acids (the solvent component); lead-, zirconium-, and titanium-based organic metal compounds; and a polymeric component.

For the piezoelectric film precursor solution according to Embodiment 2, it is preferable that the zirconium-based organic metal compound is zirconium acetate. Preferred kinds of zirconium acetate include the acetate represented by $Zr(OCOCH_3)_4$, and zirconium oxyacetate, which is $ZrO(OCOCH_3)_2$.

The zirconium acetate used here may be a commercially available one or synthesized by reaction from a zirconium alkoxide and acetic acid. The method for synthesizing the zirconium acetate is not particularly limited; in a typical method, the zirconium alkoxide and acetic acid equivalent to 4 mol of the zirconium alkoxide are mixed in a nitrogen-filled glove box, and the mixture is stirred at a temperature of 20 to 120˚C to yield a solution containing zirconium acetate. The zirconium acetate-containing solution obtained in this way can be used directly as a raw material of the piezoelectric film precursor solution; however, it is also allowed to remove the solvents (acetic acid and the alcohol) from the zirconium acetate-containing solution by distillation and use the residue as a raw material of the precursor solution.

Although not particularly limited, the molecular weight of zirconium acetate is preferably equal to or smaller than 4500 and more preferably equal to or smaller than 1500 in consideration of solubility in the solvent component.

The molecular weight used here can be measured by electrospray ionization mass spectrometry (ESI-MS). Examples of the ESI-MS systems that can be used for this purpose include Q-TOF mass spectrometers available from Waters-Micromass.

If the zirconium acetate used here is obtained by synthesis, examples of the zirconium alkoxides that can be used include, but are not particularly limited to, zirconium tetramethoxide, zirconium tetraethoxide, zirconium tetra-n-propoxide, zirconium tetraisopropoxide, zirconium tetra-n-butoxide, zirconium tetraisobutoxide, zirconium tetra-sec-butoxide, zirconium tetra-tert-butoxide, zirconium tetra-n-pentoxide, zirconium tetra-sec-pentoxide, zirconium tetra-tert-pentoxide, zirconium tetra-n-hexoxide, zirconium tetra-sec-hexoxide, zirconium tetra-n-heptoxide, zirconium tetra-sec-heptoxide, zirconium tetra-n-octoxide, tetrakis(2-ethylhexyloxy) orthozirconate, and so forth, and these compounds may be used as a pure substance or as a mixture. Among these zirconium alkoxides, those the ligand of which is an alkoxy group of 4 or less carbon atoms are preferred because in the above-described synthesis scheme a free ligand having a boiling point equal to or lower than 120˚C helps removing the alcohol from the reaction solution by distillation.

The titanium-based organic metal compound is preferably an alkoxide, although not particularly limited to this. Any titanium alkoxide may be used as long as its ligand is a branched alkoxy group of 3 to 8 carbon atoms. For example, such titanium alkoxides as those listed in Embodiment 1 can be used as a pure substance or as a mixture.

The raw materials of the piezoelectric film precursor solution according to Embodiment 2 include zirconium acetate and a titanium alkoxide whose ligand is a branched alcohol of 3 to 8 carbon atoms, and are substantially free of primary alcohols. This reduces the amount of carboxylate formation in the piezoelectric film precursor solution and thereby leads to reduced variations in thickness in the resulting piezoelectric films 72. The expression *substantially free of primary alcohols* as used herein means that no primary alcohol is contained in any of the raw materials or primary alcohols account for less than 5.0% by mass of the raw materials.

As mentioned in the description of Embodiment 1, when a metal alkoxide is dissolved in a solvent carboxylic acid, ligand exchange reaction occurs, and the carboxylic acid (A-COOH) and the alcohol (B-OH) undergo the carboxylate (A-COO-B) formation reaction of Formula (1).

The carboxylate tends to be more volatile than the constituent carboxylic acid and alcohol. If a precursor solution for piezoelectric films contains a free alcohol and the carboxylate formation reaction is let to progress over time, therefore, the film thickness achieved after the film-formation cycle will seriously vary from cycle to cycle. The use of zirconium acetate thus reduces such variations in film thickness.

When a carboxylic acid and an alcohol react with each other to form a carboxylate, the more carbon atoms the alcohol has, the smaller the amount of the carboxylate formed is. When linear and branched alcohols of the same number of carbon atoms are compared, the latter leads to a smaller amount of carboxylate formation. It is therefore preferable to use a titanium alkoxide the ligand of which is a branched alcohol of 3 to 8 carbon atoms.

The solvent component of the piezoelectric film precursor solution according to Embodiment 2 can contain one or more solvents selected from water, secondary or tertiary alcohols, ethers, esters, and ketones, as in Embodiment 1. Replacing some portion of the carboxylic acid component, the carboxylate source, with one or more selected from water, secondary or tertiary alcohols, ethers, esters, and ketones serve to suppress the carboxylate formation reaction. Examples of the secondary or tertiary alcohols, ethers, esters, and ketones that can be used for this purpose include known ones represented by those listed in Embodiment 1.

The piezoelectric film precursor solution according to Embodiment 2 contains the carboxylic acid or acids in an amount in a range of 20% by mass to 50% by mass, both inclusive, of the total amount of the raw materials used for the preparation thereof. As demonstrated by the test results for some examples provided later, the carboxylic acid or acids prevent the hydrolysis due to the moisture in the air when contained in an amount of at least 20% by mass of the total amount of the raw materials, and the resulting piezoelectric film 72 will have a sufficiently large thickness when the amount of the carboxylic acid or acids relative to the total amount of the raw materials is equal to or lower than 50% by mass.

Furthermore, it is preferable in Embodiment 2 that the polymeric component consists of one or more polymers selected from polyethylene glycols, polyethylene glycol derivatives, polypropylene glycols, and polypropylene glycol derivatives, for these polymers have carbon-oxygen bonds, and additionally the weight-average molecular weight of the polymeric component is in a range of 300 to 800. As already mentioned, carbon-oxygen bonds are weaker and thus are more likely to be broken by heat than carbon-carbon bonds. The use of a polymer or polymers having carbon-oxygen bonds therefore will lead to relaxation of the stress on the film generated as its shrinks, with a reduced adverse effect on the piezoelectric properties. Furthermore, controlling the weight-average molecular weight of the polymeric component to fall within a range of 300 to 800 ensures a sufficient stress relaxation effect and a satisfactory thermal decomposasability of the polymeric component as demonstrated by the test results for some examples provided later. As a result, the produced piezoelectric film 72 is unlikely to crack with a reduced loss of quality.

Additionally, it is preferable in Embodiment 2 that the oxide-equivalent content of the metal elements existing in the piezoelectric film precursor solution is in a range of 15% by mass to 25% by mass, both inclusive. As demonstrated by the test results for some examples provided later, controlling the oxide-equivalent content of the metal elements to fall within a range of 15% by mass to 25% by mass, both inclusive, ensures that the resulting piezoelectric film has a sufficiently large thickness.

The following examples illustrate the piezoelectric film precursor solution according to Embodiment 2 in more detail. Examples 2-1 to 2-23 illustrate PZT films and PZT solutions as examples of the piezoelectric films 72 and the precursor solution, respectively.

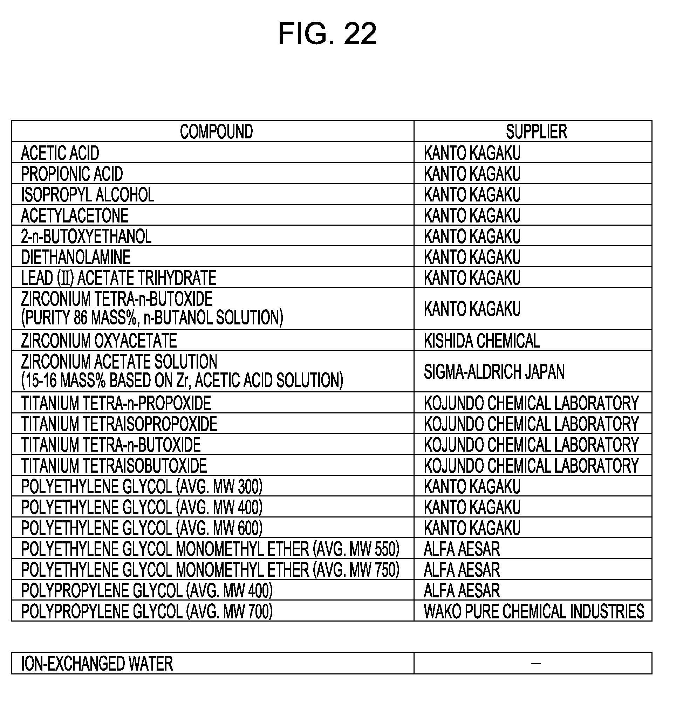

In the following examples and comparative examples, different piezoelectric film precursor solutions were used, but the application, drying, defatting, and sintering stages were carried out under the same conditions. The following paragraphs first describe the procedure for preparing the piezoelectric film precursor solution for each individual example or comparative example, and then the procedures common to the examples and comparative examples. Fig. 22 lists the raw materials used to prepare the piezoelectric film precursor solutions according to Embodiment 2. Note that these examples should not be construed as limiting the scope of the invention. Solution Preparation Stage

Example 2-1

In a 200-mL glass flask 35.0 g of acetic acid (the solvent component) was weighed. To this, 7.0 g of zirconium oxyacetate (the zirconium source), 8.4 g of titanium tetraisopropoxide (the titanium source), and 15.0 g of ion-exchanged water as another solvent were added. The obtained mixture was stirred with a magnetic stirrer at room temperature, or more specifically 25°C, for 30 minutes to yield a mixed solution. To this mixed solution 27.3 g of lead (II) acetate trihydrate (the lead source) and 6.8 g of polyethylene glycol (the polymeric component; weight-average molecular weight: 600) were added. The obtained mixture was heated and stirred in an oil bath at 80°C for 1 hour to complete the PZT precursor solution.

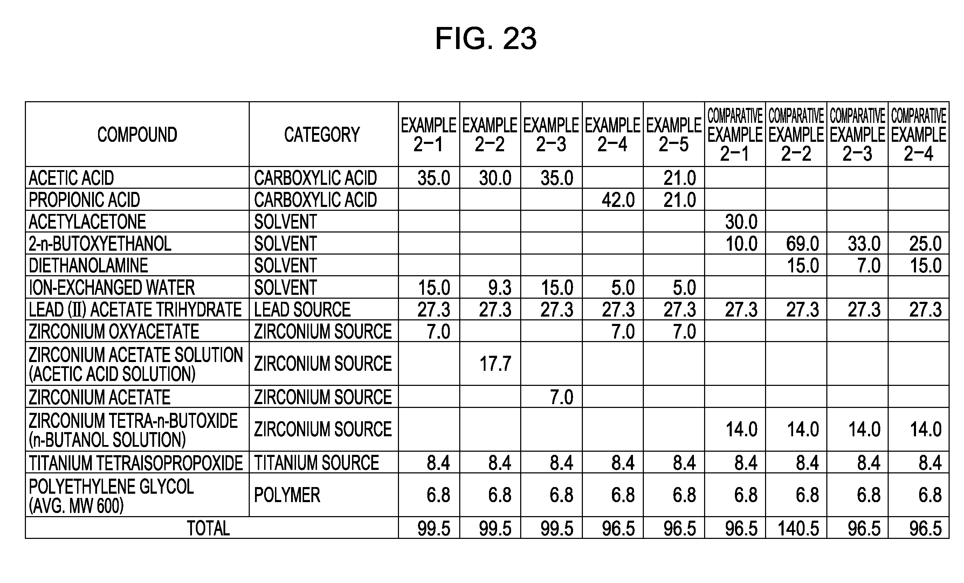

Fig. 23 presents the weight measurements of the solvents, the metal sources, and the polymer used in this example. The metal oxide content of the PZT precursor solution of this example (the content of the metal elements calculated on the assumption that the metal elements all existed in their oxide forms, i.e., lead oxide PbO, zirconium oxide $ZrO_2$, and titanium oxide $TiO_2$) was measured to be 22.4% by mass, and the raw-material-derived carboxylic acid content in the total amount of the raw materials was 35.2% by mass.

To 3 mg of the zirconium oxyacetate used in Example 2-1, ion-exchanged water was added to make the volume of the diluted solution 1 mL. The diluted solution was named Measurement Sample 1, and Measurement Sample 1 was analyzed in a Q-TOF mass spectrometer (Model Q-Tof, available from Micromass) by direct introduction. The measurement conditions were as follows: ionization mode, positive; capillary voltage, 3500 V; ion source temperature, 80°C; heater temperature, 150°C; cone voltage, 30 V.

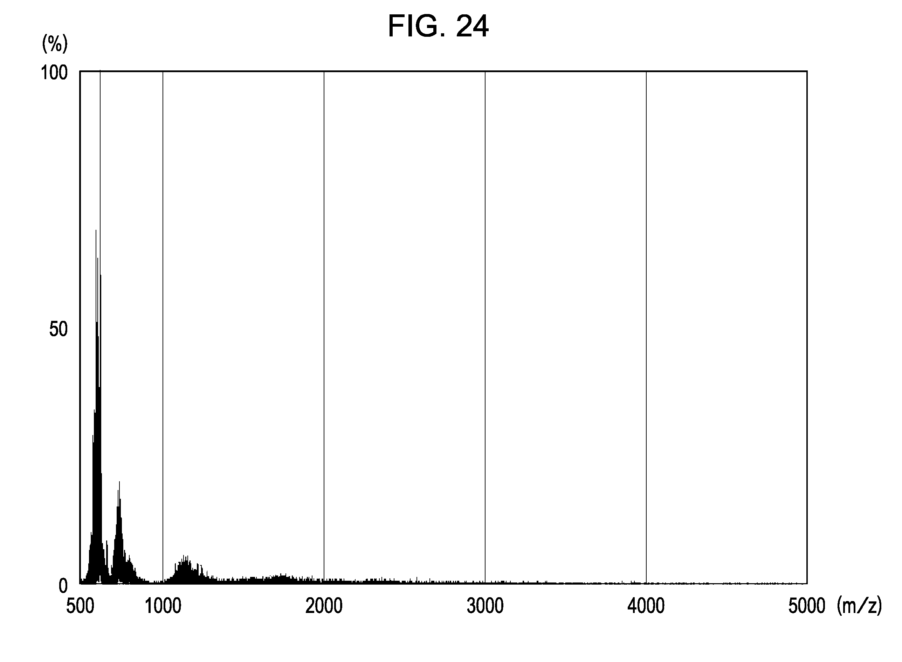

Fig. 24 shows the obtained measurement results. In Fig. 24 the most intense peak is at an m/z of 616, and this peak is attributed to divalent ions; the molecular weight was determined to be 1232.

Example 2-2

In a 200-mL glass flask 30.0 g of acetic acid (the solvent component) was weighed. To this, 17.7 g of the zirconium acetate solution (the zirconium source), 8.4 g of titanium tetraisopropoxide (the titanium source), and 9.3 g of ion-exchanged water as another solvent were added. The obtained mixture was stirred with a magnetic stirrer at room temperature, or more specifically 25°C, for 30 minutes to yield a mixed solution. To this mixed solution 27.3 g of lead (II) acetate trihydrate (the lead source) and 6.8 g of polyethylene glycol (the polymeric component; weight-average molecular weight: 600) were added. The obtained mixture was heated and stirred in an oil bath at 80°C for 1 hour to complete the PZT precursor solution. The weight measurements of the solvents, the metal sources, and the polymer used in this example are also presented in Fig. 23. The metal oxide content of the PZT precursor solution of this example (the content of the metal elements calculated on the assumption that the metal elements all existed in their oxide forms, i.e., lead oxide PbO, zirconium oxide $ZrO_2$, and titanium oxide $TiO_2$) was measured to be 22.4% by mass, and the raw-material-derived carboxylic acid content in the total amount of the raw materials was 37.7% by mass.

To 3 mg of the zirconium acetate solution used in Example 2-2, acetic acid was added to make the volume of the diluted solution 1 mL. The diluted solution was named Measurement Sample 2, and Measurement Sample 2 was analyzed in a Q-TOF mass spectrometer (Model Q-Tof, available from Micromass) by direct introduction. The measurement conditions were as follows: ionization mode, positive; capillary voltage, 3500 V; ion source temperature, 80°C; heater temperature, 150°C; cone voltage, 30 V.

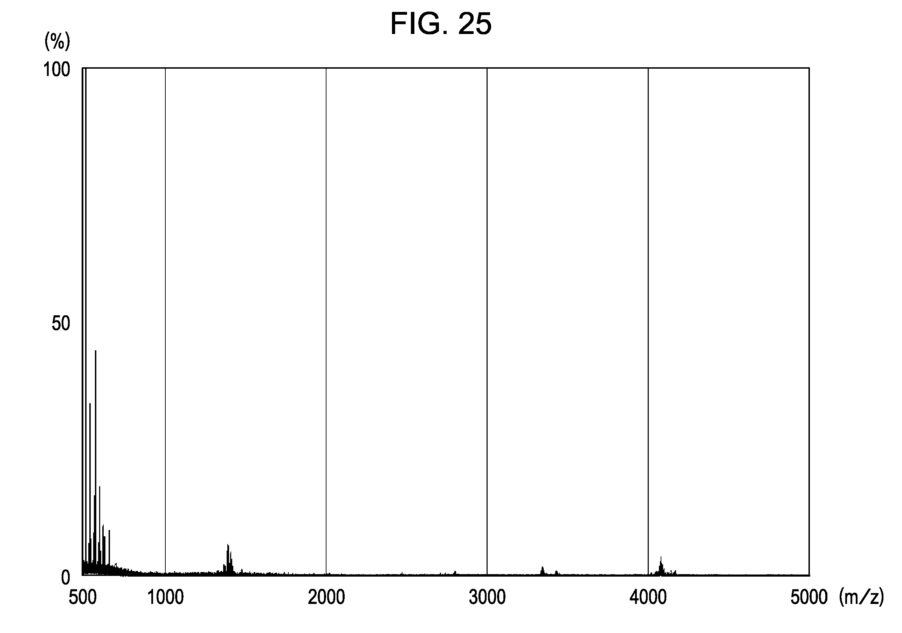

Fig. 25 shows the obtained measurement results. Measurement Sample 2 contained zirconium acetate in some forms with large molecular weights as indicated by, for example, the peaks at m/z values of 1395, 3340, and 4075 in Fig. 25, and these peaks correspond to molecular weights of 1395, 3340, and 4075, respectively.

Example 2-3

In a 200-mL glass flask 43.0 g of acetic acid (the solvent component) was weighed. To this, 14.0 g of the n-butanol solution of zirconium tetra-n-butoxide (concentration: 86.0% by mass) was added, and the obtained mixture was heated and stirred in an oil bath at 80°C for 1 hour. Then, acetic acid and butanol were removed by distillation at 50°C and a pressure of 720 to 640 mmHg (96.0 to 85.3 kPa) using a rotary evaporator (N-11 type, available from Tokyo Rikakikai Co., Ltd.), and thereby a white solid of zirconium acetate weighing 7 g was obtained.

To the same glass flask, 15.0 g of ion-exchanged water and a solution composed of 35.0 g of acetic acid and 8.4 g of titanium tetraisopropoxide were added. The obtained mixture was stirred with a magnetic stirrer at room temperature, or more specifically 25°C, for 30 minutes to yield a mixed solution. To this mixed solution 27.3 g of lead (II) acetate trihydrate (the lead source) and 6.8 g of polyethylene glycol (the polymeric component; weight-average molecular weight: 600) were added. The obtained mixture was heated and stirred in an oil bath at 80°C for 1 hour to complete the PZT precursor solution. The weight measurements of the solvents, the metal sources, and the polymer used in this example are also presented in Fig. 23. The metal oxide content of the PZT precursor solution of this example (the content of the metal elements calculated on the assumption that the metal elements all existed in their oxide forms, i.e., lead oxide PbO, zirconium oxide $ZrO_2$, and titanium oxide $TiO_2$) was measured to be 22.4% by mass, and the raw-material-derived carboxylic acid content in the total amount of the raw materials was 35.2% by mass.

To 3 mg of the white solid used in Example 2-3, ion-exchanged water was added to make the volume of the diluted solution 1 mL. The diluted solution was named Measurement Sample 3, and Measurement Sample 3 was analyzed in a Q-TOF mass spectrometer (Model Q-Tof, available from Micromass) by direct introduction. The measurement conditions were as follows: ionization mode, positive; capillary voltage, 3500 V; ion source temperature, 80˚C; heater temperature, 150˚C; cone voltage, 30 V.

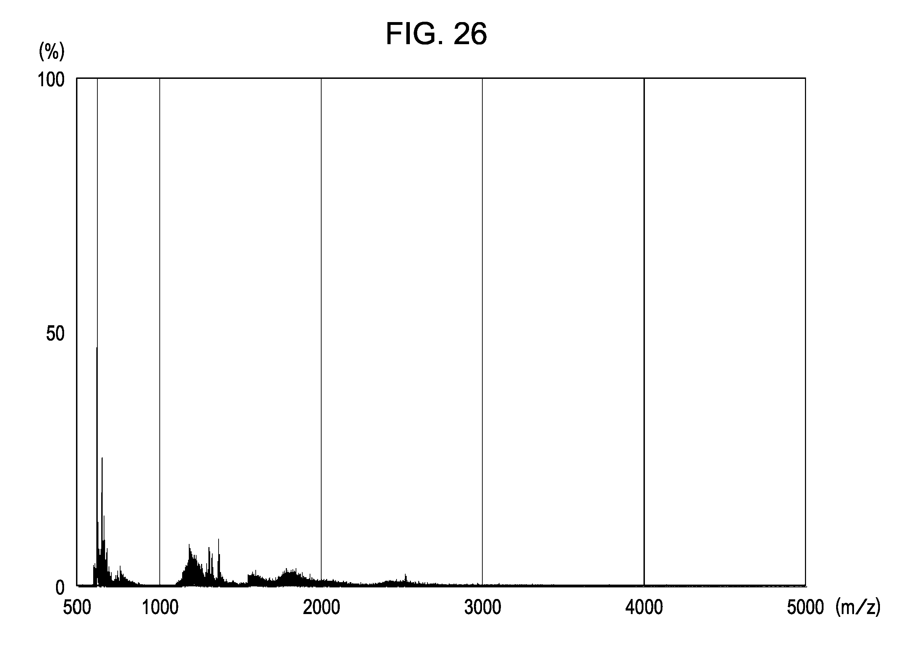

Fig. 26 shows the obtained measurement results. Measurement Sample 3 showed a similar profile to that of Measurement Sample 1 (a peak of divalent ions was observed at an m/z of 616).

Example 2-4

The PZT precursor solution was obtained in the same way as in Example 2-1 except that 42.0 g of propionic acid was used instead of the 35.0 g of acetic acid and the amount of ion-exchanged water was changed from 15.0 g to 5.0 g. The weight measurements of the solvents, the metal sources, and the polymer used in this example are also presented in Fig. 23. The metal oxide content and the raw-material-derived carboxylic acid content in the total amount of the raw materials calculated for this example in the same way as in Example 2-1 were 23.1 % by mass and 43.5% by mass, respectively.

Example 2-5

The PZT precursor solution was obtained in the same way as in Example 2-1 except that 21.0 g of acetic acid and 21.0 g of propionic acid were used instead of the 35.0 g of acetic acid and the amount of ion-exchanged water was changed from 15.0 g to 5.0 g. The weight measurements of the solvents, the metal sources, and the polymer used in this example are also presented in Fig. 23. The metal oxide content and the raw-material-derived carboxylic acid content in the total amount of the raw materials calculated for this example in the same way as in Example 2-1 were 23.1% by mass and 47.2% by mass, respectively.

Comparative Example 2-1

In a 200-mL glass flask 30.0 g of acetyl acetone and 10.0 g of 2-n-butoxyethanol (the solvent component) were weighed. To this, 14.0 g of the n-butanol solution of zirconium tetra-n-butoxide (the zirconium source; concentration: 86.0% by mass) and 8.4 g of titanium tetraisopropoxide (the titanium source) were added. The obtained mixture was stirred with a magnetic stirrer at room temperature, or more specifically 25˚C, for 30 minutes to yield a mixed solution. To this mixed solution 27.3 g of lead (II) acetate trihydrate (the lead source) and 6.8 g of polyethylene glycol (the polymeric component; weight-average molecular weight: 600) were added. The obtained mixture was heated and stirred in an oil bath at 80˚C for 1 hour to complete the PZT precursor solution. The weight measurements of the solvents, the metal sources, and the polymer used in this comparative example are also presented in Fig. 23. The metal oxide content of the PZT precursor solution of this comparative example (the content of the metal elements calculated on the assumption that the metal elements all existed in their oxide forms, i.e., lead oxide PbO, zirconium oxide $ZrO_2$, and titanium oxide $TiO_2$) was measured to be 23.1 % by mass.

Comparative Example 2-2

The PZT precursor solution was obtained in the same way as in Comparative Example 2-1 except that the solvent component consisted of 69.0 g of 2-n-butoxyethanol and 15.0 g of diethanolamine. The weight measurements of the solvents, the metal sources, and the polymer used in this comparative example are also presented in Fig. 23. The metal oxide content calculated for this comparative example in the same way as in Example 2-1 was 15.9% by mass.

Comparative Example 2-3

The PZT precursor solution was obtained in the same way as in Example 2-1 except that the solvent component consisted of 33.0 g of 2-n-butoxyethanol and 7.0 g of diethanolamine. The weight measurements of the solvents, the metal sources, and the polymer used in this comparative example are also presented in Fig. 23. The metal oxide content calculated for this comparative example in the same way as in Example 2-1 was 23.1% by mass.

Comparative Example 2-4

The PZT precursor solution was obtained in the same way as in Example 2-1 except that the solvent component consisted of 25.0 g of 2-n-butoxyethanol and 15.0 g of diethanolamine. The weight measurements of the solvents, the metal sources, and the polymer used in this comparative example are also presented in Fig. 23. The metal oxide content calculated for this comparative example in the same way as in Example 2-1 was 23.1% by mass.

Application Stage

The obtained PZT precursor solutions were applied to flow channel substrate wafers 110 like that illustrated in Fig. 4C. The following provides a more detailed description about the procedure at this stage. First, a silicon single crystal substrate measuring 150 mm in diameter and 700 $\mu$m in thickness was subjected to thermal oxidation until the thickness of the $SiO_2$ layer as the elastic film 50 reached 1.1 $\mu$m. Then, a $ZrO_2$ film was formed as the insulating film 55 by sputtering until a thickness of 0.4 $\mu$m was reached. After that, a laminate consisting of a Pt layer of 130 nm thick and an Ir layer of 20 nm thick was formed by sputtering as the lower electrode 60.

Prior to the formation of the lower electrode 60, a titanium layer having a thickness of 10 nm was formed as a contact layer. Furthermore, a titanium layer having a thickness of 5 nm was formed after the formation of the lower electrode 60. Then, the PZT precursor solutions of Examples 2-1 to 2-5 and Comparative Examples 2-1 to 2-4 were applied by spin coating at 25˚C and 40% RH. The conditions of spin coating were as follows: the volume of PZT precursor solution dropped, 4 mL; spinning speed, 2000 rpm; spinning time, 60 seconds. Note that each PZT precursor solution was applied on the next day of preparation.

Drying Stage

After the application stage, each substrate wafer was heated on a hot plate at 140˚C for 5 minutes (the drying stage).

Defatting Stage

After the drying stage, the substrate wafer was heated on a hot plate at 400˚C for 5 minutes (the defatting stage).

Sintering Stage

After the defatting stage, the substrate wafer was put into an RTA apparatus and heated at 700˚C for 5 minutes under a stream of oxygen (the sintering stage).

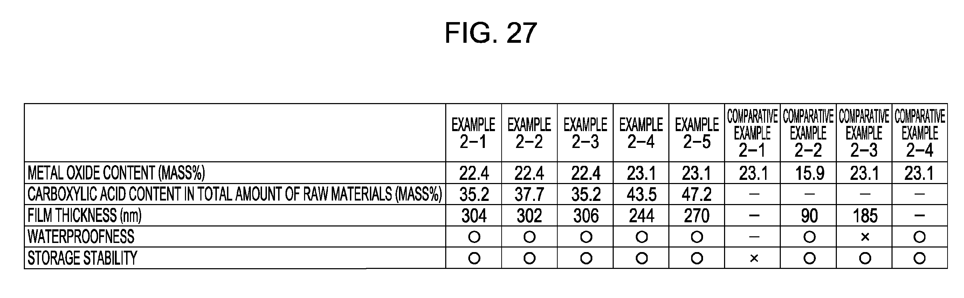

The obtained PZT films were analyzed in a scanning electron microscope (Hitachi S-4700) and the cross-sectional images were used to determine their thicknesses. For each example or comparative example, the thickness of the PZT film formed with the PZT precursor solution is presented in Fig. 27 along with the metal oxide content and the raw-material-derived carboxylic acid content in the total amount of the raw materials of the PZT precursor solution.

Waterproofness Test

The PZT precursor solutions of Examples 2-1 to 2-5 and Comparative Examples 2-1 to 2-4 were subjected to a waterproofness test. In the waterproofness test, ion-exchanged water was added to each PZT precursor solution, and the obtained mixture was rocked and observed for the formation of any precipitate. More specifically, 1.0 g of the PZT precursor solution was put into a glass bottle of 2.0 mL capacity with a cap, 0.5 g of ion-exchanged water was added, and then the bottle was rocked, and the waterproofness of the PZT precursor solution was evaluated in accordance with the following criteria: Pass (O)—No precipitate formed; Fail ($\times$)—A precipitate formed. The obtained test results are summarized in Fig. 27.

Storage Stability Test

The PZT precursor solutions of Examples 2-1 to 2-5 and Comparative Examples 2-1 to 2-4 were then tested for storage stability in the same way and in accordance with the same criteria as in Embodiment 1; the storage stability of each PZT precursor solution was evaluated in accordance with the following criteria: Pass (O)— No precipitate formed; Fail ($\times$)—A precipitate formed. The obtained test results are summarized in Fig. 27.

As is clear from the results presented in Fig. 27, the PZT precursor solutions of Examples 2-1 to 2-5 produced PZT films that had thicknesses of over 200 nm after crystallization, and these PZT precursor solutions showed good waterproofness and storage stability.

In contrast, the PZT precursor solution of Comparative Example 2-1 formed a precipitate as early as on the next day of preparation and could not be applied. This is because acetyl acetone was present in too large an amount and affected the stability of the solution.

The PZT precursor solution of Comparative Example 2-2 was good in waterproofness and storage stability, but the thickness of the PZT film formed therewith was 90 nm.

The PZT precursor solution of Comparative Example 2-3 produced a relatively thick PZT film, but failed (x) the waterproofness test (a precipitate was formed). This is because the amount of diethanolamine was too small to produce a sufficient stabilizing effect.

The PZT precursor solution of Comparative Example 2-4 was good in waterproofness and storage stability, but the PZT film formed therewith was seriously uneven and could not be tested. Diethanolamine is a very viscous solvent, and the amount of 2-n-butoxyethanol added was small. As a result, the viscosity of the PZT precursor solution was so high that the coating could not be spread over the entire surface of the substrate.

Solution Preparation Stage

Example 2-6

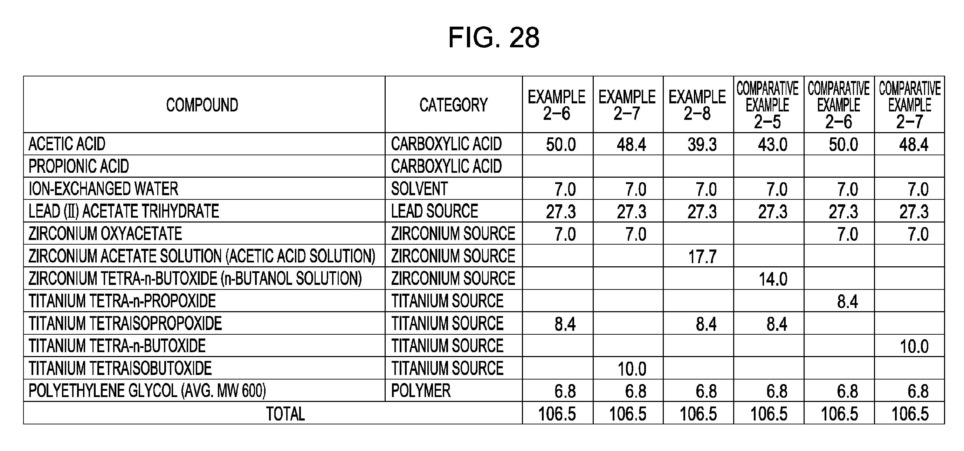

In a 200-mL glass flask 50.0 g of acetic acid (the solvent component) was weighed. To this, 7.0 g of zirconium oxyacetate (the zirconium source), 8.4 g of titanium tetraisopropoxide (the titanium source), and 7.0 g of ion-exchanged water were added. The obtained mixture was stirred with a magnetic stirrer at room temperature, or more specifically 25°C, for 30 minutes to yield a mixed solution. To this mixed solution 27.3 g of lead (II) acetate trihydrate (the lead source) and 6.8 g of a polyethylene glycol with a weight-average molecular weight of 600 (the polymeric component) were added. The obtained mixture was stirred at room temperature, 25°C, for 1 hour to complete the PZT precursor solution. Fig. 28 presents the weight measurements of the solvents, the metal sources, and the polymer used in this example. The metal oxide content and the raw-material-derived carboxylic acid content in the total amount of the raw materials calculated for this example in the same way as in Example 2-1 were 20.9% by mass and 47.0% by mass, respectively.

Example 2-7

The PZT precursor solution was obtained in the same way as in Example 2-6 except that the amount of acetic acid was changed from 50.0 g to 48.4 g and the titanium source was 10.0 g of titanium tetraisobutoxide. The weight measurements of the solvents, the metal sources, and the polymer used in this example are also presented in Fig. 28. The metal oxide content and the raw-material-derived carboxylic acid content in the total amount of the raw materials calculated for this example in the same way as in Example 2-1 were 20.9% by mass and 45.4% by mass, respectively.

Example 2-8

The PZT precursor solution was obtained in the same way as in Example 2-6 except that the amount of acetic acid was changed from 50.0 g to 39.3 g and the zirconium source was 17.7 g of the zirconium acetate solution. The weight measurements of the solvents, the metal sources, and the polymer used in this example are also presented in Fig. 28. The metal oxide content and the raw-material-derived carboxylic acid content in the total amount of the raw materials calculated for this example in the same way as in Example 2-1 were 20.9% by mass and 43.9% by mass, respectively.

Comparative Example 2-5

The PZT precursor solution was obtained in the same way as in Example 2-6 except that the amount of acetic acid was changed from 50.0 g to 43.0 g and the zirconium source was 14.0 g of the n-butanol solution of zirconium tetra-n-butoxide (concentration: 86.0% by mass). The weight measurements of the solvents, the metal sources, and the polymer used in this comparative example are also presented in Fig. 28. The metal oxide content and the raw-material-derived carboxylic acid content in the total amount of the raw materials calculated for this comparative example in the same way as in Example 2-1 were 20.9% by mass and 40.4% by mass, respectively.

Comparative Example 2-6

The PZT precursor solution was obtained in the same way as in Example 2-6 except that the titanium source was 8.4 g of titanium tetra-n-propoxide. The weight measurements of the solvents, the metal sources, and the polymer used in this comparative example are also presented in Fig. 28. The metal oxide content and the raw-material-derived carboxylic acid content in the total amount of the raw materials calculated for this comparative example in the same way as in Example 2-1 were 20.9% by mass and 47.0% by mass, respectively.

Comparative Example 2-7

The PZT precursor solution was obtained in the same way as in Example 2-6 except that the amount of acetic acid was changed from 50.0 g to 48.4 g and the titanium source was 10.0 g of titanium tetra-n-butoxide. The weight measurements of the solvents, the metal sources, and the polymer used in this comparative example are also presented in Fig. 28. The metal oxide content and the raw-material-derived carboxylic acid content in the total amount of the raw materials calculated for this comparative example in the same way as in Example 2-1 were 20.9% by mass and 45.4% by mass, respectively.

Film-Formation Cycle

The PZT precursor solutions of Examples 2-6 to 2-8 and Comparative Examples 2-5 to 2-7 were used to form PZT films. More specifically, each PZT precursor solution was used on the next day and 30 days after preparation to form a PZT film by the same film-formation cycle (the application, drying, defatting, and sintering stages) as that used for Example 2-1; two PZT films were formed for each example or comparative example. Before each time of use, the PZT precursor solution was put into a glass bottle with a cap and stored in a dark place at room temperature, or around 25°C.

Consistency Test

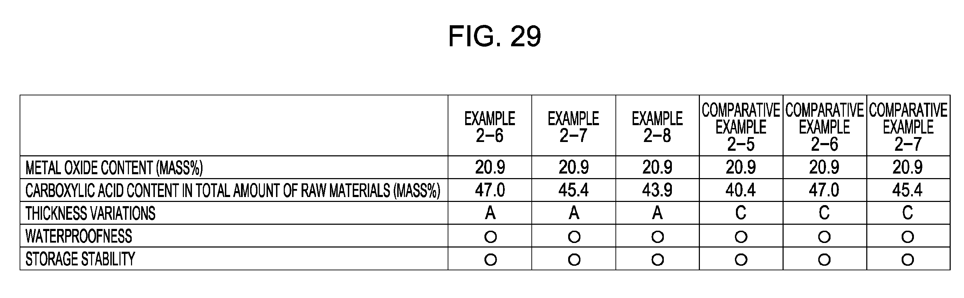

The PZT film parings obtained using the PZT precursor solutions of Examples 2-6 to 2-8 and Comparative Examples 2-5 to 2-7 were analyzed in a scanning electron microscope (Hitachi S-4700) and the cross-sectional images were used to determine their thicknesses. The thickness of the PZT film formed with the PZT precursor solution stored for 30 days was normalized against that of the PZT film formed on the next day after the PZT precursor solution was prepared, with the latter as 100, and the film thickness consistency of the PZT precursor solution was evaluated in accordance with the criteria presented below. The test results for Examples 2-6 to 2-8 and Comparative Examples 2-5 to 2-7 are summarized in Fig. 29.

A: The thickness of the PZT film obtained using the PZT precursor solution stored for 30 days was in a range of ≥100 to <103;
B: The thickness of the PZT film obtained using the PZT precursor solution stored for 30 days was in a range of ≥103 to <106;
C: The thickness of the PZT film obtained using the PZT precursor solution stored for 30 days was ≥106.

Waterproofness Test

The PZT precursor solutions of Examples 2-6 to 2-8 and Comparative Examples 2-5 to 2-7 were tested for waterproofness in the same way and in accordance with the same criteria as those used for Example 2-1. The obtained test results are summarized in Fig. 29.

Storage Stability Test

The PZT precursor solutions of Examples 2-6 to 2-8 and Comparative Examples 2-5 to 2-7 were then tested for storage stability in the same way and in accordance with the same criteria as those used for Example 2-1. The obtained test results are summarized in Fig. 29.
As is clear from the results presented in Fig. 29, the precursor solutions in which either the ligand of the zirconium alkoxide or that of the titanium alkoxide was of 1 to 3 carbon atoms or a linear chain all received a grade C in film thickness consistency test (Comparative Examples 2-5 to 2-7).
Compared with Comparative Examples 2-5 to 2-7, Examples 2-6 to 2-8 all got a grade A in film thickness consistency. This is because the use of zirconium acetate and a titanium alkoxide the ligand of which is a branched alkoxy group led to a reduced amount of carboxylate formation.
Additionally, the alcohol content and the carboxylate content of each PZT precursor solution were briefly determined by $^1$H- and $^{13}$C-NMR on the next day and 30 days after preparation. While in the PZT precursor solutions of Comparative Examples 2-5 to 2-7 the peak corresponding to the carboxylate was intensified, the PZT precursor solutions of Examples 2-6 to 2-8 produced the carboxylate only in a negligible amount over time. For example, in the $^1$H measurement for Example 2-6, the time-course change of the integrated intensity of the peak at 3.65 ppm was evaluated with the integrated intensity of the peak at 0.81 ppm corresponding to isopropyl alcohol as 6, and the integrated intensity of the peak was 0.89 and 0.86 on the next day and 30 days after preparation, respectively.

Solution Preparation Stage

Example 2-9

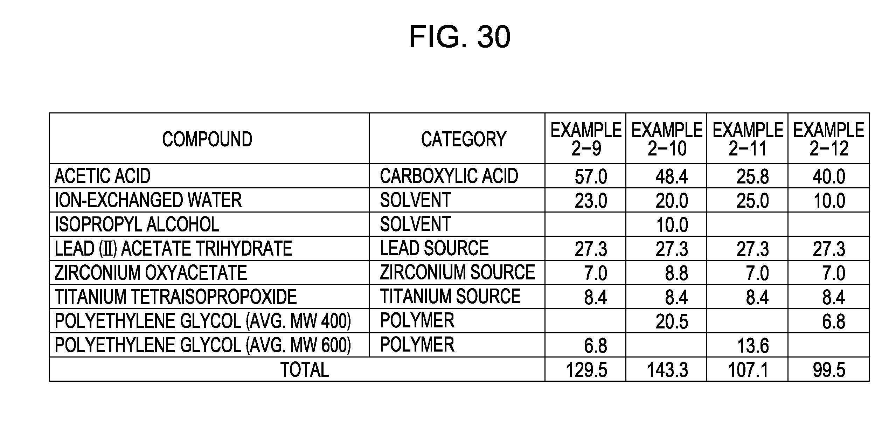

The PZT precursor solution was obtained in the same way as in Example 2-6 except that the amount of acetic acid was changed from 50.0 g to 57.0 g and the amount of ion-exchanged water was changed from 7.0 g to 23.0 g. Fig. 30 presents the weight measurements of the solvents, the metal sources, and the polymer used in this example. The metal oxide content and the raw-material-derived carboxylic acid content in the total amount of the raw materials calculated for this example in the same way as in Example 2-1 were 17.2% by mass and 44.0% by mass, respectively.

Example 2-10

The PZT precursor solution was obtained in the same way as in Example 2-6 except that 48.4 g of acetic acid and 10.0 g of isopropanol were used instead of the 50.0 g of acetic acid, the amount of ion-exchanged water was changed from 7.0 g to 20.0 g, and the 6.8 g of polyethylene glycol (weight-average molecular weight: 600) was replaced with 20.5 g of another kind of polyethylene glycol (weight-average molecular weight: 400). The weight measurements of the solvents, the metal sources, and the polymer used in this example are also presented in Fig. 30. The metal oxide content and the raw-material-derived carboxylic acid content in the total amount of the raw materials calculated for this example in the same way as in Example 2-1 were 15.6% by mass and 33.8% by mass, respectively.

Example 2-11

The PZT precursor solution was obtained in the same way as in Example 2-6 except that the amount of acetic acid was changed from 50.0 g to 25.8 g, the amount of ion-exchanged water was changed from 7.0 g to 25.0 g, and the amount of the polyethylene glycol (weight-average molecular weight: 600) from 6.8 g to 13.6 g. The weight measurements of the solvents, the metal sources, and the polymer used in this example are also presented in Fig. 30. The metal oxide content and the raw-material-derived carboxylic acid content in the total amount of the raw materials calculated for this example in the same way as in Example 2-1 were 20.8% by mass and 24.1% by mass, respectively.

Example 2-12

The PZT precursor solution was obtained in the same way as in Example 2-6 except that the amount of acetic acid was changed from 50.0 g to 40.0 g, the amount of ion-exchanged water was changed from 7.0 g to 10.0 g, and the 6.8 g of polyethylene glycol (weight-average molecular weight: 600) was replaced with 6.8 g of another kind of polyethylene glycol (weight-average molecular weight: 400). The weight measurements of the solvents, the metal sources, and the polymer used in this example are also presented in Fig. 30. The metal oxide content and the raw-material-derived carboxylic acid content in the total amount of the raw materials calculated for this example in the same way as in Example 2-1 were 22.4% by mass and 40.2% by mass, respectively.

Film-Formation Cycle

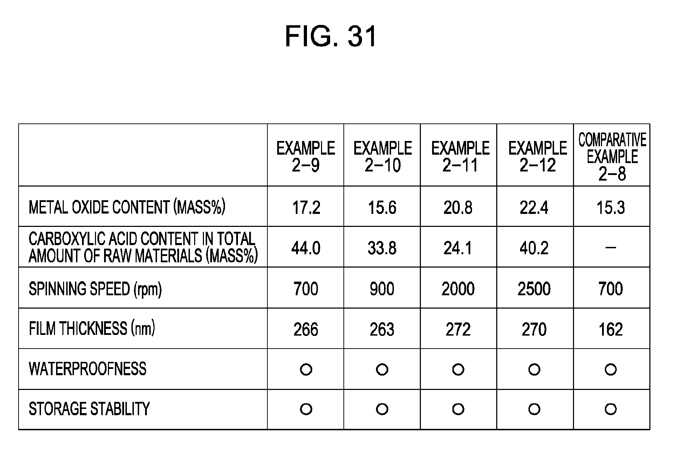

The PZT precursor solutions of Examples 2-9 to 2-12 and Comparative Example 2-2 were used to form PZT films. More specifically, each PZT precursor solution was used on the next day of preparation to form PZT films by the same film-formation cycle (the application, drying, defatting, and sintering stages) as that used for Example 2-1 except that different spinning speeds were used. Before the time of use, the PZT precursor solution was put into a glass bottle with a cap and stored in a dark place at room temperature, or at around 25˚C.
The obtained PZT films were analyzed in a scanning electron microscope (Hitachi S-4700) and the cross-sectional images were used to determine their thicknesses. The thicknesses of the PZT films formed with the PZT precursor solutions of these examples and Comparative Example 2-2 are summarized in Fig. 31. Waterproofness Test
The PZT precursor solutions of Examples 2-9 to 2-12 were tested for waterproofness in the same way and in accordance with the same criteria as those used for Example 2-1. The obtained test results are summarized in Fig. 31.

Storage Stability Test

The PZT precursor solutions of Examples 2-9 to 2-12 were then tested for storage stability in the same way and in accordance with the same criteria as those used for Example 2-1. The obtained test results are summarized in Fig. 31.
As is obvious from Fig. 31, the precursor solutions of Examples 2-8 to 2-12 each produced a PZT film with a thickness of over 200 μm when applied at an appropriate spinning speed. On the other hand, the PZT film of Comparative Example 2-8, which was formed with the PZT precursor solution of Comparative Example 2-2, had a thickness of 162 nm even when the spinning speed was 700 rpm.

Solution Preparation Stage

Example 2-13

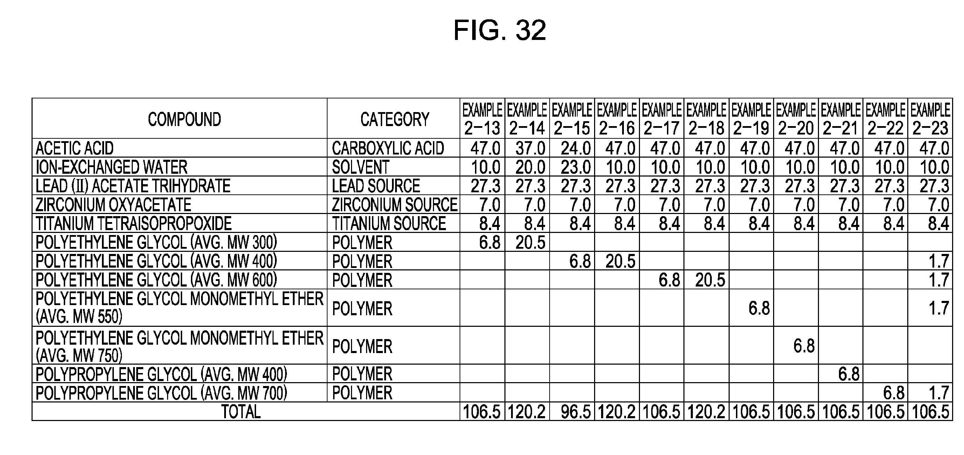

In a 200-mL glass flask 47.0 g of acetic acid (the solvent component) was weighed. To this, 7.0 g of zirconium oxyacetate (the zirconium source), 8.4 g of titanium tetraisopropoxide (the titanium source), and 10.0 g of ion-exchanged water were added. The obtained mixture was stirred with a magnetic stirrer at room temperature, or more specifically 25°C, for 30 minutes to yield a mixed solution. To this mixed solution 27.3 g of lead (II) acetate trihydrate (the lead source) and 6.8 g of a polyethylene glycol with a weight-average molecular weight of 300 were added. The obtained mixture was stirred at room temperature, or 25°C, for 1 hour to complete the PZT precursor solution. Fig. 32 presents the weight measurements of the solvents, the metal sources, and the polymer used in this example. The metal oxide content and the raw-material-derived carboxylic acid content in the total amount of the raw materials calculated for this example in the same way as in Example 2-1 were 20.9% by mass and 44.1% by mass, respectively.

Example 2-14

The PZT precursor solution was obtained in the same way as in Example 2-13 except that the amount of acetic acid was changed from 47.0 g to 37.0 g, the amount of ion-exchanged water was changed from 10.0 g to 20.0 g, and the amount of the polyethylene glycol with a weight-average molecular weight of 300 was changed from 6.8 g to 20.5 g. The weight measurements of the solvents, the metal sources, and the polymer used in this example are also presented in Fig. 32. The metal oxide content and the raw-material-derived carboxylic acid content in the total amount of the raw materials calculated for this example in the same way as in Example 2-1 were 18.5% by mass and 30.8% by mass, respectively.

Example 2-15

The PZT precursor solution was obtained in the same way as in Example 2-13 except that the amount of acetic acid was changed from 47.0 g to 24.0 g, the amount of ion-exchanged water was changed from 10.0 g to 23.0 g, and the 6.8 g of the polyethylene glycol with a weight-average molecular weight of 300 was replaced with 6.8 g of a polyethylene glycol with a weight-average molecular weight of 400. The weight measurements of the solvents, the metal sources, and the polymer used in this example are also presented in Fig. 32. The metal oxide content and the raw-material-derived carboxylic acid content in the total amount of the raw materials calculated for this example in the same way as in Example 2-1 were 23.1% by mass and 24.9% by mass, respectively.

Example 2-16

The PZT precursor solution was obtained in the same way as in Example 2-13 except that the polymeric component consisted of 20.5 g of a polyethylene glycol with a weight-average molecular weight of 400. The weight measurements of the solvents, the metal sources, and the polymer used in this example are also presented in Fig. 32. The metal oxide content and the raw-material-derived carboxylic acid content in the total amount of the raw materials calculated for this example in the same way as in Example 2-1 were 18.5% by mass and 39.1% by mass, respectively.

Example 2-17

The PZT precursor solution was obtained in the same way as in Example 2-13 except that the polymeric component consisted of 6.8 g of a polyethylene glycol with a weight-average molecular weight of 600. The weight measurements of the solvents, the metal sources, and the polymer used in this example are also presented in Fig. 32. The metal oxide content and the raw-material-derived carboxylic acid content in the total amount of the raw materials calculated for this example in the same way as in Example 2-1 were 20.9% by mass and 44.1% by mass, respectively.

Example 2-18

The PZT precursor solution was obtained in the same way as in Example 2-13 except that the polymeric component consisted of 20.5 g of a polyethylene glycol with a weight-average molecular weight of 600. The weight measurements of the solvents, the metal sources, and the polymer used in this example are also presented in Fig. 32. The metal oxide content and the raw-material-derived carboxylic acid content in the total amount of the raw materials calculated for this example in the same way as in Example 2-1 were 18.5% by mass and 39.1% by mass, respectively.

Example 2-19

The PZT precursor solution was obtained in the same way as in Example 2-13 except that the polymeric component consisted of 6.8 g of a polyethylene glycol monomethyl ether with a weight-average molecular weight of 550. The weight measurements of the solvents, the metal sources, and the polymer used in this example are also presented in Fig. 32. The metal oxide content and the raw-material-derived carboxylic acid content in the total amount of the raw materials calculated for this example in the same way as in Example 2-1 were 20.9% by mass and 44.1% by mass, respectively.

Example 2-20

The PZT precursor solution was obtained in the same way as in Example 2-13 except that the polymeric component consisted of 6.8 g of a polyethylene glycol monomethyl ether with a weight-average molecular weight of 750. The weight measurements of the solvents, the metal sources, and the polymer used in this example are also presented in Fig. 32. The metal oxide content and the raw-material-derived carboxylic acid content in the total amount of the raw materials calculated for this example in the same way as in Example 2-1 were 20.9% by mass and 44.1 % by mass, respectively.

Example 2-21

The PZT precursor solution was obtained in the same way as in Example 2-13 except that the polymeric component consisted of 6.8 g of a polypropylene glycol with a weight-average molecular weight of 400. The weight measurements of the solvents, the metal sources, and the polymer used in this example are also presented in Fig. 32. The metal oxide content and the raw-material-derived carboxylic acid content in the total amount of the raw materials calculated for this example in the same way as in Example 2-1 were 20.9% by mass and 44.1% by mass, respectively.

Example 2-22

The PZT precursor solution was obtained in the same way as in Example 2-13 except that the polymeric component consisted of 6.8 g of a polypropylene glycol with a weight-average molecular weight of 700. The weight measurements of the solvents, the metal sources, and the polymer used in this example are also presented in Fig. 32. The metal oxide content and the raw-material-derived carboxylic acid content in the total amount of the raw materials calculated for this example in the same way as in Example 2-1 were 20.9% by mass and 44.1% by mass, respectively.

Example 2-23

The PZT precursor solution was obtained in the same way as in Example 2-13 except that the polymeric component consisted of 1.7 g of a polyethylene glycol with a weight-average molecular weight of 400, 1.7 g of a polyethylene glycol with a weight-average molecular weight of 600, 1.7 g of a polyethylene glycol monomethyl ether with a weight-average molecular weight of 550, and 1.7 g of a polypropylene glycol with a weight-average molecular weight of 700. The weight measurements of the solvents, the metal sources, and the polymers used in this example are also presented in Fig. 32. The metal oxide content and the raw-material-derived carboxylic acid content in the total amount of the raw materials calculated for this example in the same way as in Example 2-1 were 20.9% by mass and 44.1% by mass, respectively. Film-Formation Cycle

The PZT precursor solutions of Examples 2-13 to 2-23 were used to form PZT films. More specifically, each PZT precursor solution was used on the next day of preparation to form a laminate consisting of six PZT films. To do this, the same film-formation cycle (the application, drying, defatting, and sintering stages) as that used for Example 2-1 was repeated six times with the PZT precursor solution. Before the time of use, the PZT precursor solution was put into a glass bottle with a cap and stored in a dark place at room temperature, or at around 25˚C.

Crack Resistance Test

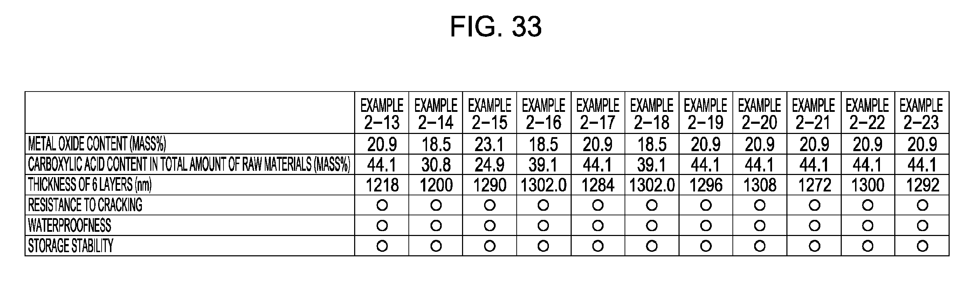

The laminates of PZT films formed with the PZT precursor solutions of Examples 2-13 to 2-23 were observed under a metallographic microscope for any cracks, and the resistance of each laminate to cracking was evaluated in accordance with the following criteria: Pass (O)—No cracks found; Fail (×)—Any cracks found. The laminates were then analyzed in a scanning electron microscope (Hitachi S-4700) and the cross-sectional images were used to determine their thicknesses. The obtained results are summarized in Fig. 33.

Waterproofness Test

The PZT precursor solutions of Examples 2-13 to 2-23 were tested for waterproofness in the same way and in accordance with the same criteria as those used for Example 2-1. The obtained test results are summarized in Fig. 33.

Storage Stability Test

The PZT precursor solutions of Examples 2-13 to 2-23 were then tested for storage stability in the same way and in accordance with the same criteria as those used for Example 2-1. The obtained test results are summarized in Fig. 33.

As demonstrated by the results presented in Fig. 33, the PZT precursor solutions of Examples 2-13 to 2-23 were all capable of producing a laminate of PZT films with a total thickness of over 1 $\mu$m with no cracks found in it. Furthermore, all of these PZT precursor solutions passed both the waterproofness test and the storage stability test.

Manufacturing of Ink Jet Recording Heads

The PZT precursor solutions of Examples 2-1 to 2-23 and Comparative Example 2-2 were used to manufacture ink jet recording heads in accordance with the above-described manufacturing process of an ink jet recording head.

For Examples 2-1 to 2-13, the PZT precursor solutions was used on the next day of preparation to form a piezoelectric layer 70 having a thickness of 1.2 $\mu$m. To do this, the above-described film-formation cycle (the application, drying, defatting, and sintering stages) was repeated six times with the PZT precursor solution. (Each PZT precursor solution was applied with the spinning speed adjusted so that the thickness of every film should be 200 nm.)

As for Comparative Example 2-2, although the PZT precursor solution was also used on the next day of preparation to form a piezoelectric layer 70 having a thickness of 1.2 $\mu$m, it was required to repeat the same film-formation cycle 12 times to achieve this thickness (the spinning speed was 1500 rpm). This means that to produce the piezoelectric layer 70 of a certain thickness, the PZT precursor solution according to this embodiment requires only half the number of film-formation cycles needed with the PZT precursor solution of Comparative Example 2-2.

The obtained piezoelectric layers 70 were subjected to the determination of crystallinity (measurement of θ/2θ in an X-ray diffractometer), the evaluation of hysteresis properties by the virtual ground method, the assessment of piezoelectric properties with a laser Doppler vibrometer (measurement of the amount of displacement), a pulse durability test (the percent reduction of displacements after 20 billion pulses from the baseline), and some other tests. The results for the piezoelectric layers 70 formed with the precursor solutions of Examples 2-1 to 2-23 were equivalent to those with the piezoelectric layer 70 formed with the precursor solution of Comparative Example 2-2.

The word *equivalent* as used herein means that the numerical results normalized with those for the piezoelectric body formed with the precursor solution of Comparative Example 2-2 as 100 all fell within a range of 95 to 105. The numerical results considered were as follows: the peak intensity corresponding to the (100) plane and the percentage of orientation along the (100) plane in the crystallinity determination; maximum polarization, remnant polarization, and coercivity in the hysteresis evaluation; the amount of displacement in piezoelectric properties; and the percent reduction of displacements in the pulse durability test.

Embodiment 3

Precursor Solution for Piezoelectric Films

The following describes the piezoelectric film precursor solution according to Embodiment 3 by explaining the differences from the above-described embodiments. The drawings used to illustrate Embodiment 1 will be mentioned as necessary. The elements already explained in Embodiment 1 are given the same numerals as in these drawings, and the explanations thereof will not be repeated.

In the piezoelectric film precursor solution according to Embodiment 3, at least 90% of the molecules coordinating to the metal or metals contained in the solution (the ligands of the metal complex or complexes) are of the same kind. Examples of the composite oxide produced include lead zirconate titanate (Pb(Zr,Ti)$O_3$, PZT), lead zirconate titanate niobate (Pb(Zr,Ti,Nb)$O_3$, PZTN), and other perovskite composite oxides based on PZT. The kind of the composite oxide to be produced with the precursor solution according to Embodiment 3 is not particularly limited as long as it has piezoelectric properties; it may be any lead-based composite oxide, i.e., a composite oxide containing lead like those listed above, or any non-lead composite oxide, i.e., a composite oxide free of lead like bismuth ferrite (BiFeO$_3$, BFO).

Examples of the solvents that can be used to prepare the piezoelectric film precursor solution according to Embodiment 3 include carboxylic acids and organic solvents. The carboxylic acids that can be used for this purpose include acetic acid, propionic acid, and octylic acid (caprylic acid), although not particularly limited to these. The organic solvents that can be used for this purpose include such alcohols, ethers, esters, glycol derivatives, and ketones as those listed in Embodiment 1 as well as aromatic hydrocarbons and aliphatic hydrocarbons, although not particularly limited to these.

The organic metal compounds used to prepare the piezoelectric film precursor solution according to Embodiment 3 are appropriately determined depending on the metal elements contained in the composite oxide intended to be produced. For example, when the piezoelectric film precursor solution is one for producing a PZT-based composite oxide containing titanium, zirconium, and lead by the sol-gel process, the organic metal compounds added to prepare the precursor solution are a titanium compound, a zirconium compound, and a lead compound.

The titanium-based organic metal compound may be a pure substance of or a mixture of two or more of such titanium alkoxides as those listed in Embodiment 1.

The zirconium-based organic metal compound may be a pure substance of or a mixture of two or more of such zirconium alkoxides as those listed in Embodiment 1. Solutions of such zirconium alkoxides in butanol or other alcohols can also be used instead.

The lead compound can be, for example, lead (II) acetate trihydrate, lead (IV) acetate trihydrate, or lead nitrate and is preferably lead (II) acetate trihydrate because of its ease of handling.

Regarding the molar ratios between the lead compound, the zirconium compound, and the titanium compound, it is preferred for better piezoelectric properties of the resulting piezoelectric films 72 to adjust their amounts to meet the following relation, as mentioned in Embodiment 1: Pb:Zr:Ti = 1.05 to 1.25:0.46 to 0.56:0.44 to 0.54 (molar ratios).

As already mentioned, in the piezoelectric film precursor solution according to Embodiment 3 at least 90% of the molecules coordinating to the metal or metals contained in the solution are of the same kind. In other words, the primary one of the ligands of the metal compound or compounds (metal complex or complexes) contained in the precursor solution, or the most abundant coordinating molecules, accounts for a share equal to or greater than 90%. This increases the simplicity of the kinds of the metal-centered ligands involved and thereby, at the heat treatment stages (drying, defatting, etc.) in the production process of the composite oxide, serves to narrow the temperature range in which the thermal decomposition reactions relevant to the precursor solution can occur. In other words, the use of the piezoelectric film precursor solution according to Embodiment 3 allows a broader temperature margin for the heat treatment operations involved in the production process of the piezoelectric layer 70. As a result, the piezoelectric layer 70 formed with this precursor solution by a liquid-phase method have an improved in-plane uniformity in piezoelectric properties.

The kind of the primary ligand of the piezoelectric film precursor solution according to Embodiment 3 is not particularly limited and is appropriately determined depending on the kinds and amounts of the solvent and organic compounds used. Examples of the primary ligand include acetic acid anions, butoxyethoxy groups, 2-ethylhexyl groups, diethanolamino groups, methoxyethoxy groups, and acetylacetonate anions. The use of a ligand having a shorter side chain, such as acetic acid anions, reduces the temperature requirement for the heat treatment operations involved in the production process of the piezoelectric layer 70.

The piezoelectric film precursor solution according to Embodiment 3 may further contain water to make 10% by mass or more of the solvent component mentioned above. In general, the addition of a titanium compound or a zirconium compound can cause the formation of a precipitate (e.g., zirconium oxyacetate). Adding water to the piezoelectric film precursor solution according to Embodiment 3 to make 10% by mass or more of the solvent component renders the precursor solution a better solvent for the solutes and thereby reduces the amount of precipitate formation.

Furthermore, the piezoelectric film precursor solution according to Embodiment 3 may further contain a polymeric component. The polymeric component may consist of a polyethylene glycol. By doing so the viscosity of the solution can be adjusted, and the quality of the resulting piezoelectric films 72 can be improved.

The preparation method (manufacturing method) of the piezoelectric film precursor solution according to Embodiment 3 is not particularly limited as long as at least 90% of the molecules coordinating to the metal or metals contained in the solution (the ligands of the metal complex or complexes) are of the same kind. By way of example, the following describes a method for manufacturing a precursor solution for the production of a PZT-based composite oxide by the sol-gel process.

This manufacturing method of the piezoelectric film precursor solution according to Embodiment 3 includes preparing a solvent component and adding organic compounds (or an organic compound) as metal sources (or a metal source) to the solvent component. In the case of preparing a precursor solution for a PZT-based composite oxide, for example, the addition of organic compounds as metal sources to the solvent component includes adding a titanium compound, adding a zirconium compound, and adding a lead compound.

The order of these stages for adding the metal sources is not particularly limited. For example, in a possible process, the titanium compound and the zirconium compound are first added to the solvent component, then the mixture is stirred at room temperature, the lead compound is added, and the resulting mixture is heated and stirred. This heating and stirring operation can be performed by, for example, stirring the mixture in an oil bath at a temperature of 30˚C to 120˚C, both inclusive, for a period equal to or longer than 30 minutes. Although there is no particular upper limit regarding the heating and stirring time, it may be specified that, for example, it should not exceed 300 minutes. This allows the solvent and the metal sources (the titanium compound, the zirconium compound, and the lead compound) to undergo ligand exchange, and thereby the precursor solution containing the metal compounds (metal complexes) is obtained. The heating and stirring operation may be followed by another stirring operation at room temperature. It is also allowed to omit the heating and stirring operation and carry out all the stirring operations at room temperature.

If water is added to make 10% by mass or more of the solvent component, this operation can be performed at any time during the course of this manufacturing method. Preferably, however, it is conducted after the addition of the titanium compound and the addition of the zirconium compound, but before the addition of the lead compound. This makes it more certain that the amount of precipitate formation is reduced. In summary, the addition of a titanium compound or a zirconium compound can generally cause the formation of a precipitate (*e.g.,* zirconium oxyacetate), but the piezoelectric film precursor solution according to Embodiment 3 contains water to be a better solvent for the solutes existing therein and thus is less likely to form a precipitate. Incidentally, the addition of water is not necessarily a one-time operation; it may be repeated two or more times until the total amount of water reaches 10% by mass or more of the solvent component.

Furthermore, a polymeric component such as a polyethylene glycol may be added after the addition of water. By doing so the viscosity of the solution can be adjusted, and the quality of the resulting piezoelectric films 72 can be improved. The addition of a polymeric component is not necessarily a one-time operation and can be repeated two or more times. In this way, the piezoelectric film precursor solution according to Embodiment 3 is constituted.

In the piezoelectric film precursor solution according to Embodiment 3, at least 90% of the coordinating molecules of the metal compound or compounds contained in the precursor solution are of the same kind. In general, different kinds of metal-centered ligands in a precursor solution are dissociated by thermal decomposition reaction in different temperature ranges. This means that the precursor solution with increased simplicity of the kinds of ligands like the piezoelectric film precursor solution according to Embodiment 3 undergoes thermal decomposition reactions in a narrowed temperature range at the heat treatment stages (drying, defatting, *etc.*) in the production process of the composite oxide therefrom. In other words, the temperature range in which the thermal decomposition reactions at the heat treatment stages (drying, defatting, *etc.*) can be induced without fail is narrowed and limited, and thus the temperature margin for heat treatment is broadened. This makes it more certain that in the coating of the precursor solution made on the flow channel substrate wafer 110 (the lower electrode 60) such thermal decomposition reactions as solvent evaporation and ligand decomposition can be induced within a reduced temperature range. As a result, the individual differences in thermal reaction temperature between the in-plane regions are corrected, and the obtained piezoelectric layer 70 is of improved in-plane uniformity in piezoelectric properties.

When the precursor solution contains multiple organic compounds as solutes that provide ligands, furthermore, thermal decomposition reactions can occur in a broader temperature range, and this has a great influence on the quality consistency of the finished products. However, the piezoelectric film precursor solution according to Embodiment 3 contributes to improved reliability of piezoelectric elements by reducing the in-plane variations in piezoelectric properties, which would be significant if the resulting composite oxide contained more kinds of metals.

Furthermore, the in-plane variations in piezoelectric properties associated with an increased area of the substrate size are also reduced. This leads to an improved productivity of piezoelectric elements and a reduced manufacturing cost.

The following examples illustrate the piezoelectric film precursor solution according to Embodiment 3 in more detail. Examples 3-1 to 3-4 illustrate PZT films and PZT precursor solutions as examples of the piezoelectric films 72 and the precursor solution, respectively. Example 3-5 illustrates precursor film and the precursor solution as examples of the precursor film and the precursor solutions containing Ba, Mn and Bi instead of Pb and Zr. Note that these examples should not be construed as limiting the scope of any aspect of the invention.

Preparation of Piezoelectric Solutions

Example 3-1

Acetic acid was prepared as the solvent component. To this, titanium tetraisopropoxide (the Ti source) was added, and then a n-butanol solution of zirconium tetra-n-butoxide (the Zr source) was added. The obtained mixture was stirred at room temperature for a period of 30 to 60 minutes. Subsequently, purified water (25% by mass relative to the solvent component) was added, and the obtained mixture was stirred at room temperature. Polyethylene glycol was then added, and the obtained mixture was stirred. To the stirred mixture lead (II) acetate trihydrate (the Pb source) was added, and the obtained mixture was heated and stirred at a temperature of 50 to 90˚C for a period of 60 to 90 minutes. In this way, the PZT precursor solution was prepared.

Example 3-2

Acetic acid was prepared as the solvent component. To this, titanium tetraisopropoxide (the Ti source) was added, and then zirconium tetraisopropoxide (the Zr source) was added. The obtained mixture was stirred at room temperature for a period of 30 to 60 minutes. Subsequently, purified water (25% by mass relative to the solvent component) was added, and the obtained mixture was stirred at room temperature. Lead (II) acetate (the Pb source) and purified water three times as much as the lead (II) acetate on a molar ratio basis were then added, and the obtained mixture was stirred at room temperature for a period of 30 to 60 minutes. In this way, the PZT precursor solution was prepared.

Example 3-3

2-n-Butoxiethanol was prepared as the solvent component, titanium tetraisopropoxide (the Ti source) was added, and then zirconium tetraisopropoxide (the Zr source) was added. The obtained mixture was heated and stirred at a temperature of 50 to 90˚C for a period of 2 to 5 hours. Subsequently, isopropanol was removed by distillation under reduced pressure with the heating temperature maintained. Lead (II) 2-n-butoxyethoxide (the Pb source) was then added, and the obtained mixture was stirred at room temperature for a period of 2 to 5 hours. To the stirred mixture 2-n-butoxyethanol was added to adjust the concentration. In this way, the PZT precursor solution was prepared.

Example 3-4

2-n-Butoxiethanol was prepared as the solvent component, titanium tetraisopropoxide (the Ti source) was added, then zirconium tetraisopropoxide (the Zr source) was added, and immediately lead (II) 2-n-butoxyethoxide (the Pb source) was added. The obtained mixture was stirred at a temperature of 50 to 90˚C for a period of 30 minutes to 2 hours. To the stirred mixture 2-n-butoxyethanol was added to adjust the concentration. In this way, the PZT precursor solution was prepared.

Example 3-5

2-Ethylhexanoic acid and n-octane were prepared as the solvent component. To this, titanium tetraisopropoxide (the Ti source) was added, and then iron (II) acetate, barium acetate, and manganese acetate were added. The obtained mixture was stirred at room temperature for a period of 30 to 60 minutes. To the stirred mixture bismuth acetate was added, and the obtained mixture was heated and stirred at a temperature of 50 to 90˚C for a period of 60 to 90 minutes. In this way, a BiFeMn-BaTi precursor solution (hereinafter referred to as the BFM-BT precursor solution) was prepared.

Comparative Example 3-1

2-n-Butoxiethanol and diethanolamine were prepared as the solvent component. To this, titanium tetraisopropoxide (the Ti source) was added, and the obtained mixture was stirred at room temperature for a period of 60 to 90 minutes. Lead (II) acetate trihydrate (the Pb source) and zirconium acetylacetonate (the Zr source) were then added, and the obtained mixture was heated and stirred at a temperature of 50 to 90˚C for a period of 2 to 5 hours. Subsequently, polyethylene glycol was added, and the obtained mixture was stirred at room temperature for a period of 60 to 90 minutes. In this way, a PZT precursor solution was prepared. Proportion of Primary Ligand in Each Precursor Solution

For each of the precursor solutions of Examples 3-1 to 3-5 and Comparative Example 3-1, the proportions of the individual metal-centered ligands contained in the solution (more specifically, the number of molecules of the primary ligand relative to the total number of all coordinating molecules) was calculated in the following way.

From each of the precursor solutions of Examples 3-1 to 3-5 and Comparative Example 3-1, as much of the solvent component as possible was removed by distillation under reduced pressure using Edwards RV3F rotary pump (lowest possible vacuum: 0.2 Pa). The residue was dissolved in DMSO-d6, the solution was subjected to $^1$H-NMR measurement on Varian 500NB FT-NMR system, and the integration ratios of the observed peaks were used to calculate the proportions of the individual metal-centered ligands contained in the solution. The computation of the integration ratios of peaks was carried out by SpecManager (available from ACD, Inc.). The solvent or solvents were distinguished from the metal-centered ligands on the basis of the chemical shifts of their peaks and the integration ratio of the peak corresponding to OH groups.

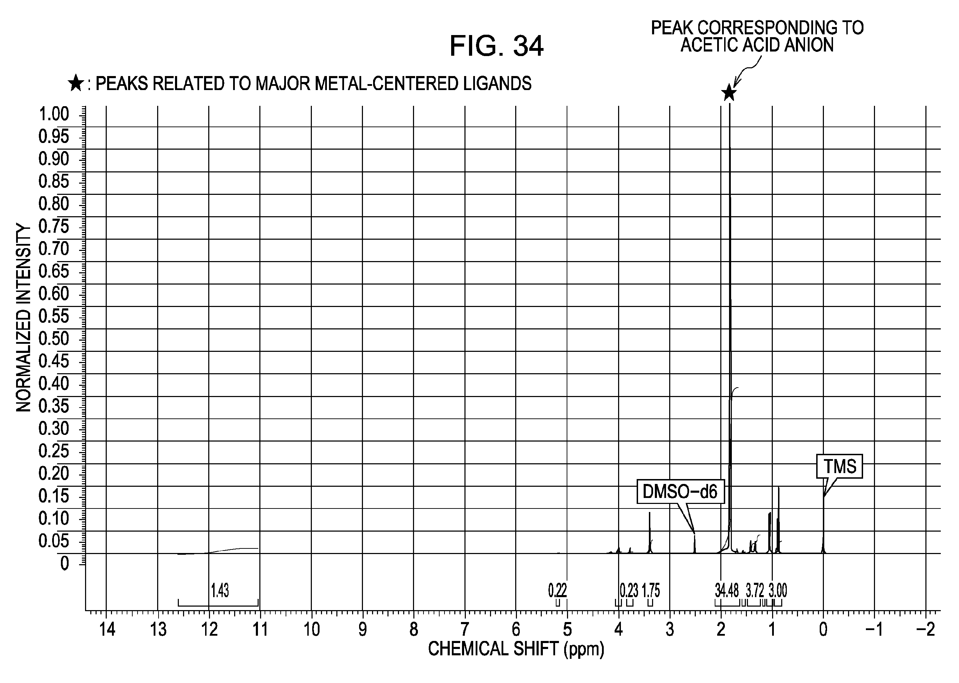

Figs. 34 to 39 are $^1$H-NMR spectra obtained for Examples 3-1 to 3-5 and Comparative Example 3-1.

Fig. 34 presents a $^1$H-NMR spectrum of the precursor solution prepared in Example 3-1. As shown in Fig. 34, acetic acid anions, butoxy groups, and isopropoxy groups were detected, and the molar ratios between the individual metal-centered ligands calculated from the integration ratios of peaks were as follows: acetic acid anions:butoxy groups: isopropoxy groups = 916:15:1. In the precursor solution of Example 3-1, therefore, 98% of the molecules coordinating to the contained metal elements were acetic acid anions.

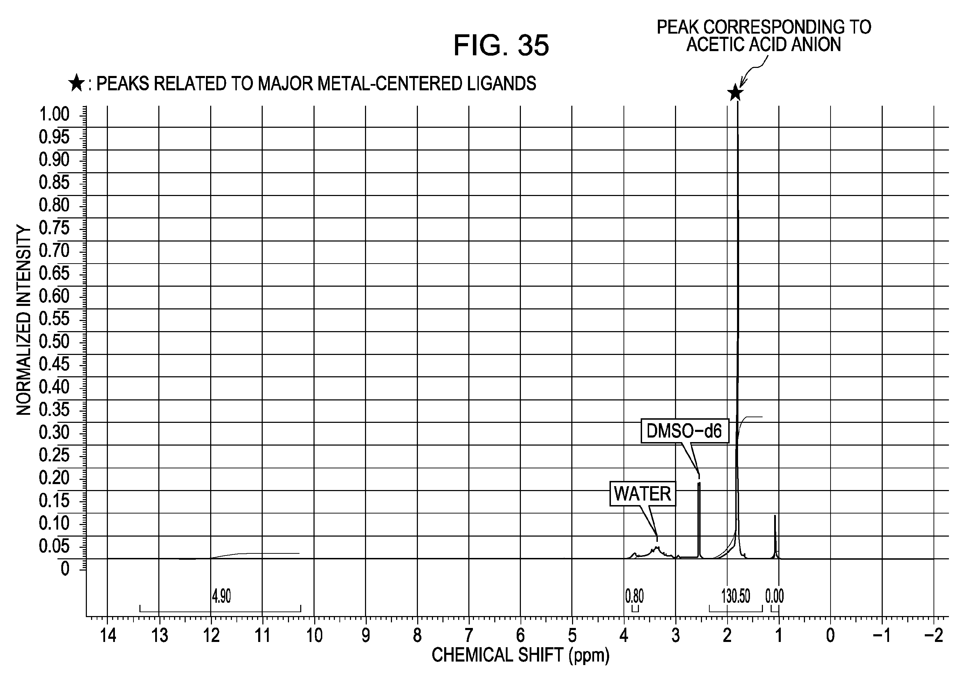

Fig. 35 presents a $^1$H-NMR spectrum of the precursor solution prepared in Example 3-2. As shown in Fig. 35, acetic acid anions and isopropoxy groups were detected, and the molar ratio between the metal-centered ligands calculated from the integration ratios of peaks were as follows: acetic acid anions:isopropoxy groups = 39:1. In the precursor solution of Example 3-2, therefore, the proportion of the primary metal-centered ligand, acetic acid anions, was 97%.

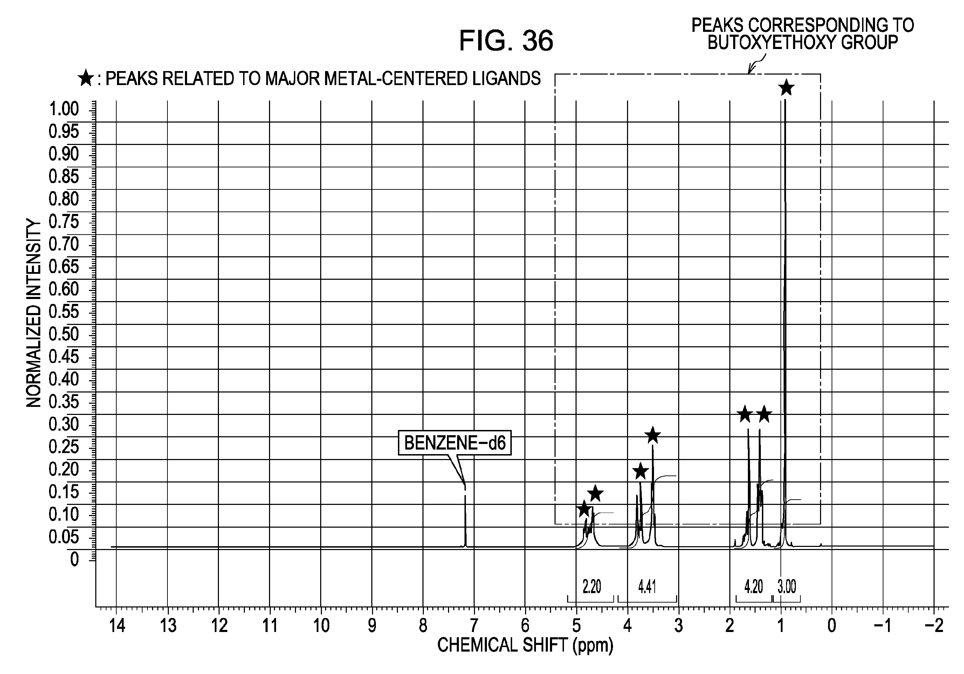

Fig. 36 presents a $^1$H-NMR spectrum of the precursor solution prepared in Example 3-3. As shown in Fig. 36, the butoxyethoxy group was the only ligand detected. In the precursor solution of Example 3-3, therefore, the proportion of the primary metal-centered ligand, butoxyethoxy groups, was 100%.

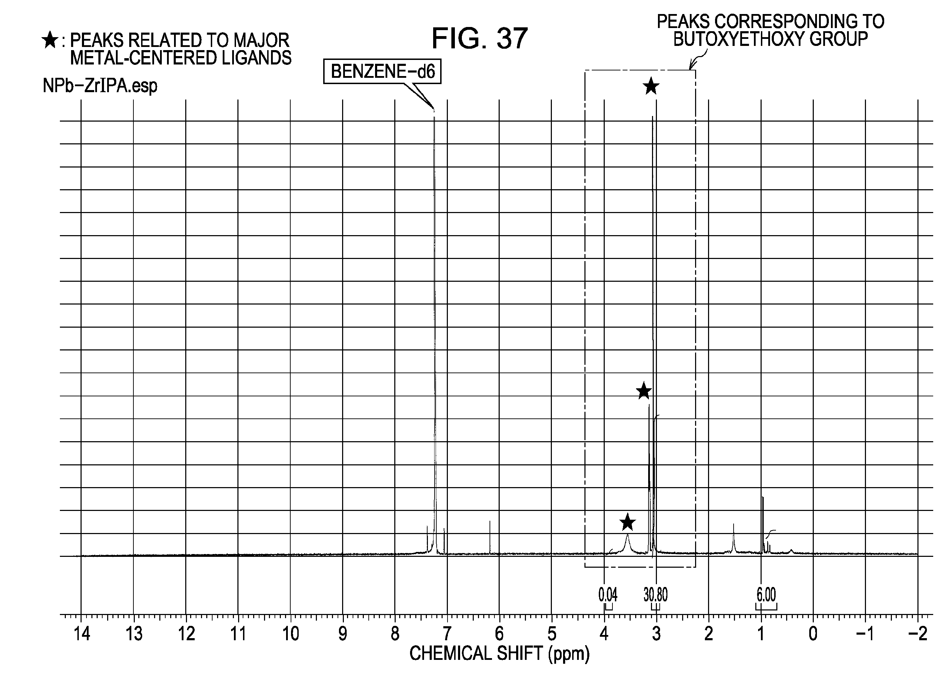

Fig. 37 presents a $^1$H-NMR spectrum of the precursor solution prepared in Example 3-4. As shown in Fig. 37, butoxyethoxy groups and isopropoxy groups were detected, and the molar ratio between the metal-centered ligands calculated from the integration ratios of peaks were as follows: butoxyethoxy groups:isopropoxy groups = 10:1. In the precursor solution of Example 3-4, therefore, the proportion of the primary metal-centered ligand, butoxyethoxy groups, was 91 %.

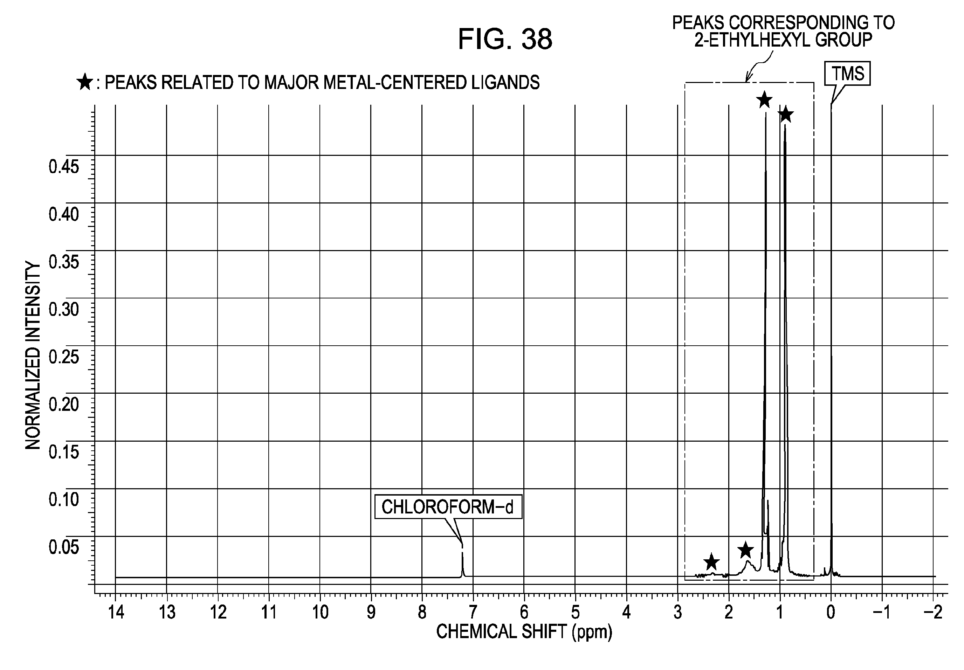

Fig. 38 presents a $^1$H-NMR spectrum of the precursor solution prepared in Example 3-5. As shown in Fig. 38, the 2-ethylhexyl group was the only ligand detected. In the precursor solution of Example 3-5, therefore, the proportion of the primary metal-centered ligand, 2-ethylhexyl groups, was 100%.

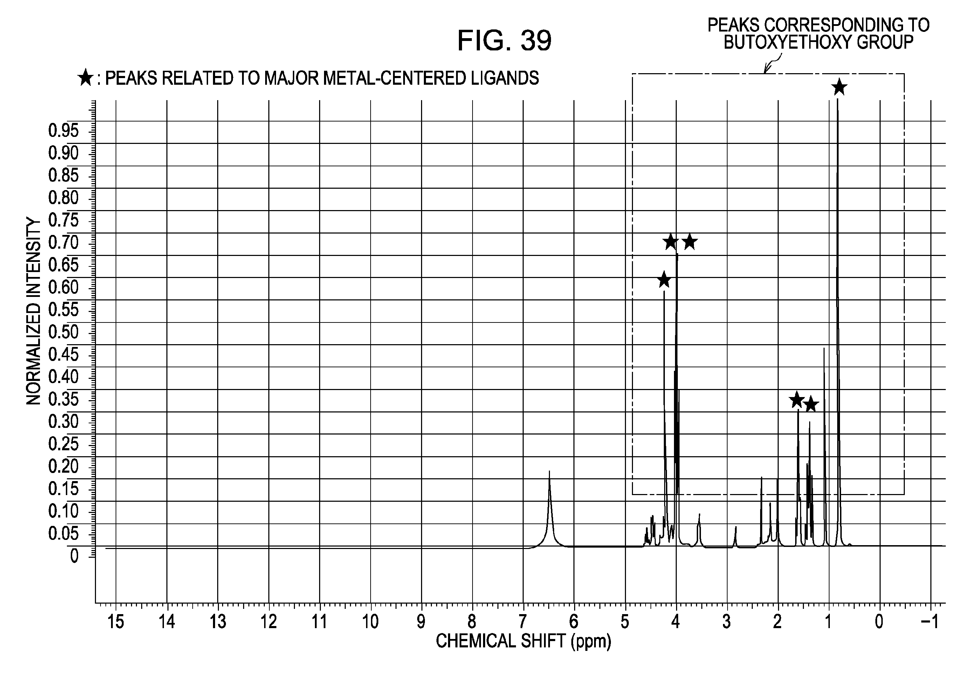

Fig. 39 presents a $^1$H-NMR spectrum of the precursor solution prepared in Comparative Example 3-1. As shown in Fig. 39, butoxyethoxy groups, isopropoxy groups, diethanolamino groups, and acetylacetonate anions were detected, and the molar ratios between the individual metal-centered ligands calculated from the integration ratios of peaks were as follows: butoxyethoxy groups:isopropoxy groups:diethanolamino groups:acetylacetonate anions = 100: 20:49:18. In the precursor solution of Comparative Example 3-1, therefore, the proportion of the primary metal-centered ligand, butoxyethoxy groups, was 53%.

The Number of Kinds of Ligands Desorbed

The precursor solutions of Examples 3-1 to 3-5 and Comparative Example 3-1 were subjected to an elemental analysis based on desorbed gas in a temperature range from room temperature to 750˚C. For Examples 3-1 to 3-5 and Comparative Example 3-1, Table 1 summarizes the primary metal-centered ligand and its proportion as well as the number of kinds of the metal-centered ligands desorbed at temperatures of 200˚C and above.

Table 1

| | Primary metal-centered ligand and its proportion (%) | | No. of kinds of metal-centered ligands desorbed at ≥200˚C |
|---|---|---|---|
| Example 3-1 | Acetic acid anions | 98 | 1 |
| Example 3-2 | Acetic acid anions | 97 | 1 |
| Example 3-3 | Butoxyethoxy groups | 100 | 1 |
| Example 3-4 | Butoxyethoxy groups | 91 | 1 |
| Example 3-5 | 2-Ethylhexyl groups | 100 | 1 |
| Comparative Example 3-1 | Butoxyethoxy groups | 53 | 3 |

As shown in Table 1, in Examples 3-1 to 3-5, in which the proportion of the primary metal-centered ligand was over 90%, only one kind of metal-centered ligand was desorbed at temperatures of 200˚C and above. In Comparative Example 3-1, in which the proportion of the primary metal-centered ligand was 53%, however, three kinds of metal-centered ligands were desorbed at temperatures of 200˚C and above.

This means that in Examples 3-1 to 3-5, the simplicity of the kinds of the metal-centered ligands involved was high (or there was only one kind of metal-centered ligand present), and thus only the primary ligand was evaporated/ dissociated in the temperature range for defatting (200 to 400˚C). In Comparative Example 3-1, however, the simplicity of the kinds of the metal-centered ligands was low, and thus several kinds of ligands were evaporated/dissociated in the temperature range for defatting (200 to 400˚C).

In-plane Uniformity in Piezoelectric Properties

The precursor solution of Example 3-1 and that of Comparative Example 3-1 were used to form piezoelectric films, and their in-plane uniformity of piezoelectric properties was measured.

Each of the precursor solutions of Example 3-1 and Comparative Example 3-1 was applied to a substrate having a lower electrode 60 made of Pt (thickness: approximately 170 nm). The substrate was then heated at a temperature of 100 to 200°C (a temperature higher than the boiling point of the primary solvent) and maintained at that temperature for a period of 3 to 30 minutes (the drying stage). Subsequently, the substrate was heated to a temperature of 250 to 420°C and maintained at that temperature for a period of 3 to 30 minutes (the defatting stage). Each defatted film was heated to a temperature of 550 to 800°C and maintained at that temperature for a period of 5 to 30 minutes so it was crystallized (the sintering stage). These drying, defatting, and sintering stages were repeated several times, and thereby PZT laminates each consisting of a total of 12 layers were formed. Each PZT laminate had a thickness of approximately 1.0 μm.

After the last sintering stage, each PZT laminate was subjected to XRD analysis in PANalytical's XRD system X'Pert Pro MPD. The obtained diffraction pattern was used to determine the full width at half maximum of the peak corresponding to the (100) plane. For the precursor solution of Example 3-1, five different defatting temperatures (300°C, 350°C, 370°C, 400°C, and 420°C) were used, and the full width at half maximum of that peak was measured with each resulting PZT laminate. For the precursor solution of Comparative Example 3-1, four different defatting temperatures (250°C, 280°C, 340°C, and 400°C) were used, and the full width at half maximum of that peak (crystallinity) was measured with each resulting PZT laminate.

Subsequently, each PZT laminate was covered with an upper electrode 80 made of Ir (thickness: approximately 100 nm) by sputtering, and thereby piezoelectric elements 300 were obtained. The piezoelectric elements 300 were then subjected to the measurement of the piezoelectric displacement in the wafer plane with aixACCT's double-beam laser interferometer. The conditions of the piezoelectric displacement measurement were as follows: 1 kHz, ±25 V, triangle waves, and 300 pulses. In each sample, the piezoelectric displacement of the piezoelectric elements 300 in the wafer plane was determined by measuring it at 40 equally spaced points in the Wf plane.

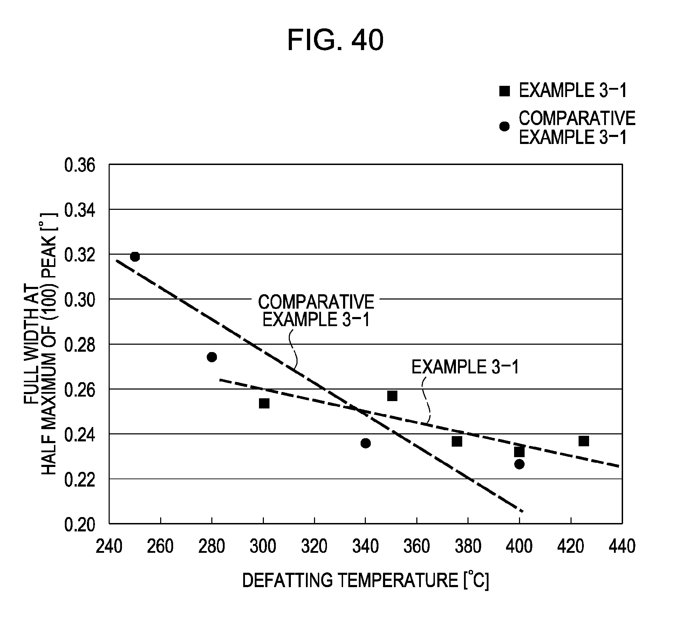

For the precursor solutions of Example 3-1 and Comparative Example 3-1, Fig. 40 shows the measurements of the full width at half maximum of the target peak plotted against the above-listed defatting temperatures used to form PZT laminates. As can be seen from Fig. 40, the change in the full width at half maximum of the target peak for a given change in defatting temperature (the slope) in Example 3-1 was smaller than that in Comparative Example 3-1. This result indicates that even when the defatting temperature varies, the variations in the degree of crystallinity among the resulting piezoelectric films 72 can be reduced by the use of the piezoelectric solution of Example 3-1.

Furthermore, the piezoelectric displacement measurement revealed that the proportion of the piezoelectric elements the amount of displacement of which was within ±2% from the average was 76% among those formed with the precursor solution of Comparative Example 3-1, and 82% among those formed with the precursor solution of Example 3-1. This result indicates that even when the defatting temperature varies, the variations in displacement properties among the resulting piezoelectric films 72 can be reduced by the use of the piezoelectric solution of Example 3-1.

Embodiment 4

Method for Manufacturing a Precursor Solution for Piezoelectric Films

The following describes the method for manufacturing a precursor solution for piezoelectric films according to Embodiment 4. Embodiment 4 can be suitably used to produce the piezoelectric film precursor solutions according to the above embodiments.

The piezoelectric film precursor solution obtained by the manufacturing method according to Embodiment 4 is one for producing a PZT-based composite oxide or any other similar composite oxide by a liquid-phase method. The kind of the composite oxide to be produced is not particularly limited as long as it has piezoelectric properties; it may be any lead-based composite oxide, i.e., a composite oxide containing lead like those listed above, or any non-lead composite oxide, i.e., a composite oxide free of lead.

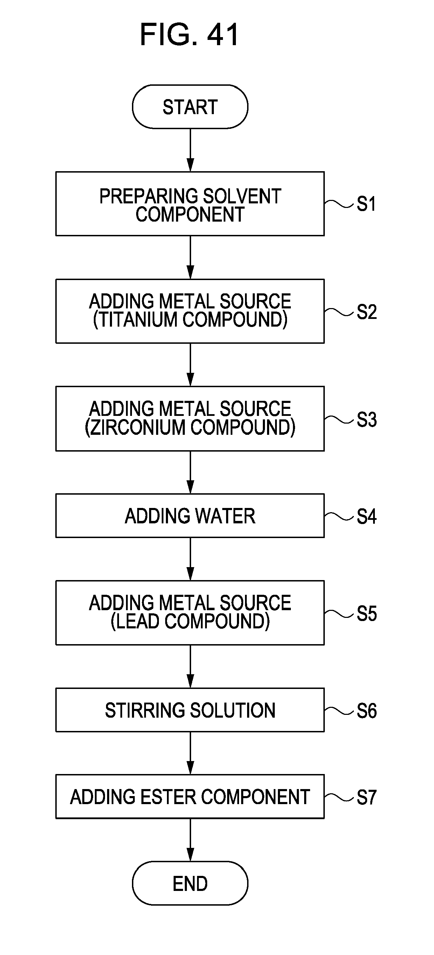

Fig. 41 is a flow chart illustrating the method for manufacturing a precursor solution for piezoelectric films according to Embodiment 4. The method for manufacturing a piezoelectric solution for piezoelectric films according to Embodiment 4 includes, as outlined in Fig. 41, preparing a solvent component (Stage S1), adding metal sources (Stages S2, S3, and S5), and adding water (Stage S4). Besides these stages, the method for manufacturing a piezoelectric solution for piezoelectric films according to Embodiment 4 can further include stirring the solution (Stage S6) and adding an ester component (Stage S7).

By way of example, the following describes a manufacturing method of a piezoelectric film precursor solution for producing a PZT-based composite oxide by the sol-gel process. In the manufacturing method of a piezoelectric film precursor solution for producing a PZT-based composite oxide the stages of adding metal sources can include, as outlined in Fig. 41, adding a titanium compound (Stage S2), adding a zirconium compound (Stage S3), and adding a lead compound (Stage S5). The individual stages are described below.

At Stage S1, a solvent component is prepared. Examples of the solvents that can be used at this stage include acetic acid, propionic acid, and other carboxylic acids. The use of a carboxylic acid in the solvent component allows the precursor solution obtained by this embodiment to contain an acid.

At Stage S2, a titanium compound is added to the solvent component to yield a first solution. This titanium compound can be, for example, one that produces an alcohol by ligand exchange at the stage of stirring the solution. Examples of titanium compounds of this type include such titanium alkoxides as those listed in Embodiment 1, and these titanium alkoxides may be used as a pure substance or as a mixture.

At Stage S3, a zirconium compound is added to the first solution to yield a second solution. This zirconium compound can be, for example, one that produces an alcohol by ligand exchange at the stage of stirring the solution. Examples of zirconium compounds of this type include such zirconium alkoxides as those listed in Embodiment 1, and these zirconium alkoxides may be used as a pure substance or as a mixture. Solutions of such zirconium alkoxides in butanol or other alcohols can also be used instead.

At Stage S4, water (purified water) is added to the second solution to yield a third solution. The amount of water added is at least 20% by mass of the solvent component. This formulation reduces the potential of the piezoelectric film precursor solution obtained by Embodiment 4 for esterification reaction and thereby enhances the stability of the precursor solution, for the reasons explained in Embodiment 1 using Formula (1).

The method for manufacturing a precursor solution for piezoelectric films according to Embodiment 4 includes adding water to make at least 20% by mass of the solvent component in the course of preparing the solution, and thereby prevents the equilibrium reaction of Formula (1) from proceeding to the right side. In other words, the potential for esterification reaction is reduced. This makes the piezoelectric film precursor solution obtained by Embodiment 4 less likely to undergo ester formation after preparation and thus less likely to change its viscosity after preparation. As a result, the piezoelectric film precursor solution obtained by Embodiment 4 is highly stable.

The amount of water added is preferably in a range of 20% by mass to 50% by mass, both inclusive, of the solvent component. Adding water in an amount less than 20% by mass may result in an incomplete inhibition of the esterification reaction of Formula (1), whereas adding water in an amount exceeding 50% by mass may lead to a reduced viscosity of the precursor solution and thereby make it difficult to form piezoelectric films 72 with sufficiently large thicknesses.

Stage S4, the addition of water, can be performed at any time during the course of this manufacturing method. Preferably, however, Stage S4 is carried out after Stages S2 and S3, the addition of a titanium compound and the addition of a zirconium compound, but before Stage S5, the addition of a lead compound. This order serves to reduce the amount of precipitate formation. In summary, the addition of a titanium compound or a zirconium compound can generally cause the formation of a precipitate (e.g., zirconium oxyacetate), but the method for manufacturing a precursor solution for piezoelectric films according to Embodiment 4 includes adding water and thereby makes the precursor solution a better solvent for its solutes and less likely to form a precipitate.

Stage S4, the addition of water, is not necessarily a one-time operation; it may be repeated two or more times as long as the total amount of water added falls within the range specified above. Furthermore, a polymeric component such as a polyethylene glycol may be added after the addition of water. By doing so the viscosity of the solution can be adjusted.

At Stage S5, a lead compound is added to the third solution to yield a fourth solution. The lead compound can be, for example, lead (II) acetate trihydrate or lead (IV) acetate trihydrate and is preferably lead (II) acetate trihydrate because of its ease of handling.

Regarding the molar ratios between the above-mentioned lead, zirconium, and titanium compounds, it is preferred for better piezoelectric properties of the resulting piezoelectric films 72 to adjust their amounts to meet the following relation, as mentioned in Embodiment 1: Pb:Zr:Ti = 1.05 to 1.25:0.46 to 0.56:0.44 to 0.54 (molar ratios).

At Stage S6, the fourth solution is stirred. More specifically, the fourth solution is heated and stirred in an oil bath at a temperature of 25˚C to 120˚C, both inclusive, for at least 10 minutes. This makes the solvent or solvents and the metal sources (the titanium compound, the zirconium compound, and the lead compound) exchange their ligands, and thereby a precursor solution containing an acid component, an alcohol component, and metal compounds (metal complexes) is obtained. This heating and stirring operation may be followed by stirring at room temperature.

For example, when the solvent component consists of acetic acid, the acid component of the resulting precursor solution consists of acetic acid. For example, when the titanium compound is titanium tetraisopropoxide and the zirconium compound is a n-butanol solution of zirconium tetra-n-butoxide, the alcohol component of the resulting precursor solution consists of isopropanol and butanol. The metal compounds contained in the precursor solution are ones containing the metals constituting the intended composite oxide. When a PZT-based composite oxide is to be formed, therefore, the metal compounds are titanium-, zirconium-, and lead-containing complexes.

At Stage S7, an ester component is added to the stirred fourth solution to yield a fifth solution. The addition of an ester or esters makes it more certain that the equilibrium reaction of Formula (1) is prevented from proceeding to the right side. As a result, it becomes more certain that the solution is made less likely to change its viscosity after preparation.

The amount of the ester component added is preferably equal to or less than 30% by mass of the solvent component, for example. Adding an ester component in an amount exceeding 30% by mass may lead to a reduced viscosity of the precursor solution and thereby make it difficult to form sufficiently thick films. More preferably, the amount of the ester component added is in a range of 15% by mass to 30% by mass, both inclusive, because adding an ester component in an amount less than 15% by mass may result in an incomplete inhibition of the esterification reaction of Formula (1).

Examples of the esters that can be added at this stage include methyl acetate, ethyl acetate, isopropyl acetate, n-butyl acetate, ethyl propionate, n-ethyl butyrate, and ethylene glycol diacetate. However, it is preferable to add the ester or esters that are formed by the reaction between the acid component and the alcohol component of the stirred fourth solution. More specifically, when the acid component and the alcohol component of the fourth solution consist of acetic acid and isopropanol and butanol, respectively, the ester component added preferably consists of isopropyl acetate and butyl acetate.

Stage S7, the addition of an ester component, can be performed at any time during the course of this manufacturing method. The addition of an ester component is not necessarily a one-time operation; it may be repeated two or more times as long as the total amount of the ester component added falls within the range specified above.

The method for manufacturing a precursor solution for piezoelectric films according to Embodiment 4 produces a piezoelectric film precursor solution through these stages. The method for manufacturing a precursor solution for piezoelectric films according to Embodiment 4 can be suitably used to produce the piezoelectric film precursor solutions according to Embodiments 1, 2, and 3.

The method for manufacturing a precursor solution for piezoelectric films according to Embodiment 4 includes adding water to make at least 20% by mass of the solvent component (Stage S4). As a result, the equilibrium reaction of Formula (1) is prevented from proceeding to the right side. In other words, the potential for esterification reaction is reduced. In this way, the method for manufacturing a precursor solution for piezoelectric films according to Embodiment 4 makes the solution less likely to undergo ester formation after preparation and thus less likely to change its viscosity after preparation, and thereby yields a highly stable precursor solution. This high stability of the precursor solution produced by the method for manufacturing a precursor solution for piezoelectric films according to Embodiment 4 extends the life of the precursor solution, and the related cost is accordingly reduced.

Furthermore, the method for manufacturing a precursor solution for piezoelectric films can include adding an ester component (Stage S7). Adding this stage makes it more certain that the equilibrium reaction of Formula (1) is prevented from proceeding to the right side. Adding this stage therefore makes it more certain that the solution becomes less likely to change its viscosity after preparation.

In the method for manufacturing a precursor solution for piezoelectric films according to Embodiment 4, a possible position of the addition of water (Stage S4) is after the addition of a titanium compound (Stage S2) and the addition of a zirconium compound (Stage S3) and before the addition of a lead compound (Stage S5). This order serves to reduce the amount of precipitate formation. In summary, the addition of a titanium compound or a zirconium compound can generally cause the formation of a precipitate, but the method for manufacturing a precursor solution for piezoelectric films according to Embodiment 4 includes adding water and thereby makes the precursor solution a better solvent for its solutes and less likely to form a precipitate.

The following examples illustrate the method for manufacturing a precursor solution for piezoelectric films according to Embodiment 4 in more detail. Note that these examples should not be construed as limiting the scope of any aspect of the invention.

Preparation of Precursor Solutions

Example 4-1

To acetic acid as the solvent component, titanium tetraisopropoxide (the Ti source) was added, and then a n-butanol solution of zirconium tetra-n-butoxide (the Zr source) was added. The obtained mixture was stirred at room temperature. Subsequently, purified water was added to make 25% by mass of the solvent component, and the obtained mixture was stirred at room temperature. Polyethylene glycol was then added, and the obtained mixture was stirred. To the stirred mixture lead (II) acetate trihydrate (the Pb source) was added, and the obtained mixture was heated and stirred in an oil bath at 80˚C for 90 minutes. In this way, a PZT precursor solution was prepared.

Example 4-2

To acetic acid as the solvent component, titanium tetraisopropoxide (the Ti source) was added, and then a n-butanol solution of zirconium tetra-n-butoxide (the Zr source) was added. The obtained mixture was stirred at room temperature. Subsequently, purified water was added to make 20% by mass of the solvent component, and the obtained mixture was stirred at room temperature. Polyethylene glycol was then added, and the obtained mixture was stirred. To the stirred mixture lead (II) acetate trihydrate (the Pb source) was added, and the obtained mixture was heated and stirred in an oil bath at 80˚C for 90 minutes, and then stirred at room temperature for another 90 minutes. After that, butyl acetate was added to make 20% by mass of the solvent component, and the obtained mixture was stirred at room temperature for 30 minutes. In this way, a PZT precursor solution was prepared.

Comparative Example 4-1

To acetic acid as the solvent component, titanium tetraisopropoxide (the Ti source) was added, and then a n-butanol solution of zirconium tetra-n-butoxide (the Zr source) was added. The obtained mixture was stirred at room temperature. Subsequently, purified water was added to make 10% by mass of the solvent component, and the obtained mixture was stirred at room temperature. Polyethylene glycol was then added, and the obtained mixture was stirred. To the stirred mixture lead (II) acetate trihydrate (the Pb source) was added, and the obtained mixture was heated and stirred in an oil bath at 80˚C for 90 minutes. In this way, a PZT precursor solution was prepared.

Assessment of the Amount of Ester Formation

For each of the precursor solutions of Examples 4-1 and 4-2 and Comparative Example 4-1, the ester content in the solution (more specifically, the combined proportion of isopropyl acetate and butyl acetate) was calculated in the following way.
Each solution was subjected to $^1$H-NMR (proton nuclear magnetic resonance) measurement on Varian 500NB FT-NMR system, and the ester content [mol%] was calculated from the integration ratios of the relevant peaks in accordance with Formula (2) below. The computation of the integration ratios of peaks was carried out by SpecManager (available from ACD, Inc.).

$$\text{Ester content} = 100 \times [\text{Carboxylates}] / ([\text{Carboxylates}] + [\text{Alcohols}]) \ldots (2)$$

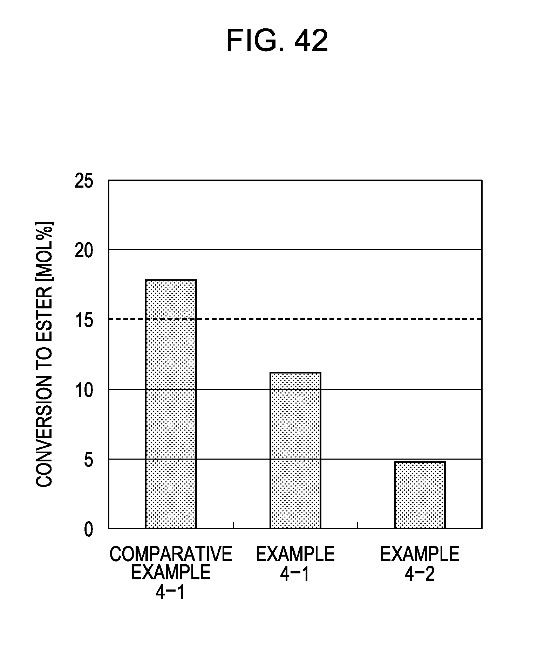

Fig. 42 shows the amount of ester formation in each solution, i.e., the difference between the ester content on Day 30 of storage (30 days after preparation) and that on Day 0 of storage. The storage of the solutions was at room temperature.
Fig. 42 demonstrates that in Examples 4-1 and 4-2 the amount of ester formation over time was smaller and thus the solution had a lower potential for esterification reaction than in Comparative Example 4-1. When the amount of ester formation during 30 days of storage exceeds 15 mol%, the conditions of spin coating for the formation of piezoelectric films 72 may be limited because of a decreased viscosity.

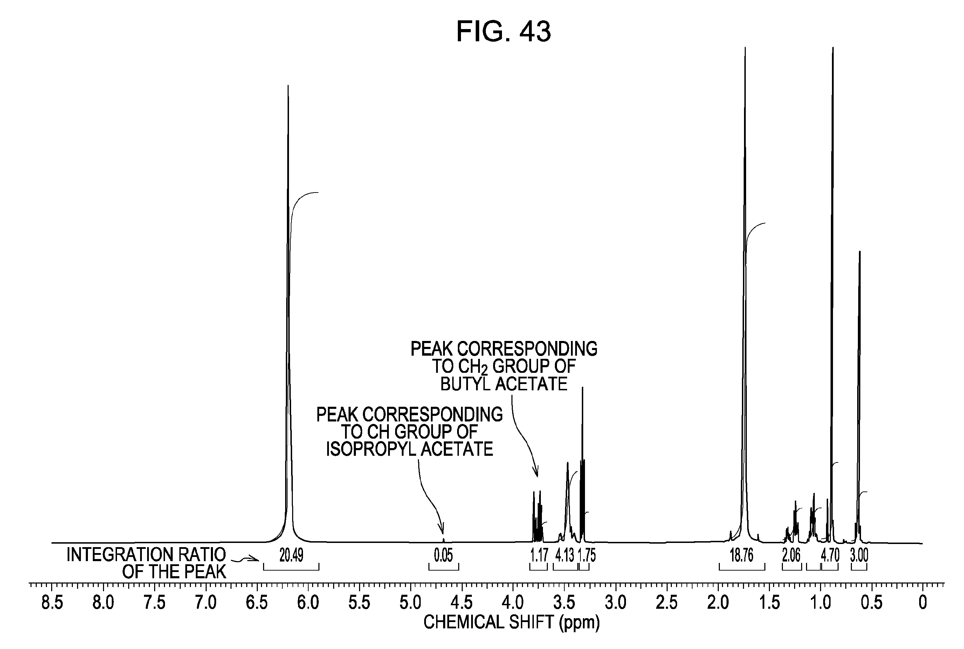

Figs. 43 to 46 are $^1$H-NMR spectra taken to calculate the amounts of ester formation presented in Fig. 42.
Fig. 43 is a $^1$H-NMR spectrum obtained for Example 4-1 on Day 0 of storage. As can be seen from Fig. 43, the integration ratios of the peaks corresponding to the CH group of isopropyl acetate and the $CH_2$ group of butyl acetate were 0.05 and 1.17, respectively.

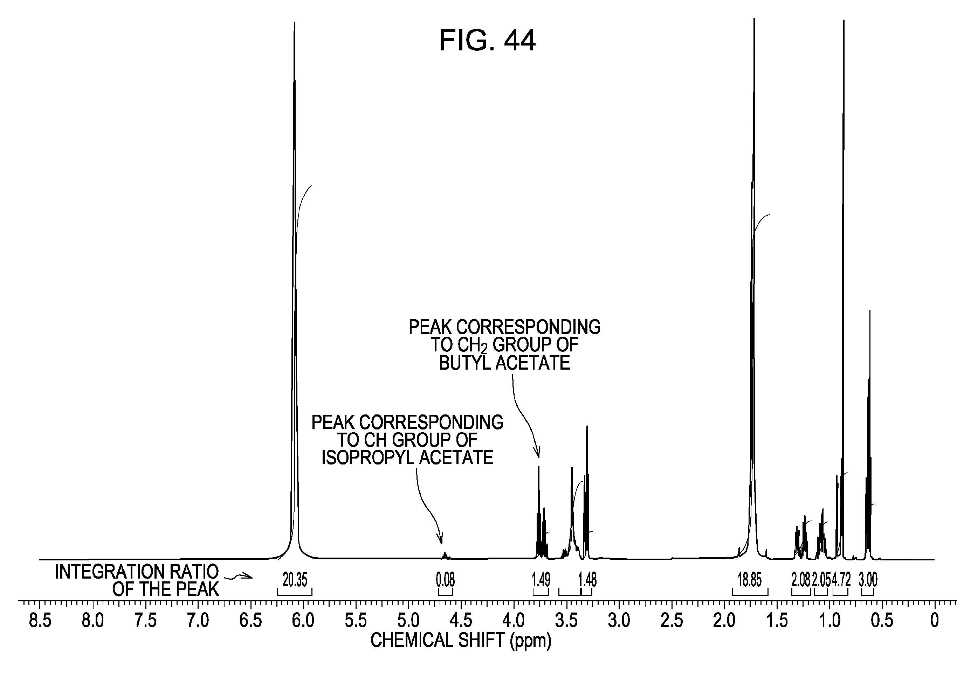

Fig. 44 is a $^1$H-NMR spectrum obtained for Example 4-1 on Day 30 of storage. As can be seen from Fig. 44, the integration ratios of the peaks corresponding to the CH group of isopropyl acetate and the $CH_2$ group of butyl acetate were 0.08 and 1.49, respectively.

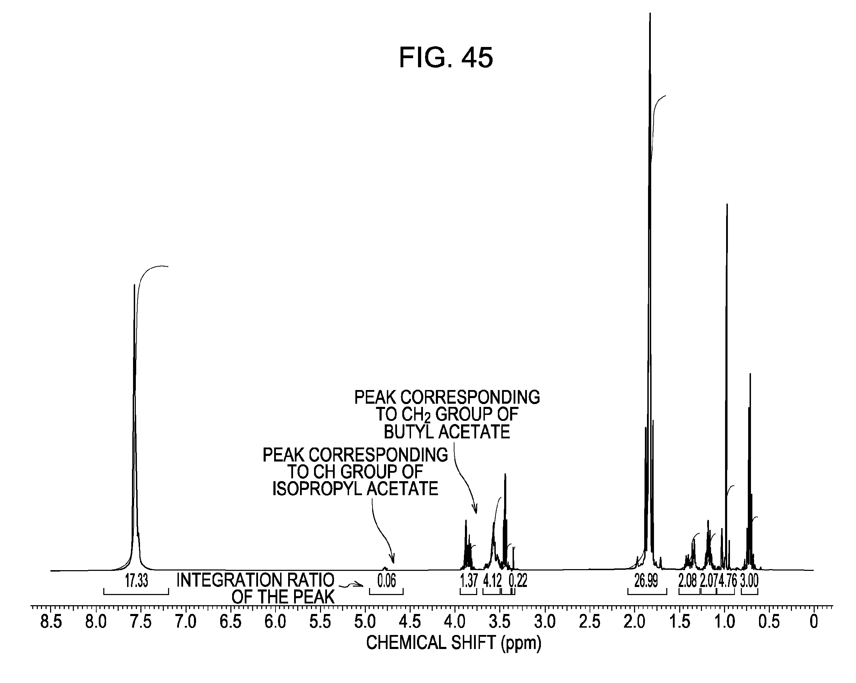

Fig. 45 is a $^1$H-NMR spectrum obtained for Comparative Example 4-1 on Day 0 of storage. As can be seen from Fig. 45, the integration ratios of the peaks corresponding to the CH group of isopropyl acetate and the $CH_2$ group of butyl acetate were 0.06 and 1.37, respectively.

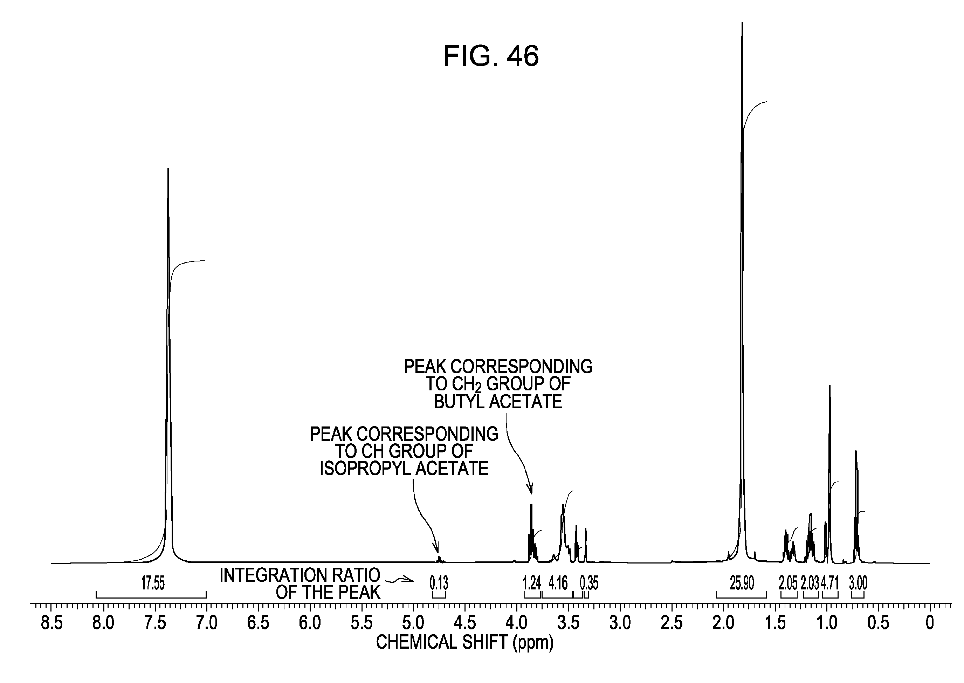

Fig. 46 is a $^1$H-NMR spectrum obtained for Comparative Example 4-1 on Day 30 of storage. As can be seen from Fig. 46, the integration ratios of the peaks corresponding to the CH group of isopropyl acetate and the $CH_2$ group of butyl acetate were 0.13 and 1.84, respectively.

Embodiment 5

Method for Manufacturing a Piezoelectric Film

The following describes the method for manufacturing a piezoelectric film according to Embodiment 5. Embodiment 5 can be suitably used to produce a piezoelectric film using a piezoelectric film precursor solution according to any of the relevant embodiments above or a piezoelectric film precursor solution prepared by the method for manufacturing a precursor solution for piezoelectric films according to the previous embodiment. The drawings used to illustrate Embodiment 1 will be mentioned as necessary, and the elements explained in Embodiment 1 are given the same numerals as in these drawings.

The method for manufacturing a piezoelectric film according to Embodiment 5 includes applying a piezoelectric film precursor solution containing a metal compound or compounds (a metal complex or complexes) as a constituent or constituents of the piezoelectric film and thereby forming a precursor piezoelectric coating (an application stage), and heating and crystallizing the precursor piezoelectric coating and thereby forming the piezoelectric film (a sintering stage).

The method for manufacturing a piezoelectric film according to Embodiment 5 is based on the finding that controlling the film thickness reduction of the piezoelectric film obtained after the sintering stage to fall within a specified range (27% to 45%, both inclusive) serves for an improved quality and a reduced potential for cracking of the resulting piezoelectric film 72. When the film thickness reduction at the sintering stage is less than 27%, the resulting piezoelectric film 72 should have voids inside; the piezoelectric film 72 has an accordingly low density and thus an accordingly low quality. When the film thickness reduction at the sintering stage exceeds 45%, however, the resulting piezoelectric film 72 unfortunately has cracks.

A possible way to control the film thickness reduction of the piezoelectric film 72 to fall within the specified range is as follows. The film thickness reduction can be adjusted by, for example, adding a selected additive to the piezoelectric film precursor solution, replacing the base to which the piezoelectric film precursor solution is applied with a smaller or larger one, changing the drying time and the drying temperature, and/or changing the defatting time and the defatting temperature. Therefore, one can ensure that the film thickness reduction at the sintering stage is in a range of 27% to 45%, both inclusive, by taking these parameters and/or measures as required.

The following describes the method for manufacturing a piezoelectric film according to Embodiment 5 by explaining a procedure for forming a piezoelectric film thereby on a stage-by-stage basis with reference to Figs. 5A and 5B.

First, a piezoelectric film precursor solution containing a metal compound or compounds (a metal complex or complexes) as a constituent or constituents of the piezoelectric film 72 is prepared. This piezoelectric film precursor solution is a coating solution for CSD (Chemical Solution Deposition)-based process. The illustrated CSD process, which will be detailed later, includes applying the piezoelectric film precursor solution and thereby forming a precursor piezoelectric coating 71, and heating and crystallizing the precursor piezoelectric coating 71 and thereby forming the piezoelectric film 72. Examples of CSD-based processes include the sol-gel process and MOD.

A precursor solution for the formation of piezoelectric films for this purpose can be prepared by mixing a selected metal compound mixture and a solvent component. Adding at least one additive selected from the group consisting of polyethylene glycols, glycol-based solvents, glycol ether-based solvents, and glycol ester-based solvents to this precursor solution serves to increase the film thickness reduction at the sintering stage.

At least one additive selected from the group consisting of polyethylene glycols, glycol-based solvents, glycol ether-based solvents, and glycol ester-based solvents is added; these additives can be used in combination. Examples of the glycol-based solvents that can be used here include ethylene glycol, diethylene glycol, triethylene glycol, and polyethylene glycols. Examples of the glycol ether-based solvents that can be used here include diethylene glycol monomethyl ether, triethylene glycol monomethyl ether, and triethylene glycol monobutyl ether. Examples of the glycol ester-based solvents that can be used here include ethylene glycol monomethyl ether acetate and ethylene glycol monoethyl ether. Among these, polyethylene glycols (PEGs) are particularly preferred.

The weight-average molecular weight of this additive or additives is preferably equal to or greater than 200 but less than 1000, and more preferably in a range of 300 to 600, both inclusive. An increased weight-average molecular weight of the additive or additives results in an increased film thickness reduction at the sintering stage.

The amount of the additive or additives is preferably, for example, in a range of 3% by weight to 30% by weight, both inclusive, on the basis of the concentration in the piezoelectric film precursor solution. An increased amount of the additive or additives will result in an increased film thickness reduction at the sintering stage.

The metal compound mixture used in Embodiment 5 is a mixture of metal compounds containing the metals that constitute the piezoelectric film 72. More specifically, the *metal compound mixture* as used herein represents a mixture of metal compounds each containing one or more of the constituent metals of the piezoelectric film 72.

Examples of piezoelectric films formed with a piezoelectric film precursor solution include ones made of ferroelectric materials such as lead zirconate titanate (PZT) and ones made of relaxor ferroelectrics, i.e., ferroelectric materials doped with a metal such as niobium, nickel, magnesium, bismuth, or yttrium. Examples of possible compositions of the piezoelectric film of this type include $PbTiO_3$(PT), $PbZrO_3$(PZ), $Pb(Zr_xTi_{1-x})O_3$ (PZT), $Pb(Mg_{1/3}Nb_{2/3})O_3$-$PbTiO_3$ (PMN-PT), $Pb(Zn_{1/3}Nb_{2/3})O_3$-$PbTiO_3$ (PZN-PT), $Pb(Ni_{1/3}Nb_{2/3})O_3$-$PbTiO_3$ (PNN-PT), $Pb(In_{1/2}Nb_{1/2})O_3$-$PbTiO_3$ (PIN-PT), $Pb(Sc_{1/2}Ta_{1/2})O_3$-$PbTiO_3$ (PST-PT), $Pb(Sc_{1/2}Nb_{1/2})O_3$-$PbTiO_3$ (PSN-PT), $BiScO_3$-$PbTiO_3$ (BS-PT), and $BiYbO_3$-$PbTiO_3$ (BY-PT), barium titanate ($BaTiO_3$) and barium strontium titanate (($Ba$, $Sr$)$TiO_3$), as well as solid solutions of lead magnesium niobate (PMN) and lead titanate (PT). In addition to these, the following compositions can also be chosen: perovskite composite oxides based on bismuth ferrite, such as bismuth ferrite ($BiFeO_3$), bismuth ferrite aluminate ($Bi(Fe,Al)O_3$), and bismuth ferrite manganite ($Bi(Fe,Mn)O_3$); perovskite composite oxides based on bismuth titanate, such as bismuth sodium potassium titanate (($Bi,Na,K$)$TiO_3$), bismuth sodium barium zincate titanate (($Bi,Na,Ba$)($Zn,Ti$)$O_3$), and bismuth sodium barium cuprate titanate; perovskite composite oxides based on potassium sodium niobate, such as potassium sodium niobate (($K,Na$)$NbO_3$, hereinafter referred to as *KNN*), potassium sodium lithium niobate (($K,Na,Li$)$NbO_3$), and potassium sodium lithium niobate tantalate (($K,Na,Li$)($Nb,Ta$)$O_3$); perovskite composite oxides based on lanthanide ferrites, such as lanthanum ferrite ($LaFeO_3$), praseodymium ferrite ($PrFeO_3$) and neodymium ferrite ($NdFeO_3$); perovskite composite oxides based on barium titanate, such as barium titanate ($BaTiO_3$), barium strontium titanate (($Ba,Sr$)$TiO_3$), and bismuth barium titanate ferrite (($Bi,Ba$)($Fe,Ti$)$O_3$). Note that possible compositions of the piezoelectric films formed with a piezoelectric film precursor solution are not limited to these; $SiO_2$, $AlO_x$, $ZrO_x$, $TiO_x$, $SrO$, $MgO$, and other similar compositions for insulating films, protective films, and so forth can also be chosen.

For example, when a PZT-based composite oxide for the formation of lead zirconate titanate (PZT) thin films is intended, metal compounds containing the metals constituting PZT, i.e., lead (Pb), titanium (Ti), and zirconium (Zr), are first mixed to achieve the desired molar ratios, and then the obtained metal compound mixture is dissolved/dispersed in a solvent component.

Examples of the organic metal compounds that can be used for this purpose include alkoxides, organic acid salts, and β-diketone complexes of metals. Examples of lead (Pb)-containing organic metal compounds include lead acetate. Examples of zirconium (Zr)-containing organic metal compounds include zirconium acetylacetonate, zirconium tetraacetylacetonate, zirconium monoacetylacetonate, zirconium bisacetylacetonate, and zirconium trisacetylacetonate. Examples of titanium (Ti)-containing organic metal compounds include titanium tetraisopropoxide and other titanium alkoxides.

The solvent component is for the purpose of dissolving or dispersing the metal compound mixture therein, and examples of possible constituents thereof include carboxylic acids and alcohols. Examples of the alcohols that can be used for this purpose include butanol, methyl Cellosolve, butyl Cellosolve, 2-n-butoxyalcohol, n-pentyl alcohol, 2-phenyl ethanol, 2-phenoxyethanol, methoxyethanol, ethylene glycol monoacetate, triethylene glycol, trimethylene glycol, propylene glycol, neopentyl glycol. In addition to the above-mentioned carboxylic acids and alcohols, esters such as isoamyl acetate may also be used. Examples of the carboxylic acids that can be used for this purpose include acetic acid, propionic acid, butyric acid, and caprylic acid (octylic acid). These solvents may be used as a pure substance or as a mixture of two or more thereof.

In addition, the piezoelectric film precursor solution may further contain an amine or amines. The presence of an amine or amines in the precursor solution serves to improve the dispersion stability of the other components. Examples of the amines that can be used for this purpose include alkanolamines such as monoethanolamine and diethanolamine. These amines can be used as a pure substance or as a mixture of two or more thereof.

The metal compound mixture and the solvent component described above are mixed in such a ratio that the molar concentration of the metals (the total content of the metals existing in the metal compound mixture) should be in a range of, for example, 0.1 to 1.0 mol·$L^{-1}$.

Then, as illustrated in Fig. 5A, the piezoelectric film precursor solution is applied to the base, or more specifically a flow channel substrate wafer 110 having a lower electrode 60 formed thereon, by spin coating, dip coating, ink jet printing, or any other suitable technique, and thereby a precursor piezoelectric coating 71 is formed (the application stage). An increased size of the base, or an increased size of the flow channel substrate wafer 110 to which the piezoelectric film precursor solution is applied, will result in a decreased film thickness reduction at the sintering stage.

This precursor piezoelectric coating 71 is then dried by heating at a certain temperature (e.g., in a range of 130 to 180˚C) for a certain period of time (e.g., in a range of 2 to 10 minutes) (the drying stage). The dried precursor piezoelectric coating 71 is then heated to a certain temperature (e.g., in a range of 300 to 450˚C) and maintained for a certain period of time (e.g., in a range of 2 to 10 minutes) and thereby defatted (the defatting stage). The kind of atmosphere for the drying and defatting stages is not limited; these stages can be carried out in the air or in an inert gas. An increased drying temperature will result in a decreased film thickness reduction at the sintering stage, and an increased defatting temperature will also lead to a decreased film thickness reduction at the sintering stage. Furthermore, a prolonged defatting time will result in a decreased film thickness reduction at the sintering stage.

Subsequently, the precursor piezoelectric coating 71 is heated to a certain temperature, e.g., a temperature of about 600 to 750˚C, and maintained for a certain period of time and thereby crystallized into a piezoelectric film 72 like that illustrated in Fig. 5B (the sintering stage). The kind of atmosphere for the sintering stage is also not limited; this stage can be carried out in the air or in an inert gas.

Regarding the heating apparatus for the drying, defatting, and sintering stages, examples include RTA apparatuses, which heat the target by irradiating it with an infrared lamp, and hot plates.

The film thickness reduction $\alpha$ at the sintering stage can be determined by the formula $\alpha = 100 (H1 - H2) / H1$, where H1 is the thickness of the uncrystallized film and H2 is that of the crystallized film. In other words, the percent change in film thickness over the sintering stage is defined as the film thickness reduction. In this embodiment, *the thickness of the uncrystallized film* represents the thickness of the precursor piezoelectric coating 71 after the defatting stage.

Furthermore, it is also allowed to repeat the cycle consisting of the above-described application, drying, and defatting stages or the cycle consisting of the application, drying, defatting, and sintering stages as many times as needed to achieve the desired film thickness or for any other purpose and thereby form several piezoelectric films 72 in layers.

In the method for manufacturing a piezoelectric film according to Embodiment 5, as mentioned above, the film thickness reduction at the sintering stage is controlled to fall within a range of 27% to 45%, both inclusive, by adding a selected additive or additives to the piezoelectric film precursor solution, replacing the base to which the piezoelectric film precursor solution is applied with a smaller or larger one, changing the defatting time and the defatting temperature, and/or other similar measures. As a result, the produced piezoelectric film 72 is of good quality and with a reduced potential for cracking.

The following Examples illustrate the method for manufacturing a piezoelectric film according to Embodiment 5 in more detail.

Example 5-1

First, the surface of a silicon substrate was thermally oxidized to form an oxide film 51 (see Fig. 4A) of silicon dioxide ($SiO_2$). This oxide film 51 was then covered with an isolating film 55 (see Fig. 4B) made of zirconium oxide. Subsequently, a (111)-oriented platinum film having a thickness of 100 nm was deposited on the insulating film 55 to form a lower electrode 60 (see Fig. 4C). The size of the silicon substrate was 3 cm $\times$ 3cm.

Then, a piezoelectric layer 70 was formed by the sol-gel process in the following way. First, titanium tetraisopropoxide was added to acetic acid and the mixture was stirred in an inert gas atmosphere. Zirconium tetra-n-butoxide was then added, and the obtained mixture was stirred. After that, a polyethylene glycol with a weight-average molecular weight of 600 (Polyethylene Glycol #600, available from Kanto Chemical Co., Inc.) was added, and the obtained mixture was further stirred. To the stirred mixture lead acetate trihydrate was added, and the obtained mixture was stirred. The mixture was then stirred at 80˚C for 30 minutes, and allowed to cool to room temperature. In this way, the piezoelectric film precursor solution of Example 5-1 was obtained. The concentration of the polyethylene glycol in this piezoelectric film precursor solution was 6% by weight.

The obtained piezoelectric film precursor solution was applied to the lower electrode 60 by spin coating, and thereby a precursor piezoelectric coating 71 was formed (the application stage). The obtained precursor piezoelectric coating 71 was heated at 140˚C for 5 minutes (the drying stage) and then at 375˚C for 5 minutes (the defatting stage). After that, the precursor piezoelectric coating 71 was heated at 700˚C until it was crystallized into a piezoelectric film 72 (the sintering stage). In this way, a piezoelectric layer 70 consisting of one piezoelectric film 72 was formed. The obtained piezoelectric layer 70 was a layer of lead zirconate titanate with a thickness of approximately 1000 nm.

Example 5-2

The same procedure as in Example 5-1 was taken except that the polyethylene glycol with a weight-average molecular weight of 600 was replaced with a polyethylene glycol with a weight-average molecular weight of 300 (Polyethylene Glycol #300, available from Kanto Chemical Co., Inc.).

Example 5-3

A piezoelectric layer 70 was formed in the same way as in Example 5-1 except that the polyethylene glycol with a weight-average molecular weight of 600 was replaced with a polyethylene glycol with a weight-average molecular weight of 400 (Polyethylene Glycol #400, available from Kanto Chemical Co., Inc.).

Example 5-4

A piezoelectric layer 70 was formed in the same way as in Example 5-1 except that the defatting temperature was 350˚C and the polyethylene glycol with a weight-average molecular weight of 600 was omitted.

Example 5-5

A piezoelectric layer 70 was formed in the same way as in Example 5-1 except that the defatting temperature was 425°C.

Example 5-6

A piezoelectric layer 70 was formed in the same way as in Example 5-1 except that the defatting temperature was 350°C.

Example 5-7

A piezoelectric layer 70 was formed in the same way as in Example 5-3 except that the concentration of the polyethylene glycol with a weight-average molecular weight of 400 was 3% by weight.

Example 5-8

A piezoelectric layer 70 was formed in the same way as in Example 5-3 except that the concentration of the polyethylene glycol with a weight-average molecular weight of 400 was 12% by weight.

Example 5-9

A piezoelectric layer 70 was formed in the same way as in Example 5-3 except that the concentration of the polyethylene glycol with a weight-average molecular weight of 400 was 18% by weight.

Example 5-10

A piezoelectric layer 70 was formed in the same way as in Example 5-3 except that the size of the substrate was 10 cm in diameter.

Example 5-11

A piezoelectric layer 70 was formed in the same way as in Example 5-1 except that the size of the substrate was 10 cm in diameter.

Example 5-12

A piezoelectric layer 70 was formed in the same way as in Example 5-11 except that the heating conditions at the defatting stage were 375°C and 3 minutes.

Example 5-13

A piezoelectric layer 70 was formed in the same way as in Example 5-11 except that the heating conditions at the defatting stage were 400°C and 3 minutes.

Example 5-14

A piezoelectric layer 70 was formed in the same way as in Example 5-11 except that the heating conditions at the defatting stage were 350°C and 5 minutes.

Example 5-15

A piezoelectric layer 70 was formed in the same way as in Example 5-11 except that the heating conditions at the defatting stage were 400°C and 5 minutes.

Example 5-16

A piezoelectric layer 70 was formed in the same way as in Example 5-11 except that the heating conditions at the defatting stage were 425˚C and 5 minutes.

Example 5-17

A piezoelectric layer 70 was formed in the same way as in Example 5-11 except that the heating conditions at the defatting stage were 375˚C and 7 minutes.

Example 5-18

A piezoelectric layer 70 was formed in the same way as in Example 5-11 except that the heating conditions at the defatting stage were 400˚C and 7 minutes.

Example 5-19

A piezoelectric layer 70 was formed in the same way as in Example 5-11 except that the heating conditions at the drying stage were 120˚C and 5 minutes.

Example 5-20

A piezoelectric layer 70 was formed in the same way as in Example 5-11 except that the heating conditions at the drying stage were 160˚C and 5 minutes.

Example 5-21

A piezoelectric layer 70 was formed in the same way as in Example 5-11 except that the heating conditions at the drying stage were 180˚C and 5 minutes. Comparative Example 5-1
A piezoelectric layer 70 was formed in the same way as in Example 5-1 except that the polyethylene glycol with a weight-average molecular weight of 600 was omitted.

Comparative Example 5-2

A piezoelectric layer 70 was formed in the same way as in Example 5-1 except that the polyethylene glycol with a weight-average molecular weight of 600 was replaced with a polyethylene glycol with a weight-average molecular weight of 1000. Comparative Example 5-3
A piezoelectric layer 70 was formed in the same way as in Example 5-5 except that the polyethylene glycol with a weight-average molecular weight of 600 was omitted.

Comparative Example 5-4

A piezoelectric layer 70 was formed in the same way as in Example 5-11 except that the heating conditions at the defatting stage were 200˚C and 5 minutes. Comparative Example 5-5
A piezoelectric layer 70 was formed in the same way as in Example 5-11 except that the heating conditions at the defatting stage were 500˚C and 5 minutes.

Example 5-22

A piezoelectric layer 70 was formed in the same way as in Example 5-10 except that the piezoelectric film precursor solution was prepared in the way described below, the heating conditions at the drying stage were 160˚C and 3 minutes, and those at the defatting stage were 375˚C and 3 minutes.
The piezoelectric film precursor solution was prepared as follows. Lead acetate trihydrate, titanium tetraisopropoxide, and zirconium acetylacetonate (main raw materials), butyl Cellosolve (the solvent component), diethanolamine (a stabilizing agent), and a polyethylene glycol with a weight-average molecular weight of 400 (Polyethylene Glycol #400, available from Kanto Chemical Co., Inc.) were mixed in an inert gas atmosphere. The obtained mixture was stirred at 80˚C for 30 minutes, and allowed to cool to room temperature. In this way, the piezoelectric film precursor solution of Example 5-22 was obtained. The concentration of the polyethylene glycol in this piezoelectric film precursor solution was 6% by weight.

Test 1

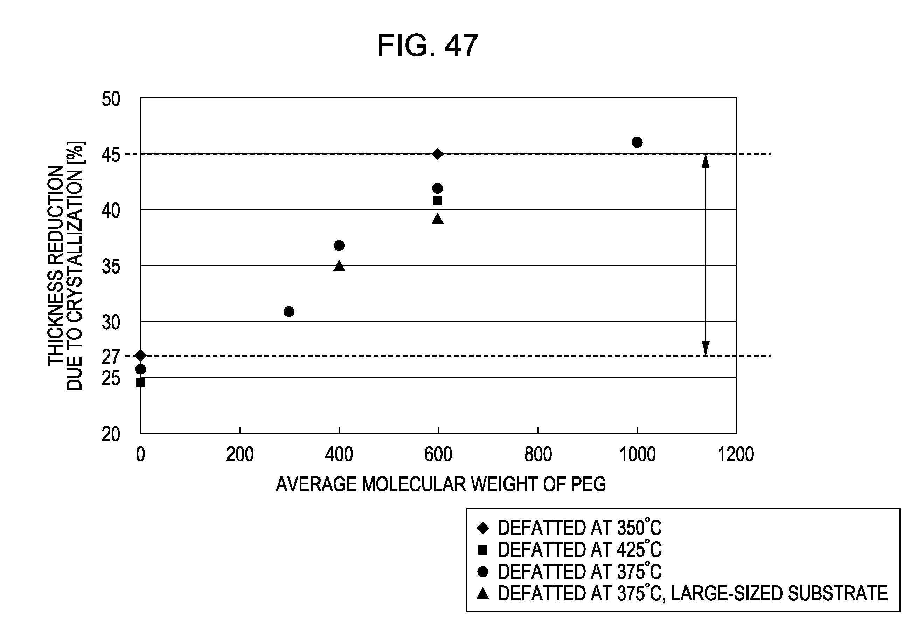

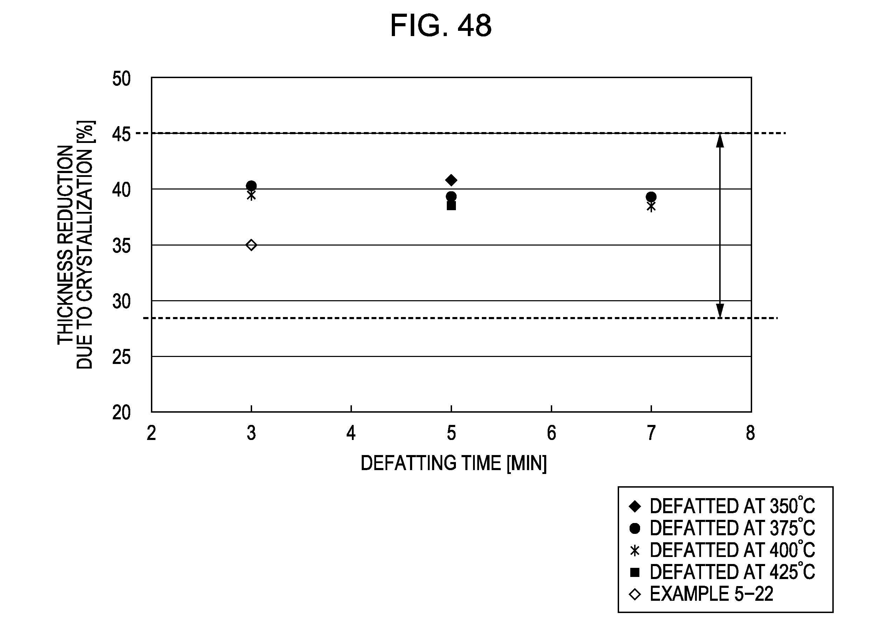

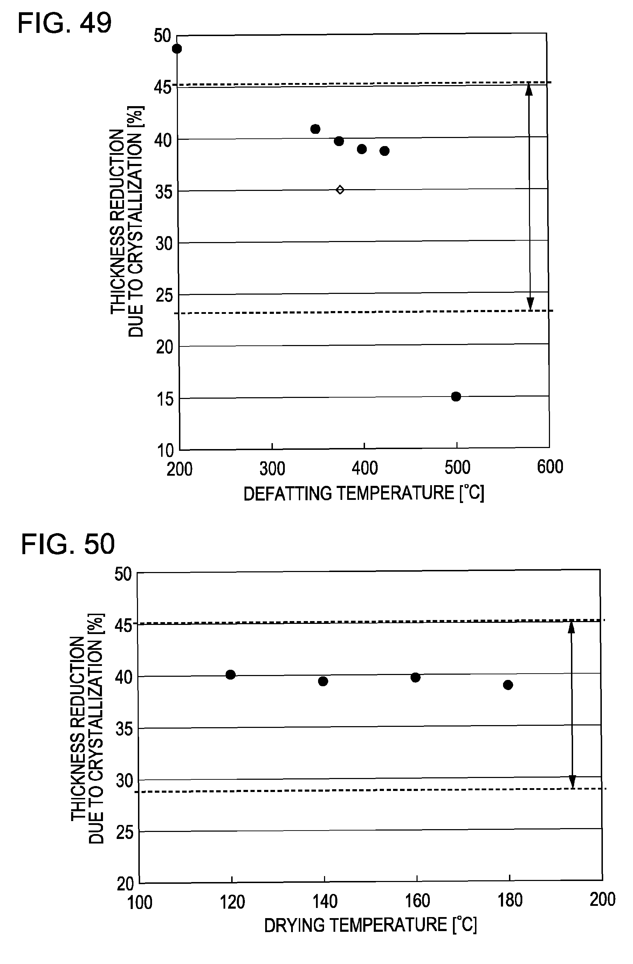

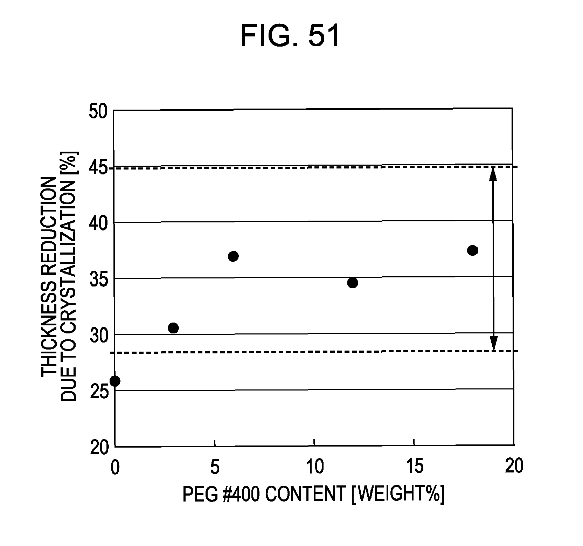

For each example or comparative example, the film thickness reduction at the sintering stage ("THICKNESS REDUCTION DUE TO CRYSTALLIZATION" in the relevant drawings) was determined. The results are presented in Tables 2 and 3 and in Figs. 47 to 51. Fig. 47 shows the relationship between the weight-average molecular weight of the polyethylene glycol (PEG) and the thickness reduction at the sintering stage. Fig. 48 shows the relationship between the defatting time and the film thickness reduction at the sintering stage. Fig. 49 shows the relationship between the defatting time and the film thickness reduction at the sintering stage. Fig. 50 shows the relationship between the drying temperature and the film thickness reduction at the sintering stage. Fig. 51 shows the relationship between the amount of the PEG added (the PEG concentration [% by weight]) and the film thickness reduction at the sintering stage.

Table 2

| | Film thickness reduction at the sintering stage (%) | | Film thickness reduction at the sintering stage (%) |
|---|---|---|---|
| Example 5-1 | 42.0 | Example 5-12 | 40.3 |
| Example 5-2 | 30.9 | Example 5-13 | 39.4 |
| Example 5-3 | 36.8 | Example 5-14 | 40.8 |
| Example 5-4 | 27.0 | Example 5-15 | 38.8 |
| Example 5-5 | 40.8 | Example 5-16 | 38.6 |
| Example 5-6 | 45.0 | Example 5-17 | 39.3 |
| Example 5-7 | 30.5 | Example 5-18 | 38.6 |
| Example 5-8 | 34.5 | Example 5-19 | 40.1 |
| Example 5-9 | 37.3 | Example 5-20 | 39.6 |
| Example 5-10 | 35.0 | Example 5-21 | 38.9 |
| Example 5-11 | 39.3 | Example 5-22 | 35.0 |

Table 3

| | Film thickness reduction at the sintering stage (%) |
|---|---|
| Comparative Example 5-1 | 25.7 |
| Comparative Example 5-2 | 46.1 |
| Comparative Example 5-3 | 24.5 |
| Comparative Example 5-4 | 48.5 |
| Comparative Example 5-5 | 15.0 |

As shown in Fig. 47, an increased weight-average molecular weight of the polyethylene glycol added to the piezoelectric film precursor solution resulted in an increased film thickness reduction at the sintering stage, and an increased size of the substrate led to a decreased film thickness reduction at the sintering stage.
As shown in Fig. 48, a prolonged defatting time resulted in a decreased film thickness reduction at the sintering stage, regardless of defatting temperature.
As shown in Fig. 49, an increased defatting temperature resulted in a decreased film thickness reduction at the sintering stage.
As shown in Fig. 50, an increased drying temperature also resulted in a decreased film thickness reduction at the sintering stage.
As shown in Fig. 51, an increased amount of the polyethylene glycol added (the polyethylene glycol concentration) generally led to an increased film thickness reduction at the sintering stage.
Therefore, it was confirmed that the film thickness reduction at the sintering stage can be controlled by such measures as adding a selected additive to the piezoelectric film precursor solution, replacing the base to which the piezoelectric film precursor solution is applied with a smaller or larger one, changing the drying time and the drying temperature, and/or changing the defatting time and the defatting temperature.

Test 2

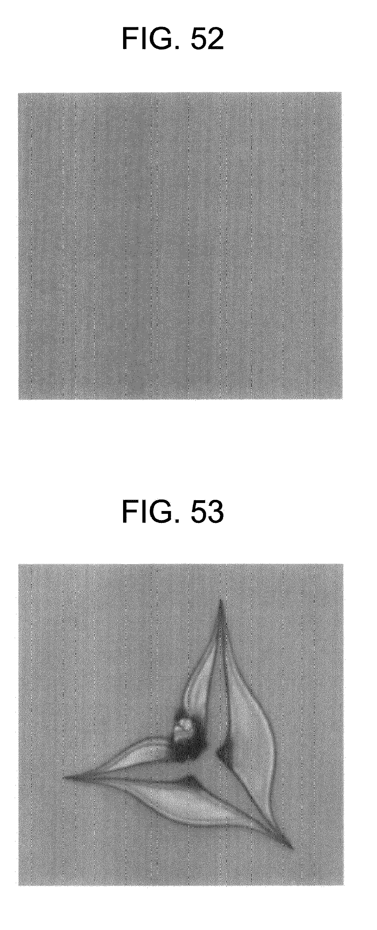

For each of Examples 5-1 to 5-22 and Comparative Examples 5-1 to 5-5, the surface of the piezoelectric layer 70 (piezoelectric film 72) was observed under a metallographic microscope at a magnification of 500 times after 14 days of the production of the piezoelectric layer 70. No cracks were found for Examples 5-1 to 5-22 and Comparative Examples 5-1, 5-3, and 5-5. For Comparative Examples 5-2 and 5-4, however, some cracks were detected. By way of example, the images obtained for Example 5-1 and Comparative Example 5-2 are presented in Figs. 52 and 53, respectively.

These results indicate that controlling the film thickness reduction at the sintering stage not to exceed 45% makes the resulting piezoelectric layer 70 (piezoelectric film 72) less likely to crack. When the film thickness reduction at the sintering stage is greater than 45%, however, the resulting piezoelectric layer 70 (piezoelectric film 72) cracks.

Test 3

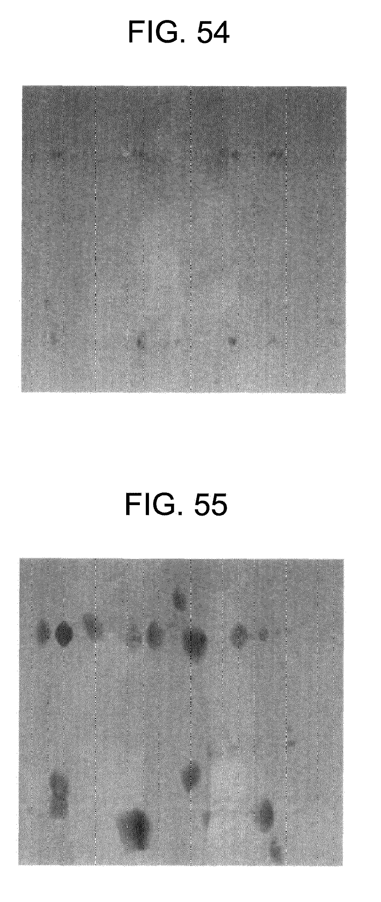

For each of Examples 5-1 to 5-22 and Comparative Examples 5-1 to 5-5, a cross section of the piezoelectric layer 70 (piezoelectric film 72) was observed under a scanning electron microscope (SEM) at a magnification of 30,000 times. By way of example, the images obtained for Example 5-1 and Comparative Example 5-1 are presented in Figs. 54 and 55, respectively. The piezoelectric layer 70 (piezoelectric film 72) was of good quality for Examples 5-1 to 5-22 and Comparative Examples 5-2 and 5-4. The films of Comparative Examples 5-1, 5-3, and 5-5, in which the film thickness reduction at the sintering stage was smaller than 27%, however, had several voids inside; the piezoelectric layer 70 (piezoelectric film 72) was of poor quality for these comparative examples.

These results demonstrate that controlling the film thickness reduction at the sintering stage to be equal to or greater than 27% ensures that the resulting piezoelectric layer 70 (piezoelectric film 72) has good quality.

In this way, it was confirmed that controlling the film thickness reduction at the sintering stage to fall within a range of 27% to 45%, both inclusive, ensures that the resulting piezoelectric film 70 (piezoelectric film 72) is of good quality and with a reduced potential for cracking.

In addition, the method for manufacturing a piezoelectric film according to Embodiment 5 can be suitably used to produce piezoelectric films for ferroelectric devices, pyroelectric devices, piezoelectric devices, and optical filters. Examples of the applicable ferroelectric devices include ferroelectric memories (FeRAMs), ferroelectric transistors (FeFETs), and SAW devices, and examples of the applicable pyroelectric devices include heat sensors, pyroelectric sensors, temperature sensors, infrared detectors, and thermoelectric converters. Examples of the applicable piezoelectric devices include liquid ejecting apparatuses, ultrasonic motors, ultrasonic sensors, acceleration sensors, pressure sensors, piezoelectric transducers, microphones, sounding bodies, a wide range of oscillators (resonators), and microfluidic pumps. Examples of the applicable optical filters include cutoff filters for infrared light beams or other harmful rays of light, optical filters based on the photonic crystal effect induced by the formation of quantum dots, and optical filters based on thin-film optical interference.

The foregoing description has been given by way of example only and it will be appreciated by a person skilled in the art that modifications can be made without departing from the scope of the present invention.

**Claims**

1. A precursor solution for piezoelectric films comprising raw materials including the following:

    a carboxylic acid component consisting of acetic acid and/or propionic acid;
    lead acetate;
    a zirconium alkoxide represented by $Zr(OR^1)_4$ ($OR^1$ is a linear or branched alkoxy group having 3 to 8 carbon atoms);
    a titanium alkoxide represented by $Ti(OR^2)_4$ ($OR^2$ is a linear or branched alkoxy group having 3 to 8 carbon atoms); and
    a polymeric component, wherein
    the carboxylic acid component is contained in an amount of 20% by mass to 60% by mass, both inclusive, of the total amount of the raw materials, and
    at least one of the ligand $OR^1$ of the zirconium alkoxide and the ligand $OR^2$ of the titanium alkoxide is a branched alkoxy group.

2. The precursor solution for piezoelectric films according to Claim 1, wherein both of the ligand $OR^1$ of the zirconium

alkoxide and the ligand OR$^2$ of the titanium alkoxide are branched alkoxy groups.

3. The precursor solution for piezoelectric films according to Claim 1, further comprising one or more solvents selected from water, secondary or tertiary alcohols, ethers, esters, and ketones.

4. The precursor solution for piezoelectric films according to Claim 1, wherein the polymeric component consists of one or more polymers selected from polyethylene glycols, polyethylene glycol derivatives, polypropylene glycols, and polypropylene glycol derivatives, and the weight-average molecular weight of the polymeric component is in a range of 300 to 800.

5. The precursor solution for piezoelectric films according to Claim 1, wherein the oxide-equivalent content of the metal elements contained in the precursor solution is in a range of 15% by mass to 27% by mass, both inclusive.

6. The precursor solution for piezoelectric films according to Claim 1, further comprising at least one organic metal compound.

7. A precursor solution for piezoelectric films comprising raw materials including the following:

   a solvent component containing a carboxylic acid component consisting of acetic acid and/or propionic acid;
   lead acetate;
   zirconium acetate and/or zirconium oxyacetate;
   a titanium alkoxide represented by Ti(OR$^1$)$_4$ (OR$^1$ is a branched alkoxy group having 3 to 8 carbon atoms); and
   a polymeric component, wherein
   the carboxylic acid component is contained in an amount of 20% by mass to 50% by mass, both inclusive, of the total amount of the raw materials, and
   the raw materials are substantially free of primary alcohols.

8. The precursor solution for piezoelectric films according to Claim 7, wherein the solvent component further contains one or more solvents selected from water, secondary or tertiary alcohols, ethers, esters, and ketones.

9. The precursor solution for piezoelectric films according to Claim 7, wherein the polymeric component consists of one or more polymers selected from polyethylene glycols, polyethylene glycol derivatives, polypropylene glycols, and polypropylene glycol derivatives, and the weight-average molecular weight of the polymeric component is in a range of 300 to 800.

10. The precursor solution for piezoelectric films according to Claim 7, wherein the oxide-equivalent content of the metal elements contained in the precursor solution is in a range of 15% by mass to 25% by mass, both inclusive.

11. The precursor solution for piezoelectric films according to Claim 7, further comprising at least one organic metal compound.

12. A precursor solution for piezoelectric films comprising a metal and molecules coordinating to the metal, wherein 90% or more of the molecules coordinating to the metal are of the same kind.

13. The precursor solution for piezoelectric films according to Claim 12, wherein 90% or more of the molecules coordinating to the metal are acetic acid anions, butoxyethoxy groups, 2-ethylhexyl groups, diethanolamino groups, methoxyethoxy groups, or acetylacetonate anions.

14. The precursor solution for piezoelectric films according to Claim 12, further comprising water to make 10% by mass or more of the preexisting solvent component thereof.

15. The precursor solution for piezoelectric films according to Claim 12, further comprising a polyethylene glycol.

16. A method for manufacturing a precursor solution for piezoelectric films, the precursor solution containing an acid, an alcohol, and a metal compound, comprising adding water to make 20% by mass or more of the preexisting solvent component of the precursor solution.

17. The method for manufacturing a precursor solution for piezoelectric films according to Claim 16, further comprising adding an ester to the solvent component.

18. The method for manufacturing a precursor solution for piezoelectric films according to Claim 16, further comprising adding an ester of the kind that the acid and the alcohol form by reacting with each other.

19. The method for manufacturing a precursor solution for piezoelectric films according to Claim 16, further comprising:

adding a titanium compound;
adding a zirconium compound; and
adding a lead compound, wherein
water is added after the titanium compound and the zirconium compound are added, but before the lead compound is added.

20. A method for manufacturing a piezoelectric film, comprising:

applying a piezoelectric film precursor solution containing a metal compound and thereby forming a precursor piezoelectric coating; and
heating and crystallizing the precursor piezoelectric coating until a film thickness reduction of 27% to 45%, both inclusive, is reached and thereby forming the piezoelectric film.

21. The method for manufacturing a piezoelectric film according to Claim 20, wherein the piezoelectric film is one made of a piezoelectric material containing at least Pb, Zr, and Ti.

22. The method for manufacturing a piezoelectric film according to Claim 20, wherein the precursor solution contains a polyethylene glycol.

23. The method for manufacturing a piezoelectric film according to Claim 22, wherein the weight-average molecular weight of the polyethylene glycol is at least 200 but less than 1000.

# FIG. 1

# FIG. 2A

1

30    33    43

III

80

IIB                                                          IIB

42 } 40
41

III

31  70    12  300        90

60

# FIG. 2B

1

31  300  80  70  60    90    33    43    42 } 40
                                              41
35                                                    30
55
50
10                                                    20

21    12    13    14  15  32
                            100

# FIG. 3

# FIG. 4A

~50, 51

~110, 10

# FIG. 4B

~55
~50, 51

~110, 10

# FIG. 4C

~60
~55
~50, 51

~110, 10

## FIG. 5A

71, 70
60
55
50, 51
110, 10

## FIG. 5B

72, 70
60
55
50, 51
110, 10

# FIG. 6A

60  72, 70

55
50, 51

110, 10

# FIG. 6B

70

72  72 72···72

60  72

55
50, 51

110, 10

# FIG. 7A

60 70      60 70

55
50, 51

110, 10

# FIG. 7B

300

60 70      60 70

80
55
50, 51

110, 10

# FIG. 8

EP 2 520 692 A2

# FIG. 9

| COMPOUND | SUPPLIER |
|---|---|
| ACETIC ACID | KANTO KAGAKU |
| PROPIONIC ACID | KANTO KAGAKU |
| ISOPROPYL ALCOHOL | KANTO KAGAKU |
| tert-BUTANOL | KANTO KAGAKU |
| DI-n-BUTYL ETHER | KANTO KAGAKU |
| n-BUTYL ACETATE | KANTO KAGAKU |
| ETHYLENE GLYCOL MONOMETHYL ETHER ACETATE | KANTO KAGAKU |
| METHYL ETHYL KETONE | KANTO KAGAKU |
| ACETYLACETONE | KANTO KAGAKU |
| 2-n-BUTOXYETHANOL | KANTO KAGAKU |
| DIETHANOLAMINE | KANTO KAGAKU |
| LEAD (II) ACETATE TRIHYDRATE | KANTO KAGAKU |
| ZIRCONIUM TETRAMETHOXIDE | KOJUNDO CHEMICAL LABORATORY |
| ZIRCONIUM TETRAETHOXIDE | KOJUNDO CHEMICAL LABORATORY |
| ZIRCONIUM TETRA-n-PROPOXIDE | KOJUNDO CHEMICAL LABORATORY |
| ZIRCONIUM TETRAISOPROPOXIDE | KOJUNDO CHEMICAL LABORATORY |
| ZIRCONIUM TETRA-n-BUTOXIDE | KOJUNDO CHEMICAL LABORATORY |
| ZIRCONIUM TETRA-n-BUTOXIDE (PURITY 86 MASS%, n-BUTANOL SOLUTION) | KANTO KAGAKU |
| ZIRCONIUM TETRAISOBUTOXIDE | KOJUNDO CHEMICAL LABORATORY |
| ZIRCONIUM TETRA-sec-BUTOXIDE | KOJUNDO CHEMICAL LABORATORY |
| ZIRCONIUM TETRA-tert-BUTOXIDE | KOJUNDO CHEMICAL LABORATORY |
| ZIRCONIUM TETRA-tert-PENTOXIDE | AZMAX |
| ZIRCONIUM TETRAKIS (2-ETHYLHEXYLOXIDE) | AZMAX |
| TITANIUM TETRAMETHOXIDE | KOJUNDO CHEMICAL LABORATORY |
| TITANIUM TETRAETHOXIDE | KOJUNDO CHEMICAL LABORATORY |
| TITANIUM TETRA-n-PROPOXIDE | KOJUNDO CHEMICAL LABORATORY |
| TITANIUM TETRAISOPROPOXIDE | KOJUNDO CHEMICAL LABORATORY |
| TITANIUM TETRA-n-BUTOXIDE | KOJUNDO CHEMICAL LABORATORY |
| TITANIUM TETRAISOBUTOXIDE | KOJUNDO CHEMICAL LABORATORY |
| TITANIUM TETRA-sec-BUTOXIDE | KOJUNDO CHEMICAL LABORATORY |
| TITANIUM TETRA-tert-BUTOXIDE | KOJUNDO CHEMICAL LABORATORY |
| TITANIUM TETRAKIS (2-ETHYLHEXYLOXIDE) | AZMAX |
| POLYETHYLENE GLYCOL (AVG. MW 300) | KANTO KAGAKU |
| POLYETHYLENE GLYCOL (AVG. MW 400) | KANTO KAGAKU |
| POLYETHYLENE GLYCOL (AVG. MW 600) | KANTO KAGAKU |
| POLYETHYLENE GLYCOL MONOMETHYL ETHER (AVG. MW 550) | ALFA AESAR |
| POLYETHYLENE GLYCOL MONOMETHYL ETHER (AVG. MW 750) | ALFA AESAR |
| POLYPROPYLENE GLYCOL (AVG. MW 400) | ALFA AESAR |
| POLYPROPYLENE GLYCOL (AVG. MW 700) | WAKO PURE CHEMICAL INDUSTRIES |
| LANTHANUM ACETATE 1.5-HYDRATE | KANTO KAGAKU |
| MAGNESIUM ACETATE TETRAHYDRATE | KANTO KAGAKU |
| NIOBIUM PENTA-n-BUTOXIDE | KOJUNDO CHEMICAL LABORATORY |

| ION-EXCHANGED WATER | — |
|---|---|

# FIG. 10

| COMPOUND | CATEGORY | EXAMPLE 1-1 | EXAMPLE 1-2 | EXAMPLE 1-3 | EXAMPLE 1-4 | EXAMPLE 1-5 | COMPARATIVE EXAMPLE 1-1 | COMPARATIVE EXAMPLE 1-2 | COMPARATIVE EXAMPLE 1-3 | COMPARATIVE EXAMPLE 1-4 |
|---|---|---|---|---|---|---|---|---|---|---|
| ACETIC ACID | CARBOXYLIC ACID | 43.0 | 50.0 | | | 20.0 | | | | |
| PROPIONIC ACID | CARBOXYLIC ACID | | | 37.0 | 40.0 | 20.0 | | | | |
| ACETYL ACETONE | SOLVENT | | | | | | 30.0 | | | |
| 2-n-BUTOXYETHANOL | SOLVENT | | | | | | 10.0 | 69.0 | 33.0 | 25.0 |
| DIETHANOLAMINE | SOLVENT | | | | | | | 15.0 | 7.0 | 15.0 |
| LEAD (II) ACETATE TRIHYDRATE | LEAD SOURCE | 27.3 | 27.3 | 27.3 | 27.3 | 27.3 | 27.3 | 27.3 | 27.3 | 27.3 |
| ZIRCONIUM TETRA-n-BUTOXIDE (n-BUTANOL SOLUTION) | ZIRCONIUM SOURCE | 14.0 | 14.0 | 14.0 | 14.0 | 14.0 | 14.0 | 14.0 | 14.0 | 14.0 |
| TITANIUM TETRAISOPROPOXIDE | TITANIUM SOURCE | 8.4 | 8.4 | 8.4 | 8.4 | 8.4 | 8.4 | 8.4 | 8.4 | 8.4 |
| POLYETHYLENE GLYCOL (AVG. MW 600) | POLYMER | 6.8 | 6.8 | 6.8 | 6.8 | 6.8 | 6.8 | 6.8 | 6.8 | 6.8 |
| TOTAL | | 99.5 | 106.5 | 93.5 | 96.5 | 96.5 | 96.5 | 140.5 | 96.5 | 96.5 |

EP 2 520 692 A2

# FIG. 11

| | EXAMPLE 1-1 | EXAMPLE 1-2 | EXAMPLE 1-3 | EXAMPLE 1-4 | EXAMPLE 1-5 | COMPARATIVE EXAMPLE 1-1 | COMPARATIVE EXAMPLE 1-2 | COMPARATIVE EXAMPLE 1-3 | COMPARATIVE EXAMPLE 1-4 |
|---|---|---|---|---|---|---|---|---|---|
| METAL OXIDE CONTENT (MASS%) | 22.4 | 20.9 | 23.8 | 23.1 | 23.1 | 23.1 | 15.9 | 23.1 | 23.1 |
| CARBOXYLIC ACID CONTENT IN TOTAL AMOUNT OF RAW MATERIALS (MASS%) | 43.2 | 46.9 | 39.6 | 41.4 | 41.4 | — | — | — | — |
| FILM THICKNESS (nm) | 310 | 272 | 260 | 236 | 275 | — | 90 | 185 | — |
| WATERPROOFNESS | ○ | ○ | ○ | ○ | ○ | — | ○ | × | ○ |
| STORAGE STABILITY | ○ | ○ | ○ | ○ | ○ | × | ○ | ○ | ○ |

# FIG. 12

| COMPOUND | CATEGORY | EXAMPLE 1-6 | EXAMPLE 1-7 | EXAMPLE 1-8 | EXAMPLE 1-9 | EXAMPLE 1-10 | EXAMPLE 1-11 | EXAMPLE 1-12 | EXAMPLE 1-13 | EXAMPLE 1-14 | EXAMPLE 1-15 | EXAMPLE 1-16 | EXAMPLE 1-17 | EXAMPLE 1-18 | EXAMPLE 1-19 | EXAMPLE 1-20 | EXAMPLE 1-21 | EXAMPLE 1-22 | COMPARATIVE EXAMPLE 1-5 | COMPARATIVE EXAMPLE 1-6 | COMPARATIVE EXAMPLE 1-7 |
|---|---|---|---|---|---|---|---|---|---|---|---|---|---|---|---|---|---|---|---|---|---|
| ACETIC ACID | CARBOXYLIC ACID | 48.7 | 45.3 | 45.3 | 47.1 | | 47.1 | 45.3 | 45.3 | 46.9 | | 48.7 | | 45.2 | | | 47.0 | 45.3 | | 52.2 | 48.7 |
| PROPIONIC ACID | CARBOXYLIC ACID | | | | | 41.7 | | | | | 43.3 | | 50.3 | | 44.9 | 45.5 | | | 60.6 | | |
| ION-EXCHANGED WATER | SOLVENT | 5.0 | 5.0 | 5.0 | 5.0 | | 5.0 | 5.0 | 5.0 | 5.0 | | 5.0 | | 5.0 | | | 5.0 | 5.0 | | 5.0 | 5.0 |
| LEAD (II) ACETATE TRIHYDRATE | LEAD SOURCE | 27.3 | 27.3 | 27.3 | 27.3 | 27.3 | 27.3 | 27.3 | 27.3 | 27.3 | 27.3 | 27.3 | 27.3 | 27.3 | 27.3 | 27.3 | 27.3 | 27.3 | 27.3 | 27.3 | 27.3 |
| ZIRCONIUM TETRAMETHOXIDE | ZIRCONIUM SOURCE | | | | | | | | | | | | | | | | | | 6.8 | | |
| ZIRCONIUM TETRAETHOXIDE | ZIRCONIUM SOURCE | | | | | | | | | | | | | | | | | | | 8.5 | |
| ZIRCONIUM TETRA-n-PROPOXIDE | ZIRCONIUM SOURCE | 10.3 | | | 10.3 | | | | | | | | | | | | | | | | 10.3 |
| ZIRCONIUM TETRAISOPROPOXIDE | ZIRCONIUM SOURCE | | | | | | 10.3 | | | | | 10.3 | | | | 10.3 | | | | | |
| ZIRCONIUM TETRA-n-BUTOXIDE (n-BUTANOL SOLUTION) | ZIRCONIUM SOURCE | | | | | 14.0 | | | | | | | | | | | | | | | |
| ZIRCONIUM TETRA-n-BUTOXIDE | ZIRCONIUM SOURCE | | 12.1 | 12.1 | | | | | | | | | | | | | | | | | |
| ZIRCONIUM TETRAISOBUTOXIDE | ZIRCONIUM SOURCE | | | | | | | 12.1 | | | | | | | | | 12.1 | | | | |
| ZIRCONIUM TETRA-sec-BUTOXIDE | ZIRCONIUM SOURCE | | | | | | | | 12.1 | | | | | | | | | | | | |
| ZIRCONIUM TETRA-tert-BUTOXIDE | ZIRCONIUM SOURCE | | | | | | | | | 12.1 | | | 12.1 | | | | | 12.1 | | | |
| ZIRCONIUM TETRA-tert-PENTOXIDE | ZIRCONIUM SOURCE | | | | | | | | | | | | | 13.8 | | | | | | | |
| ZIRCONIUM TETRAKIS (2-ETHYLHEXYLOXIDE) | ZIRCONIUM SOURCE | | | | | | | | | | 19.1 | | | | 19.1 | | | | | | |
| TITANIUM TETRAMETHOXIDE | TITANIUM SOURCE | | | | | | | | | | | | | | | | | | 5.1 | | |
| TITANIUM TETRAETHOXIDE | TITANIUM SOURCE | | | | | | | | | | | | | | | | | | | 6.7 | |
| TITANIUM TETRA-n-PROPOXIDE | TITANIUM SOURCE | | | | | | | | | 8.4 | | | | | | | | | | | 8.4 |
| TITANIUM TETRAISOPROPOXIDE | TITANIUM SOURCE | 8.4 | | | | | | | | | | 8.4 | | 8.4 | 8.4 | | 8.4 | | | | |
| TITANIUM TETRA-n-BUTOXIDE | TITANIUM SOURCE | | | | | | 10.0 | 10.0 | 10.0 | | 10.0 | | | | | | | | | | |
| TITANIUM TETRAISOBUTOXIDE | TITANIUM SOURCE | | 10.0 | | | | | | | | | | | | | | | 10.0 | | | |
| TITANIUM TETRA-sec-BUTOXIDE | TITANIUM SOURCE | | | 10.0 | | | | | | | | | | | | | | | | | |
| TITANIUM TETRA-tert-BUTOXIDE | TITANIUM SOURCE | | | | 10.0 | | | | | | | | 10.0 | | | | | | | | |
| TITANIUM TETRAKIS (2-ETHYLHEXYLOXIDE) | TITANIUM SOURCE | | | | | 16.7 | | | | | | | | | | 16.7 | | | | | |
| POLYETHYLENE GLYCOL (AVG. MW 600) | POLYMER | 6.8 | 6.8 | 6.8 | 6.8 | 6.8 | 6.8 | 6.8 | 6.8 | 6.8 | 6.8 | 6.8 | 6.8 | 6.8 | 6.8 | 6.8 | 6.8 | 6.8 | 6.8 | 6.8 | 6.8 |
| TOTAL | | 106.5 | 106.5 | 106.5 | 106.5 | 106.5 | 106.5 | 106.5 | 106.5 | 106.5 | 106.5 | 106.5 | 106.5 | 106.5 | 106.5 | 106.5 | 106.5 | 106.5 | 106.5 | 106.5 | 106.5 |

EP 2 520 692 A2

# FIG. 13

| | EXAMPLE 1-6 | EXAMPLE 1-7 | EXAMPLE 1-8 | EXAMPLE 1-9 | EXAMPLE 1-10 | EXAMPLE 1-11 | EXAMPLE 1-12 | EXAMPLE 1-13 | EXAMPLE 1-14 | EXAMPLE 1-15 | EXAMPLE 1-16 | EXAMPLE 1-17 | EXAMPLE 1-18 | EXAMPLE 1-19 | EXAMPLE 1-20 | EXAMPLE 1-21 | EXAMPLE 1-22 | COMPARATIVE EXAMPLE 1-5 | COMPARATIVE EXAMPLE 1-6 | COMPARATIVE EXAMPLE 1-7 |
|---|---|---|---|---|---|---|---|---|---|---|---|---|---|---|---|---|---|---|---|---|
| METAL OXIDE CONTENT (MASS%) | 20.9 | 20.9 | 20.9 | 20.9 | 20.9 | 20.9 | 20.9 | 20.9 | 20.9 | 20.9 | 20.9 | 20.9 | 20.9 | 20.9 | 20.9 | 20.9 | 20.9 | 20.9 | 20.9 | 20.9 |
| CARBOXYLIC ACID CONTENT IN TOTAL AMOUNT OF RAW MATERIALS (MASS%) | 45.8 | 42.5 | 42.5 | 44.2 | 39.2 | 44.2 | 42.5 | 42.5 | 44.0 | 40.6 | 45.8 | 47.2 | 42.4 | 42.2 | 42.7 | 44.1 | 42.5 | 56.9 | 49.0 | 45.8 |
| THICKNESS VARIATIONS | B | B | B | B | B | B | B | B | B | B | A | A | A | A | A | A | A | C | C | C |
| WATERPROOFNESS | O | O | O | O | O | O | O | O | O | O | O | O | O | O | O | O | O | O | O | O |
| STORAGE STABILITY | O | O | O | O | O | O | O | O | O | O | O | O | O | O | O | O | O | O | O | O |

EP 2 520 692 A2

# FIG. 14

| COMPOUND | CATEGORY | EXAMPLE 1-23 | EXAMPLE 1-24 | EXAMPLE 1-25 | EXAMPLE 1-26 | EXAMPLE 1-27 | EXAMPLE 1-28 | EXAMPLE 1-29 | EXAMPLE 1-30 | EXAMPLE 1-31 | EXAMPLE 1-32 |
|---|---|---|---|---|---|---|---|---|---|---|---|
| ACETIC ACID | CARBOXYLIC ACID | 23.5 | | 28.2 | | 32.9 | | 23.5 | 28.2 | | |
| PROPIONIC ACID | CARBOXYLIC ACID | | 23.5 | | 37.6 | | 32.9 | | | 37.6 | 37.6 |
| ION-EXCHANGED WATER | SOLVENT | 23.5 | | | | | | 14.1 | 9.4 | | |
| ISOPROPYL ALCOHOL | SOLVENT | | 23.5 | | | | | 9.4 | | | |
| tert-BUTANOL | SOLVENT | | | 18.8 | | | | | | 4.7 | |
| DI-n-BUTYL ETHER | SOLVENT | | | | 9.4 | | | | | | |
| n-BUTYL ACETATE | SOLVENT | | | | | 14.1 | | | 9.4 | | |
| ETHYLENE GLYCOL MONOMETHYL ETHER ACETATE | SOLVENT | | | | | | 14.1 | | | 4.7 | |
| METHYL ETHYL KETONE | SOLVENT | | | | | | | | | | 9.4 |
| LEAD (II) ACETATE TRIHYDRATE | LEAD SOURCE | 27.3 | 27.3 | 27.3 | 27.3 | 27.3 | 27.3 | 27.3 | 27.3 | 27.3 | 27.3 |
| ZIRCONIUM TETRA-n-BUTOXIDE (n-BUTANOL SOLUTION) | ZIRCONIUM SOURCE | 14.0 | 14.0 | 14.0 | 14.0 | 14.0 | 14.0 | 14.0 | 14.0 | 14.0 | 14.0 |
| TITANIUM TETRAISOPROPOXIDE | TITANIUM SOURCE | 8.4 | 8.4 | 8.4 | 8.4 | 8.4 | 8.4 | 8.4 | 8.4 | 8.4 | 8.4 |
| POLYETHYLENE GLYCOL (AVG. MW 600) | POLYMER | 10.3 | 10.3 | 10.3 | 10.3 | 10.3 | 10.3 | 10.3 | 10.3 | 10.3 | 10.3 |
| TOTAL | | 107.0 | 107.0 | 107.0 | 107.0 | 107.0 | 107.0 | 107.0 | 107.0 | 107.0 | 107.0 |

EP 2 520 692 A2

# FIG. 15

| | EXAMPLE 1-23 | EXAMPLE 1-24 | EXAMPLE 1-25 | EXAMPLE 1-26 | EXAMPLE 1-27 | EXAMPLE 1-28 | EXAMPLE 1-29 | EXAMPLE 1-30 | EXAMPLE 1-31 | EXAMPLE 1-32 |
|---|---|---|---|---|---|---|---|---|---|---|
| METAL OXIDE CONTENT (MASS%) | 20.8 | 20.8 | 20.8 | 20.8 | 20.8 | 20.8 | 20.8 | 20.8 | 20.8 | 20.8 |
| CARBOXYLIC ACID CONTENT IN TOTAL AMOUNT OF RAW MATERIALS (MASS%) | 22.0 | 22.0 | 26.4 | 35.2 | 30.8 | 30.8 | 22.0 | 26.4 | 35.2 | 35.2 |
| THICKNESS VARIATIONS | A | A | A | A | A | A | A | A | A | A |
| WATERPROOFNESS | ○ | ○ | ○ | ○ | ○ | ○ | ○ | ○ | ○ | ○ |
| STORAGE STABILITY | ○ | ○ | ○ | ○ | ○ | ○ | ○ | ○ | ○ | ○ |

# FIG. 16

| COMPOUND | CATEGORY | EXAMPLE 1-33 | EXAMPLE 1-34 | EXAMPLE 1-35 | EXAMPLE 1-36 | EXAMPLE 1-37 | EXAMPLE 1-38 | EXAMPLE 1-39 | EXAMPLE 1-40 | EXAMPLE 1-41 | EXAMPLE 1-42 | EXAMPLE 1-43 |
|---|---|---|---|---|---|---|---|---|---|---|---|---|
| ACETIC ACID | CARBOXYLIC ACID | 40.0 | 40.0 | 40.0 | 40.0 | 40.0 | 40.0 | 40.0 | 40.0 | 40.0 | 40.0 | 40.0 |
| ION-EXCHANGED WATER | SOLVENT | 10.0 | 10.0 | 10.0 | 10.0 | 10.0 | 10.0 | 10.0 | 10.0 | 10.0 | 10.0 | 10.0 |
| LEAD (II) ACETATE TRIHYDRATE | LEAD SOURCE | 27.3 | 27.3 | 27.3 | 27.3 | 27.3 | 27.3 | 27.3 | 27.3 | 27.3 | 27.3 | 27.3 |
| ZIRCONIUM TETRA-n-BUTOXIDE (n-BUTANOL SOLUTION) | ZIRCONIUM SOURCE | 14.0 | 14.0 | 14.0 | 14.0 | 14.0 | 14.0 | 14.0 | 14.0 | 14.0 | 14.0 | 14.0 |
| TITANIUM TETRAISOPROPOXIDE | TITANIUM SOURCE | 8.4 | 8.4 | 8.4 | 8.4 | 8.4 | 8.4 | 8.4 | 8.4 | 8.4 | 8.4 | 8.4 |
| POLYETHYLENE GLYCOL (AVG. MW 300) | POLYMER | 6.8 | 20.5 | | | | | | | | | |
| POLYETHYLENE GLYCOL (AVG. MW 400) | POLYMER | | | 6.8 | 20.5 | | | | | | | 1.7 |
| POLYETHYLENE GLYCOL (AVG. MW 600) | POLYMER | | | | | 6.8 | 20.5 | | | | | 1.7 |
| POLYETHYLENE GLYCOL MONOMETHYL ETHER (AVG. MW 550) | POLYMER | | | | | | | 6.8 | | | | 1.7 |
| POLYETHYLENE GLYCOL MONOMETHYL ETHER (AVG. MW 750) | POLYMER | | | | | | | | 6.8 | | | |
| POLYPROPYLENE GLYCOL (AVG. MW 400) | POLYMER | | | | | | | | | 6.8 | | |
| POLYPROPYLENE GLYCOL (AVG. MW 700) | POLYMER | | | | | | | | | | 6.8 | 1.7 |
| TOTAL | | 106.5 | 120.2 | 106.5 | 120.2 | 106.5 | 120.2 | 106.5 | 106.5 | 106.5 | 106.5 | 106.5 |

EP 2 520 692 A2

## FIG. 17

EP 2 520 692 A2

| | EXAMPLE 1-33 | EXAMPLE 1-34 | EXAMPLE 1-35 | EXAMPLE 1-36 | EXAMPLE 1-37 | EXAMPLE 1-38 | EXAMPLE 1-39 | EXAMPLE 1-40 | EXAMPLE 1-41 | EXAMPLE 1-42 | EXAMPLE 1-43 |
|---|---|---|---|---|---|---|---|---|---|---|---|
| METAL OXIDE CONTENT (MASS%) | 20.9 | 18.5 | 20.9 | 18.5 | 20.9 | 18.5 | 20.9 | 20.9 | 20.9 | 20.9 | 20.9 |
| CARBOXYLIC ACID CONTENT IN TOTAL AMOUNT OF RAW MATERIALS (MASS%) | 37.5 | 33.3 | 37.5 | 33.3 | 37.5 | 33.3 | 37.5 | 37.5 | 37.5 | 37.5 | 37.5 |
| THICKNESS OF 6 LAYERS (nm) | 1218 | 1200 | 1290 | 1302.0 | 1284 | 1302.0 | 1296 | 1308 | 1272 | 1300 | 1292 |
| RESISTANCE TO CRACKING | O | O | O | O | O | O | O | O | O | O | O |
| WATERPROOFNESS | O | O | O | O | O | O | O | O | O | O | O |
| STORAGE STABILITY | O | O | O | O | O | O | O | O | O | O | O |

# FIG. 18

| COMPOUND | CATEGORY | EXAMPLE 1-44 | EXAMPLE 1-45 | EXAMPLE 1-46 | EXAMPLE 1-47 | EXAMPLE 1-48 |
|---|---|---|---|---|---|---|
| ACETIC ACID | CARBOXYLIC ACID | 50.0 | 32.6 | 56.5 | | |
| PROPIONIC ACID | CARBOXYLIC ACID | | | | 30.0 | 25.0 |
| ION-EXCHANGED WATER | SOLVENT | 23.0 | 14.4 | 6.3 | | |
| ISOPROPYL ALCOHOL | SOLVENT | | 14.4 | | | |
| n-BUTYL ACETATE | SOLVENT | | | | 10.0 | |
| METHYL ETHYL KETONE | SOLVENT | | | | 6.0 | |
| LEAD (II) ACETATE TRIHYDRATE | LEAD SOURCE | 27.3 | 21.8 | 21.8 | 27.3 | 27.3 |
| ZIRCONIUM TETRA-n-BUTOXIDE (n-BUTANOL SOLUTION) | ZIRCONIUM SOURCE | 14.0 | | 11.2 | 14.0 | 14.0 |
| ZIRCONIUM TETRAISOPROPOXIDE | ZIRCONIUM SOURCE | | 8.2 | | | |
| TITANIUM TETRAISOPROPOXIDE | TITANIUM SOURCE | 8.4 | 6.7 | 6.7 | 8.4 | 8.4 |
| POLYETHYLENE GLYCOL (AVG. MW 400) | POLYMER | | 16.4 | | 13.7 | |
| POLYETHYLENE GLYCOL (AVG. MW 600) | POLYMER | 6.8 | | 5.4 | | 6.8 |
| TOTAL | | 129.5 | 114.6 | 107.9 | 109.4 | 81.5 |

EP 2 520 692 A2

# FIG. 19

| | EXAMPLE 1-44 | EXAMPLE 1-45 | EXAMPLE 1-46 | EXAMPLE 1-47 | EXAMPLE 1-48 | COMPARATIVE EXAMPLE 1-8 |
|---|---|---|---|---|---|---|
| METAL OXIDE CONTENT (MASS%) | 17.2 | 15.6 | 16.5 | 20.4 | 26.1 | 15.9 |
| CARBOXYLIC ACID CONTENT IN TOTAL AMOUNT OF RAW MATERIALS (MASS%) | 38.6 | 28.4 | 52.4 | 27.4 | 30.7 | — |
| SPINNING SPEED (rpm) | 700 | 900 | 1000 | 1500 | 4000 | 700 |
| FILM THICKNESS (nm) | 266 | 263 | 215 | 265 | 270 | 162 |
| WATERPROOFNESS | ○ | ○ | ○ | ○ | ○ | ○ |
| STORAGE STABILITY | ○ | ○ | ○ | ○ | ○ | ○ |

EP 2 520 692 A2

# FIG. 20

| COMPOUND | CATEGORY | EXAMPLE 1-49 | EXAMPLE 1-50 |
|---|---|---|---|
| ACETIC ACID | CARBOXYLIC ACID | 40.0 | 40.0 |
| ION-EXCHANGED WATER | SOLVENT | 10.0 | 10.0 |
| LEAD (II) ACETATE TRIHYDRATE | LEAD SOURCE | 25.4 | 27.3 |
| LANTHANUM ACETATE 1.5-HYDRATE | LANTHANUM SOURCE | 2.1 | |
| ZIRCONIUM TETRA-n-BUTOXIDE (n-BUTANOL SOLUTION) | ZIRCONIUM SOURCE | 14.0 | 9.8 |
| TITANIUM TETRAISOPROPOXIDE | TITANIUM SOURCE | 8.4 | 5.9 |
| MAGNESIUM ACETATE TETRAHYDRATE | MAGNESIUM SOURCE | | 1.3 |
| NIOBIUM PENTA-n-BUTOXIDE | NIOBIUM SOURCE | | 5.6 |
| POLYETHYLENE GLYCOL (AVG. MW 600) | POLYMER | 6.8 | 6.8 |
| TOTAL | | 106.8 | 106.7 |

EP 2 520 692 A2

# FIG. 21

|  | EXAMPLE 1−49 | EXAMPLE 1−50 |
|---|---|---|
| METAL OXIDE CONTENT (MASS%) | 20.9 | 20.9 |
| CARBOXYLIC ACID CONTENT IN TOTAL AMOUNT OF RAW MATERIALS (MASS%) | 37.5 | 37.5 |
| THICKNESS VARIATIONS | A | A |
| WATERPROOFNESS | ○ | ○ |
| STORAGE STABILITY | ○ | ○ |

# FIG. 22

| COMPOUND | SUPPLIER |
|---|---|
| ACETIC ACID | KANTO KAGAKU |
| PROPIONIC ACID | KANTO KAGAKU |
| ISOPROPYL ALCOHOL | KANTO KAGAKU |
| ACETYLACETONE | KANTO KAGAKU |
| 2-n-BUTOXYETHANOL | KANTO KAGAKU |
| DIETHANOLAMINE | KANTO KAGAKU |
| LEAD (II) ACETATE TRIHYDRATE | KANTO KAGAKU |
| ZIRCONIUM TETRA-n-BUTOXIDE (PURITY 86 MASS%, n-BUTANOL SOLUTION) | KANTO KAGAKU |
| ZIRCONIUM OXYACETATE | KISHIDA CHEMICAL |
| ZIRCONIUM ACETATE SOLUTION (15-16 MASS% BASED ON Zr, ACETIC ACID SOLUTION) | SIGMA-ALDRICH JAPAN |
| TITANIUM TETRA-n-PROPOXIDE | KOJUNDO CHEMICAL LABORATORY |
| TITANIUM TETRAISOPROPOXIDE | KOJUNDO CHEMICAL LABORATORY |
| TITANIUM TETRA-n-BUTOXIDE | KOJUNDO CHEMICAL LABORATORY |
| TITANIUM TETRAISOBUTOXIDE | KOJUNDO CHEMICAL LABORATORY |
| POLYETHYLENE GLYCOL (AVG. MW 300) | KANTO KAGAKU |
| POLYETHYLENE GLYCOL (AVG. MW 400) | KANTO KAGAKU |
| POLYETHYLENE GLYCOL (AVG. MW 600) | KANTO KAGAKU |
| POLYETHYLENE GLYCOL MONOMETHYL ETHER (AVG. MW 550) | ALFA AESAR |
| POLYETHYLENE GLYCOL MONOMETHYL ETHER (AVG. MW 750) | ALFA AESAR |
| POLYPROPYLENE GLYCOL (AVG. MW 400) | ALFA AESAR |
| POLYPROPYLENE GLYCOL (AVG. MW 700) | WAKO PURE CHEMICAL INDUSTRIES |

| ION-EXCHANGED WATER | — |
|---|---|

# FIG. 23

| COMPOUND | CATEGORY | EXAMPLE 2-1 | EXAMPLE 2-2 | EXAMPLE 2-3 | EXAMPLE 2-4 | EXAMPLE 2-5 | COMPARATIVE EXAMPLE 2-1 | COMPARATIVE EXAMPLE 2-2 | COMPARATIVE EXAMPLE 2-3 | COMPARATIVE EXAMPLE 2-4 |
|---|---|---|---|---|---|---|---|---|---|---|
| ACETIC ACID | CARBOXYLIC ACID | 35.0 | 30.0 | 35.0 | | 21.0 | | | | |
| PROPIONIC ACID | CARBOXYLIC ACID | | | | 42.0 | 21.0 | | | | |
| ACETYLACETONE | SOLVENT | | | | | | 30.0 | | | |
| 2-n-BUTOXYETHANOL | SOLVENT | | | | | | 10.0 | 69.0 | 33.0 | 25.0 |
| DIETHANOLAMINE | SOLVENT | | | | | | | 15.0 | 7.0 | 15.0 |
| ION-EXCHANGED WATER | SOLVENT | 15.0 | 9.3 | 15.0 | 5.0 | 5.0 | | | | |
| LEAD (II) ACETATE TRIHYDRATE | LEAD SOURCE | 27.3 | 27.3 | 27.3 | 27.3 | 27.3 | 27.3 | 27.3 | 27.3 | 27.3 |
| ZIRCONIUM OXYACETATE | ZIRCONIUM SOURCE | 7.0 | | | 7.0 | 7.0 | | | | |
| ZIRCONIUM ACETATE SOLUTION (ACETIC ACID SOLUTION) | ZIRCONIUM SOURCE | | 17.7 | | | | | | | |
| ZIRCONIUM ACETATE | ZIRCONIUM SOURCE | | | 7.0 | | | | | | |
| ZIRCONIUM TETRA-n-BUTOXIDE (n-BUTANOL SOLUTION) | ZIRCONIUM SOURCE | | | | | | 14.0 | 14.0 | 14.0 | 14.0 |
| TITANIUM TETRAISOPROPOXIDE | TITANIUM SOURCE | 8.4 | 8.4 | 8.4 | 8.4 | 8.4 | 8.4 | 8.4 | 8.4 | 8.4 |
| POLYETHYLENE GLYCOL (AVG. MW 600) | POLYMER | 6.8 | 6.8 | 6.8 | 6.8 | 6.8 | 6.8 | 6.8 | 6.8 | 6.8 |
| TOTAL | | 99.5 | 99.5 | 99.5 | 96.5 | 96.5 | 96.5 | 140.5 | 96.5 | 96.5 |

# FIG. 24

FIG. 25

EP 2 520 692 A2

## FIG. 26

# FIG. 27

| | EXAMPLE 2-1 | EXAMPLE 2-2 | EXAMPLE 2-3 | EXAMPLE 2-4 | EXAMPLE 2-5 | COMPARATIVE EXAMPLE 2-1 | COMPARATIVE EXAMPLE 2-2 | COMPARATIVE EXAMPLE 2-3 | COMPARATIVE EXAMPLE 2-4 |
|---|---|---|---|---|---|---|---|---|---|
| METAL OXIDE CONTENT (MASS%) | 22.4 | 22.4 | 22.4 | 23.1 | 23.1 | 23.1 | 15.9 | 23.1 | 23.1 |
| CARBOXYLIC ACID CONTENT IN TOTAL AMOUNT OF RAW MATERIALS (MASS%) | 35.2 | 37.7 | 35.2 | 43.5 | 47.2 | − | − | − | − |
| FILM THICKNESS (nm) | 304 | 302 | 306 | 244 | 270 | − | 90 | 185 | − |
| WATERPROOFNESS | ○ | ○ | ○ | ○ | ○ | − | ○ | × | ○ |
| STORAGE STABILITY | ○ | ○ | ○ | ○ | ○ | × | ○ | ○ | ○ |

# FIG. 28

| COMPOUND | CATEGORY | EXAMPLE 2-6 | EXAMPLE 2-7 | EXAMPLE 2-8 | COMPARATIVE EXAMPLE 2-5 | COMPARATIVE EXAMPLE 2-6 | COMPARATIVE EXAMPLE 2-7 |
|---|---|---|---|---|---|---|---|
| ACETIC ACID | CARBOXYLIC ACID | 50.0 | 48.4 | 39.3 | 43.0 | 50.0 | 48.4 |
| PROPIONIC ACID | CARBOXYLIC ACID | | | | | | |
| ION-EXCHANGED WATER | SOLVENT | 7.0 | 7.0 | 7.0 | 7.0 | 7.0 | 7.0 |
| LEAD (II) ACETATE TRIHYDRATE | LEAD SOURCE | 27.3 | 27.3 | 27.3 | 27.3 | 27.3 | 27.3 |
| ZIRCONIUM OXYACETATE | ZIRCONIUM SOURCE | 7.0 | 7.0 | | | 7.0 | 7.0 |
| ZIRCONIUM ACETATE SOLUTION (ACETIC ACID SOLUTION) | ZIRCONIUM SOURCE | | | 17.7 | | | |
| ZIRCONIUM TETRA-n-BUTOXIDE (n-BUTANOL SOLUTION) | ZIRCONIUM SOURCE | | | | 14.0 | | |
| TITANIUM TETRA-n-PROPOXIDE | TITANIUM SOURCE | | | | | 8.4 | |
| TITANIUM TETRAISOPROPOXIDE | TITANIUM SOURCE | 8.4 | | 8.4 | 8.4 | | |
| TITANIUM TETRA-n-BUTOXIDE | TITANIUM SOURCE | | | | | | 10.0 |
| TITANIUM TETRAISOBUTOXIDE | TITANIUM SOURCE | | 10.0 | | | | |
| POLYETHYLENE GLYCOL (AVG. MW 600) | POLYMER | 6.8 | 6.8 | 6.8 | 6.8 | 6.8 | 6.8 |
| TOTAL | | 106.5 | 106.5 | 106.5 | 106.5 | 106.5 | 106.5 |

EP 2 520 692 A2

## FIG. 29

| | EXAMPLE 2-6 | EXAMPLE 2-7 | EXAMPLE 2-8 | COMPARATIVE EXAMPLE 2-5 | COMPARATIVE EXAMPLE 2-6 | COMPARATIVE EXAMPLE 2-7 |
|---|---|---|---|---|---|---|
| METAL OXIDE CONTENT (MASS%) | 20.9 | 20.9 | 20.9 | 20.9 | 20.9 | 20.9 |
| CARBOXYLIC ACID CONTENT IN TOTAL AMOUNT OF RAW MATERIALS (MASS%) | 47.0 | 45.4 | 43.9 | 40.4 | 47.0 | 45.4 |
| THICKNESS VARIATIONS | A | A | A | C | C | C |
| WATERPROOFNESS | ○ | ○ | ○ | ○ | ○ | ○ |
| STORAGE STABILITY | ○ | ○ | ○ | ○ | ○ | ○ |

# FIG. 30

| COMPOUND | CATEGORY | EXAMPLE 2-9 | EXAMPLE 2-10 | EXAMPLE 2-11 | EXAMPLE 2-12 |
|---|---|---|---|---|---|
| ACETIC ACID | CARBOXYLIC ACID | 57.0 | 48.4 | 25.8 | 40.0 |
| ION-EXCHANGED WATER | SOLVENT | 23.0 | 20.0 | 25.0 | 10.0 |
| ISOPROPYL ALCOHOL | SOLVENT | | 10.0 | | |
| LEAD (II) ACETATE TRIHYDRATE | LEAD SOURCE | 27.3 | 27.3 | 27.3 | 27.3 |
| ZIRCONIUM OXYACETATE | ZIRCONIUM SOURCE | 7.0 | 8.8 | 7.0 | 7.0 |
| TITANIUM TETRAISOPROPOXIDE | TITANIUM SOURCE | 8.4 | 8.4 | 8.4 | 8.4 |
| POLYETHYLENE GLYCOL (AVG. MW 400) | POLYMER | | 20.5 | | 6.8 |
| POLYETHYLENE GLYCOL (AVG. MW 600) | POLYMER | 6.8 | | 13.6 | |
| TOTAL | | 129.5 | 143.3 | 107.1 | 99.5 |

EP 2 520 692 A2

# FIG. 31

|  | EXAMPLE 2-9 | EXAMPLE 2-10 | EXAMPLE 2-11 | EXAMPLE 2-12 | COMPARATIVE EXAMPLE 2-8 |
|---|---|---|---|---|---|
| METAL OXIDE CONTENT (MASS%) | 17.2 | 15.6 | 20.8 | 22.4 | 15.3 |
| CARBOXYLIC ACID CONTENT IN TOTAL AMOUNT OF RAW MATERIALS (MASS%) | 44.0 | 33.8 | 24.1 | 40.2 | — |
| SPINNING SPEED (rpm) | 700 | 900 | 2000 | 2500 | 700 |
| FILM THICKNESS (nm) | 266 | 263 | 272 | 270 | 162 |
| WATERPROOFNESS | ○ | ○ | ○ | ○ | ○ |
| STORAGE STABILITY | ○ | ○ | ○ | ○ | ○ |

# FIG. 32

| COMPOUND | CATEGORY | EXAMPLE 2-13 | EXAMPLE 2-14 | EXAMPLE 2-15 | EXAMPLE 2-16 | EXAMPLE 2-17 | EXAMPLE 2-18 | EXAMPLE 2-19 | EXAMPLE 2-20 | EXAMPLE 2-21 | EXAMPLE 2-22 | EXAMPLE 2-23 |
|---|---|---|---|---|---|---|---|---|---|---|---|---|
| ACETIC ACID | CARBOXYLIC ACID | 47.0 | 37.0 | 24.0 | 47.0 | 47.0 | 47.0 | 47.0 | 47.0 | 47.0 | 47.0 | 47.0 |
| ION-EXCHANGED WATER | SOLVENT | 10.0 | 20.0 | 23.0 | 10.0 | 10.0 | 10.0 | 10.0 | 10.0 | 10.0 | 10.0 | 10.0 |
| LEAD (II) ACETATE TRIHYDRATE | LEAD SOURCE | 27.3 | 27.3 | 27.3 | 27.3 | 27.3 | 27.3 | 27.3 | 27.3 | 27.3 | 27.3 | 27.3 |
| ZIRCONIUM OXYACETATE | ZIRCONIUM SOURCE | 7.0 | 7.0 | 7.0 | 7.0 | 7.0 | 7.0 | 7.0 | 7.0 | 7.0 | 7.0 | 7.0 |
| TITANIUM TETRAISOPROPOXIDE | TITANIUM SOURCE | 8.4 | 8.4 | 8.4 | 8.4 | 8.4 | 8.4 | 8.4 | 8.4 | 8.4 | 8.4 | 8.4 |
| POLYETHYLENE GLYCOL (AVG. MW 300) | POLYMER | 6.8 | 20.5 | | | | | | | | | |
| POLYETHYLENE GLYCOL (AVG. MW 400) | POLYMER | | | 6.8 | 20.5 | | | | | | | 1.7 |
| POLYETHYLENE GLYCOL (AVG. MW 600) | POLYMER | | | | | 6.8 | 20.5 | | | | | 1.7 |
| POLYETHYLENE GLYCOL MONOMETHYL ETHER (AVG. MW 550) | POLYMER | | | | | | | 6.8 | | | | 1.7 |
| POLYETHYLENE GLYCOL MONOMETHYL ETHER (AVG. MW 750) | POLYMER | | | | | | | | 6.8 | | | |
| POLYPROPYLENE GLYCOL (AVG. MW 400) | POLYMER | | | | | | | | | 6.8 | | |
| POLYPROPYLENE GLYCOL (AVG. MW 700) | POLYMER | | | | | | | | | | 6.8 | 1.7 |
| TOTAL | | 106.5 | 120.2 | 96.5 | 120.2 | 106.5 | 120.2 | 106.5 | 106.5 | 106.5 | 106.5 | 106.5 |

EP 2 520 692 A2

## FIG. 33

| | EXAMPLE 2-13 | EXAMPLE 2-14 | EXAMPLE 2-15 | EXAMPLE 2-16 | EXAMPLE 2-17 | EXAMPLE 2-18 | EXAMPLE 2-19 | EXAMPLE 2-20 | EXAMPLE 2-21 | EXAMPLE 2-22 | EXAMPLE 2-23 |
|---|---|---|---|---|---|---|---|---|---|---|---|
| METAL OXIDE CONTENT (MASS%) | 20.9 | 18.5 | 23.1 | 18.5 | 20.9 | 18.5 | 20.9 | 20.9 | 20.9 | 20.9 | 20.9 |
| CARBOXYLIC ACID CONTENT IN TOTAL AMOUNT OF RAW MATERIALS (MASS%) | 44.1 | 30.8 | 24.9 | 39.1 | 44.1 | 39.1 | 44.1 | 44.1 | 44.1 | 44.1 | 44.1 |
| THICKNESS OF 6 LAYERS (nm) | 1218 | 1200 | 1290 | 1302.0 | 1284 | 1302.0 | 1296 | 1308 | 1272 | 1300 | 1292 |
| RESISTANCE TO CRACKING | O | O | O | O | O | O | O | O | O | O | O |
| WATERPROOFNESS | O | O | O | O | O | O | O | O | O | O | O |
| STORAGE STABILITY | O | O | O | O | O | O | O | O | O | O | O |

FIG. 34

EP 2 520 692 A2

FIG. 35

★ : PEAKS RELATED TO MAJOR METAL-CENTERED LIGANDS

FIG. 36

★ : PEAKS RELATED TO MAJOR METAL-CENTERED LIGANDS

PEAKS CORRESPONDING TO BUTOXYETHOXY GROUP

BENZENE-d6

FIG. 37

★ : PEAKS RELATED TO MAJOR
    METAL-CENTERED LIGANDS

NPb-ZrIPA.esp

BENZENE-d6

PEAKS CORRESPONDING TO
BUTOXYETHOXY GROUP

CHEMICAL SHIFT (ppm)

EP 2 520 692 A2

# FIG. 38

★: PEAKS RELATED TO MAJOR METAL-CENTERED LIGANDS

PEAKS CORRESPONDING TO 2-ETHYLHEXYL GROUP

TMS

CHLOROFORM-d

NORMALIZED INTENSITY

CHEMICAL SHIFT (ppm)

EP 2 520 692 A2

## FIG. 39

EP 2 520 692 A2

★ : PEAKS RELATED TO MAJOR METAL-CENTERED LIGANDS

PEAKS CORRESPONDING TO BUTOXYETHOXY GROUP

# FIG. 40

# FIG. 41

```
        ┌─────────────┐
        │    START    │
        └─────────────┘
               │
               ▼
   ┌───────────────────────┐
   │   PREPARING SOLVENT   │ ～S1
   │      COMPONENT        │
   └───────────────────────┘
               │
               ▼
   ┌───────────────────────┐
   │  ADDING METAL SOURCE  │ ～S2
   │  (TITANIUM COMPOUND)  │
   └───────────────────────┘
               │
               ▼
   ┌───────────────────────┐
   │  ADDING METAL SOURCE  │ ～S3
   │ (ZIRCONIUM COMPOUND)  │
   └───────────────────────┘
               │
               ▼
   ┌───────────────────────┐
   │     ADDING WATER      │ ～S4
   └───────────────────────┘
               │
               ▼
   ┌───────────────────────┐
   │  ADDING METAL SOURCE  │ ～S5
   │   (LEAD COMPOUND)     │
   └───────────────────────┘
               │
               ▼
   ┌───────────────────────┐
   │   STIRRING SOLUTION   │ ～S6
   └───────────────────────┘
               │
               ▼
   ┌───────────────────────┐
   │ ADDING ESTER COMPONENT│ ～S7
   └───────────────────────┘
               │
               ▼
        ┌─────────────┐
        │     END     │
        └─────────────┘
```

# FIG. 42

# FIG. 43

PEAK CORRESPONDING
TO CH$_2$ GROUP OF
BUTYL ACETATE

PEAK CORRESPONDING
TO CH GROUP OF
ISOPROPYL ACETATE

INTEGRATION RATIO
OF THE PEAK

20.49    0.05    1.17 4.13 1.75    18.76    2.06    4.70 3.00

8.5  8.0  7.5  7.0  6.5  6.0  5.5  5.0  4.5  4.0  3.5  3.0  2.5  2.0  1.5  1.0  0.5  0

CHEMICAL SHIFT (ppm)

EP 2 520 692 A2

# FIG. 44

PEAK CORRESPONDING TO CH₂ GROUP OF BUTYL ACETATE

PEAK CORRESPONDING TO CH GROUP OF ISOPROPYL ACETATE

INTEGRATION RATIO OF THE PEAK

20.35    0.08    1.49    1.48    18.85    2.08 2.05 4.72 3.00

8.5  8.0  7.5  7.0  6.5  6.0  5.5  5.0  4.5  4.0  3.5  3.0  2.5  2.0  1.5  1.0  0.5  0

CHEMICAL SHIFT (ppm)

EP 2 520 692 A2

FIG. 45

EP 2 520 692 A2

EP 2 520 692 A2

# FIG. 46

PEAK CORRESPONDING
TO CH$_2$ GROUP OF
BUTYL ACETATE

PEAK CORRESPONDING
TO CH GROUP OF
ISOPROPYL ACETATE

INTEGRATION RATIO
OF THE PEAK

17.55    0.13    1.24  4.16  0.35    25.90    2.05 2.03 4.71 3.00

8.5   8.0   7.5   7.0   6.5   6.0   5.5   5.0   4.5   4.0   3.5   3.0   2.5   2.0   1.5   1.0   0.5   0
CHEMICAL SHIFT (ppm)

## FIG. 47

EP 2 520 692 A2

FIG. 48

FIG. 49

FIG. 50

# FIG. 51

# FIG. 52

# FIG. 53

# FIG. 54

# FIG. 55

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008001038 A
- JP 11079747 A
- JP 5058636 A
- JP 8111411 A
- JP 2007145657 A